# FASCICULE DE BREVET EUROPEEN

(11) **EP 3 843 158 B1**
(45) Date de publication et mention de la délivrance du brevet: **01.06.2022**
(21) Numéro de dépôt: 20216818.3
(22) Date de dépôt: 23.12.2020
(51) Int. Cl.: H01L 21/336, H01L 29/423, H01L 29/786, H01L 29/06, H01L 27/24, H01L 45/00

(54) **DISPOSITIF COMPRENANT DES TRANSISTORS À GRILLE ENROBANTE ET PROCÉDÉ DE FABRICATION D'UN TEL DISPOSITIF**
VORRICHTUNG UMFASSEND TRANSISTOREN MIT RUNDUM-GATE UND HERSTELLUNGSVERFAHREN EINER SOLCHEN VORRICHTUNG
DEVICE COMPRISING GATE-ALL-AROUND TRANSISTORS AND METHOD FOR MANUFACTURING SUCH A DEVICE

(30) Priorité: 23.12.2019 FR 1915474
(43) Date de publication de la demande: 30.06.2021
(73) Titulaire: Commissariat à l'Energie Atomique et aux Energies Alternatives, 75015 Paris (FR)
(72) Inventeur: BARRAUD, Sylvain, 38054 GRENOBLE CEDEX 09 (FR); ANDRIEU, François, 38054 GRENOBLE CEDEX 09 (FR)
(74) Mandataire: Hautier IP

(56) Documents cités:
- US-A1- 2010 295 021
- US-A1- 2013 153 851
- US-A1- 2017 271 402
- US-A1- 2019 088 553
- US-B1- 8 026 521
- US-B1- 10 236 217

## Description

### DOMAINE TECHNIQUE

La présente invention se rapporte au domaine de la microélectronique. Elle concerne plus particulièrement la réalisation de dispositifs à base de transistors en intégration 3D. Une application non limitative de l'invention concerne les mémoires résistives non-volatiles RRAM ou ReRAM (pour « Resistive random-access memory »).

### ÉTAT DE LA TECHNIQUE

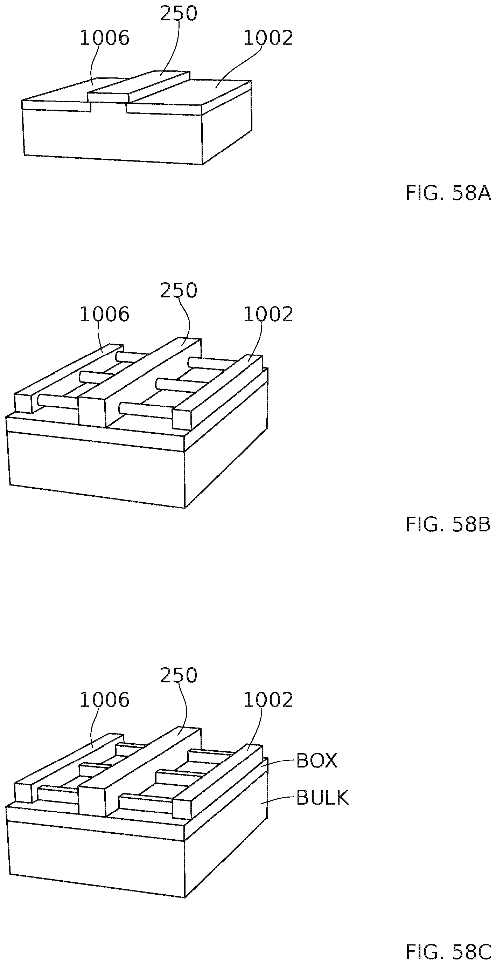

L'augmentation constante de performance des transistors a d'abord été permise par la réduction des dimensions des transistors dits planaires. La figure 58A présente un exemple d'un tel transistor planaire comprenant classiquement une source 1002, une grille 250 déposée en surface d'un canal (non visible) et un drain 1006.

Cette architecture planaire a ensuite laissé place à d'autres types d'architectures mieux adaptées aux performances spécifiées dans les nœuds technologiques inférieurs à 12 nm. L'architecture dite « finFET » présentée à la figure 58B permet par exemple de répondre aux performances fixées par le nœud technologique 7 nm. Cette architecture finFET comprend typiquement une source 1002, une grille 250 enrobant partiellement le canal (non visible) et un drain 1006. Le confinement de grille est ici amélioré.

Pour les prochains nœuds technologiques notamment à partir de 3 nm, cette architecture finFET devra céder le pas devant d'autres architectures offrant un confinement de grille encore amélioré.

Une architecture envisagée pour répondre aux problématiques de ces prochains nœuds technologiques est présentée à la figure 58C. Cette architecture comprend des transistors à grille enrobante dits transistors GAA (acronyme de Gate All Around) empilés les uns sur les autres. Les transistors GAA illustrés à la figure 58C se présentent sous forme de nanofils horizontaux dont les parties centrales sont noyées au sein d'une grille 250. Ces parties centrales correspondent aux canaux des transistors. Les nanofils comprennent des parties périphériques s'étendant de part et d'autre des parties centrales. Ces parties périphériques sont connectées aux sources 1002 et drains 1006 des transistors GAA. Ces transistors GAA peuvent être empilés selon z et reposent par exemple sur un oxyde enterré ou BOX.

Pour supplanter les performances d'une architecture à base de transistors finFET, une telle architecture à base de transistors GAA doit comprendre au moins deux transistors GAA empilés, voire quatre transistors empilés les uns sur les autres selon z.

Pour réaliser un tel empilement de transistors GAA, un procédé consiste à transférer une première couche de transistors réalisée sur une première tranche ou wafer, sur un deuxième wafer comprenant une deuxième couche de transistors. Un collage moléculaire peut alors être effectué de manière à solidariser les couches entre elles. Plusieurs étapes de report successives peuvent être effectuées de manière à construire un empilement de plusieurs transistors GAA. Un tel procédé est néanmoins complexe à mettre en œuvre. La gestion du budget thermique associé au collage des couches est une problématique importante de ce procédé.

Une autre solution permettant de limiter le budget thermique des transistors de l'empilement consiste à reporter, à partir d'un premier wafer de type SOI (acronyme de Silicon On Insulator) une couche mince non structurée sur un deuxième wafer comprenant une première couche de transistors. La technologie de référence "Smart Cut"^{™} bien connue de l'homme du métier permet alors de séparer la couche mince du premier wafer. Celle-ci peut ensuite être structurée de façon à former une deuxième couche de transistors en limitant le budget thermique des transistors de la première couche. Ce procédé nécessite également plusieurs étapes complexes de report successives pour construire un empilement de plusieurs transistors GAA tel qu'illustré à la figure 58C.

US 2019/088553 A1, US 2010/295021 A1 et US 10 236 217 B1 divulguent des dispositifs microélectroniques selon le préambule de la revendication indépendante 11, chaque dispositif comprenant au moins deux transistors à canal nanofil empilés verticalement, dont la source et le drain d'un transistor sont localisés uniquement au niveau de son canal, et leurs procédés de fabrication correspondants.

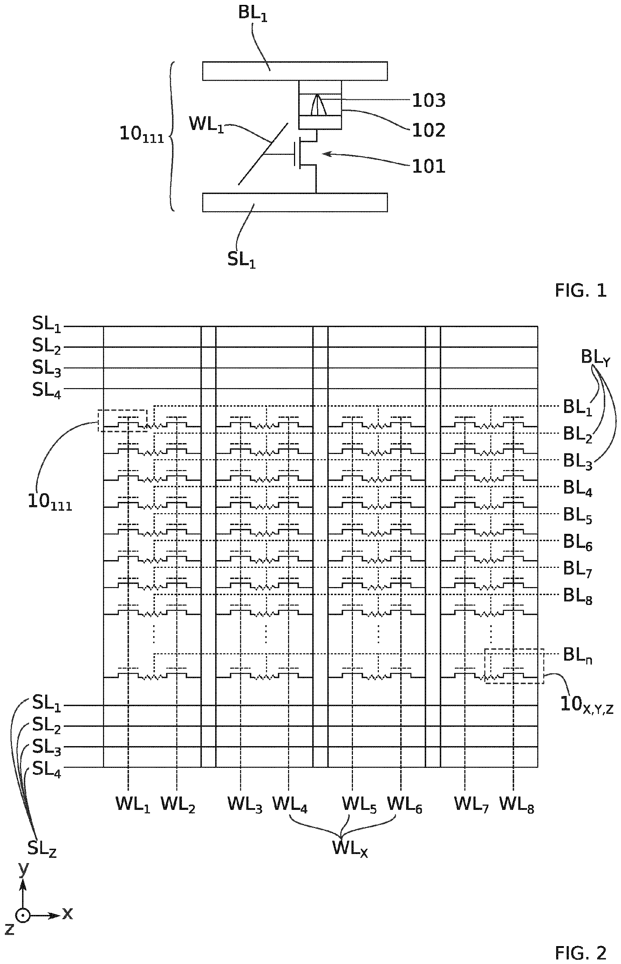

Selon une possibilité, ces transistors GAA peuvent former des transistors de sélection de cellules mémoire intégrées selon une architecture 3D. Une cellule mémoire comprend typiquement un élément mémoire 102 commutable associé à un transistor de sélection 101, tel qu'illustré à la figure 1. Dès lors, le procédé de fabrication des transistors GAA empilés peut être poursuivi de façon à former ces éléments mémoire. La complexité et le coût de ce procédé de fabrication d'architectures 3D monolithiques augmentent encore.

Il existe donc un besoin consistant à fournir un procédé de fabrication d'un dispositif électronique 3D à base de transistors GAA limitant la complexité et/ou le coût de fabrication. La présente invention vise à répondre au moins en partie à ce besoin.

En particulier, un objet de la présente invention est un procédé de fabrication d'une architecture 3D de dispositif microélectronique, réduisant le coût de fabrication.

Un autre objet de l'invention est un dispositif microélectronique à base de transistors GAA.

Un objectif particulier commun au procédé et au dispositif est de densifier les transistors GAA.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre ces objectifs, la présente invention propose selon un premier aspect un procédé de fabrication d'un dispositif microélectronique comprenant au moins deux transistors comprenant chacun un canal de préférence sous forme de fil s'étendant selon une première direction x, une grille entourant ledit canal, une source et un drain, lesdits transistors étant empilés selon une troisième direction z et occupant chacun un niveau n_{z}, n_{z} = n₁...n₄, d'altitude donnée selon la troisième direction z, selon la revendication indépendante 1.

Le procédé comprend les étapes suivantes :
- Former sur un substrat un empilement selon la troisième direction z comprenant au moins deux couches en un premier matériau semi-conducteur séparées par au moins une couche sacrificielle en un deuxième matériau semi-conducteur, chaque couche en un premier matériau semi-conducteur correspondant à un niveau d'altitude donnée selon la troisième direction z,
- Former à partir de cet empilement des ouvertures définissant des motifs de transistors, les motifs de transistors comprenant chacun une partie centrale s'étendant notamment et de préférence principalement selon la première direction x et des première et deuxième parties périphériques s'étendant de part et d'autre de la partie centrale, ladite partie centrale étant destinée à former les canaux des transistors et lesdites première et deuxième parties périphériques étant destinées à former respectivement les sources et les drains des transistors,

- Former des grilles sacrificielles en partie dans les ouvertures, à cheval sur les parties centrales des motifs de transistors et s'étendant principalement selon une deuxième direction y normale à la première direction x,
- Retirer, à partir des ouvertures, le deuxième matériau semi-conducteur de l'au moins une couche sacrificielle des motifs de transistors,
- Remplir un premier espace laissé par le retrait de l'au moins une couche sacrificielle, par un deuxième matériau diélectrique au niveau des première et deuxième parties périphériques des motifs de transistors,
- Retirer les grilles sacrificielles,
- Remplir un deuxième espace laissé par le retrait de l'au moins une couche sacrificielle, par un matériau de grille au niveau des parties centrales des motifs de transistors, de façon à former des grilles dites enrobantes entourant totalement les canaux d'au moins un niveau n_{z} parmi les niveaux d'altitudes données.

Ce procédé permet de réaliser un empilement de transistors de type GAA (acronyme de « Gate All Around »), c'est-à-dire comprenant une grille entourant totalement le canal, sur plusieurs niveaux n_{z}. Ces transistors sont isolés électriquement les uns des autres.

Dans les procédés de l'art antérieur, l'empilement de transistors isolés est directement formé par report de couches semi-conductrices sur des couches isolantes, en alternance. Un tel procédé de report est cher et complexe.

Au contraire, dans la présente invention les transistors ne sont pas isolés les uns des autres dès le début du procédé. Ils sont isolés a *posteriori,* lors du retrait du deuxième matériau effectué par exemple via une gravure sélective. Le procédé proposé par la présente invention permet de réduire considérablement la complexité et le cout de réalisation de ce type de transistor.

Le deuxième matériau est de préférence semi-conducteur. Il peut avantageusement servir de couche de germination pour l'épitaxie du premier matériau. Ainsi, les différentes couches peuvent être formées par croissance épitaxiale des premier et deuxième matériaux, sans report de couches.

La formation d'un tel empilement de couches des premier et deuxième matériaux, suivi d'un retrait du deuxième matériau et d'un remplissage par un matériau diélectrique visant à remplacer le deuxième matériau, permet donc d'obtenir *in fine* un empilement de couches semi-conductrices et isolantes avec un coût réduit.

Les grilles sacrificielles permettent avantageusement de maintenir les futurs canaux des transistors lors du retrait du deuxième matériau. Cela évite un effondrement des canaux de transistors les uns sur les autres.

Un tel procédé est en outre avantageusement compatible avec une intégration 3D dense.

Dans le procédé selon l'invention et contrairement aux procédés connus, les sources et drains sont avantageusement formés directement par des parties de l'empilement, avant dépôt ou formation des grilles sacrificielles notamment. Cela permet d'économiser des étapes ultérieures de formation des sources et drains, par exemple des étapes d'épitaxie ou de recroissance en phase solide de sources et drains.

Un deuxième aspect de l'invention concerne un dispositif microélectronique comprenant au moins deux transistors comprenant chacun un canal sous forme de fil s'étendant principalement selon une première direction x, une grille entourant ledit canal, une source et un drain connectés ou associés au canal, lesdits transistors étant empilés selon une troisième direction z de sorte que le canal de chaque desdits transistors occupe un niveau n_{z}, n_{z} = n₁...n₄, d'altitude donnée selon la troisième direction z, et la source et le drain connectés ou associés audit canal sont localisés uniquement audit niveau n_{z}, selon la revendication indépendante 11.

Selon un exemple, les sources des transistors sont séparées entre elles selon la troisième direction z par au moins un espaceur, dit espaceur horizontal, et/ou les drains des transistors sont séparés entre eux selon la troisième direction z par au moins un autre espaceur horizontal.

Cela permet d'isoler les sources et/ou les drains entre chaque niveau nz. Cela permet par exemple de connecter indépendamment les sources et/ou les drains de chaque niveau n_{z}.

Un autre aspect de l'invention concerne une pluralité de dispositifs microélectroniques tels que décrits ci-dessus.

Certaines caractéristiques et certains avantages du procédé de fabrication peuvent s'appliquer *mutatis mutandis* au dispositif microélectronique, et réciproquement.

### BRÈVE DESCRIPTION DES FIGURES

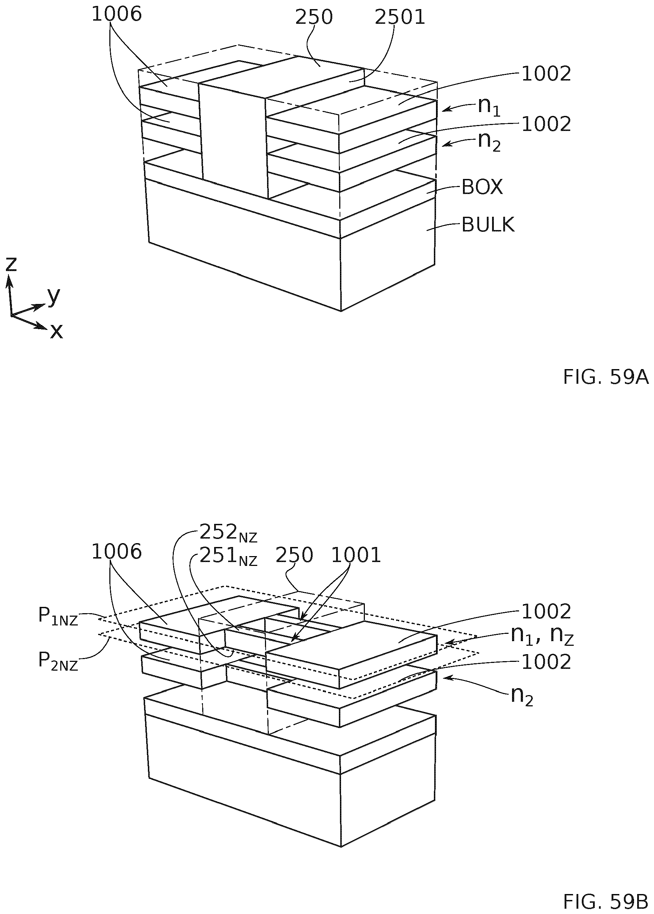

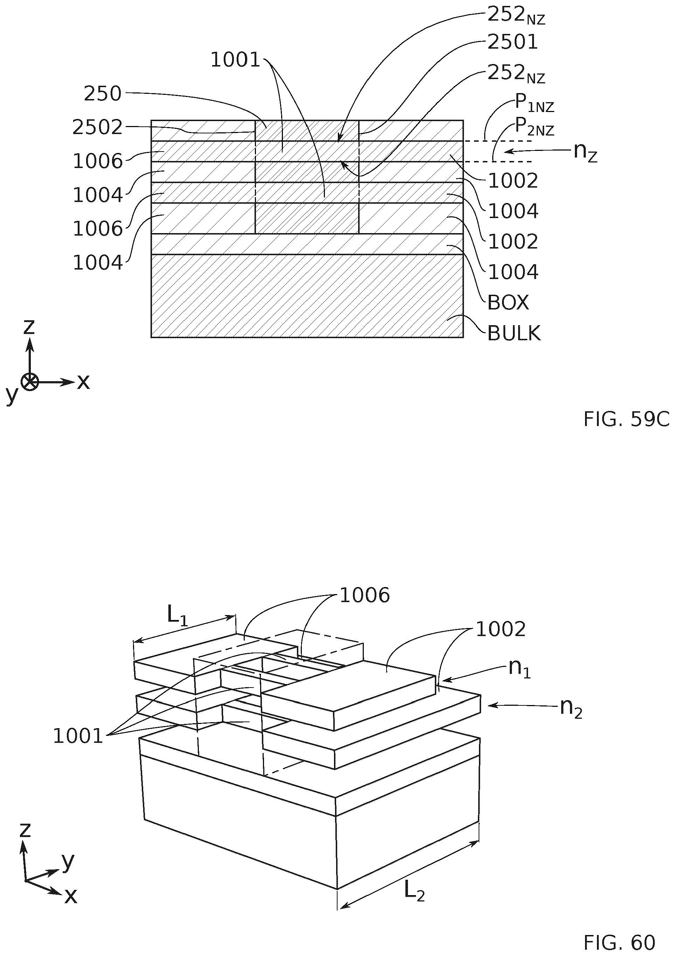

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La FIGURE 1 illustre schématiquement une cellule mémoire résistive de type OxRAM.
La FIGURE 2 présente un design d'une matrice de cellules mémoire selon un mode de réalisation de la présente invention.
La FIGURE 3 présente un plan d'un système microélectronique comprenant une matrice de cellules mémoire selon un mode de réalisation de la présente invention.
Les FIGURES 4A à 4G illustrent schématiquement en vue de trois-quarts des étapes de fabrication des grilles sacrificielles d'un système microélectronique selon un premier mode de réalisation de la présente invention.
La FIGURE 5 illustre schématiquement en vue de trois-quarts une étape de fabrication d'un système microélectronique selon un premier mode de réalisation de la présente invention.
Les FIGURES 6A à 6C illustrent schématiquement en vue de trois-quarts des étapes de fabrication d'un système microélectronique selon un premier mode de réalisation de la présente invention.
Les FIGURES 7A et 7B illustrent respectivement des coupes transverses selon les axes AA' et BB' illustrés à la FIGURE 6C
Les FIGURES 8A à 8D illustrent schématiquement en vue de trois-quarts des étapes de fabrication d'un système microélectronique visant à isoler des sources de transistors entre elles, selon un premier mode de réalisation de la présente invention.
La FIGURE 9 présente une image STEM HAADF d'une partie d'un système microélectronique selon un premier mode de réalisation de la présente invention, en cours de fabrication.
Les FIGURES 10A et 10B illustrent une partie d'un système microélectronique selon un premier mode de réalisation de la présente invention, respectivement avant et après isolation des sources entre elles.
Les FIGURES 11A à 11D illustrent schématiquement en vue de trois-quarts des étapes de fabrication de la zone des lignes de source d'un système microélectronique selon un premier mode de réalisation de la présente invention.
La FIGURE 12 est une vue schématique des sources et des canaux en silicium d'un système microélectronique selon un premier mode de réalisation de la présente invention.
Les FIGURES 13A à 13F illustrent schématiquement en vue de trois-quarts des étapes de fabrication de la zone des lignes de mots d'un système microélectronique selon un premier mode de réalisation de la présente invention.
Les FIGURES 14A à 14C illustrent schématiquement des étapes d'un procédé de fabrication de la zone des lignes de données d'un système microélectronique selon un premier mode de réalisation de la présente invention.
La FIGURE 15 illustre schématiquement l'étape du procédé de fabrication illustrée à la FIGURE 14C selon une coupe longitudinale EE' représentée sur la FIGURE 14C.
Les FIGURES 16A à 16D illustrent schématiquement des étapes d'un procédé de fabrication de la zone des lignes de source d'un système microélectronique selon un premier mode de réalisation de la présente invention, pour la réalisation de contacts en escalier.
Les FIGURES 17A et 17B illustrent schématiquement des étapes d'un procédé de fabrication d'un système microélectronique selon un premier mode de réalisation de la présente invention.
La FIGURE 18 illustre schématiquement en vue de trois-quarts un système microélectronique selon un premier mode de réalisation de la présente invention.
Les FIGURES 19 à 22 illustrent schématiquement en vue de trois-quarts des étapes de fabrication d'un système microélectronique selon un deuxième mode de réalisation de la présente invention.
Les FIGURES 23 à 28 illustrent schématiquement des étapes d'un procédé de fabrication de la zone des lignes de source d'un système microélectronique selon un deuxième mode de réalisation de la présente invention, pour la réalisation de contacts en escalier.
Les FIGURES 29 à 33 illustrent schématiquement en vue de trois-quarts des étapes de fabrication des grilles sacrificielles d'un système microélectronique selon un deuxième mode de réalisation de la présente invention.
Les FIGURES 34 à 39 illustrent schématiquement en vue de trois-quarts des étapes de fabrication d'un système microélectronique visant à isoler des sources de transistors entre elles, selon un deuxième mode de réalisation de la présente invention.
Les FIGURES 40 à 45 illustrent schématiquement des étapes d'un procédé de fabrication de la zone des lignes de source d'un système microélectronique selon un deuxième mode de réalisation de la présente invention.
Les FIGURES 46 à 49 illustrent schématiquement des étapes d'un procédé de fabrication de la zone des lignes de mots d'un système microélectronique selon un deuxième mode de réalisation de la présente invention.
Les FIGURES 50 à 55 illustrent schématiquement des étapes d'un procédé de fabrication de la zone des lignes de données d'un système microélectronique selon un deuxième mode de réalisation de la présente invention.
Les FIGURES 56 et 57 illustrent schématiquement un système microélectronique selon un deuxième mode de réalisation de la présente invention, respectivement selon une coupe transverse XZ et selon une coupe longitudinale YZ.
Les FIGURES 58A à 58C illustrent schématiquement différentes architectures de transistors selon l'art antérieur.
Les FIGURES 59A à 59C illustrent schématiquement une architecture d'un dispositif microélectronique à base de transistors GAA selon un mode de réalisation de la présente invention.
La FIGURE 60 illustre schématiquement une architecture d'un dispositif microélectronique à base de transistors GAA selon un autre mode de réalisation de la présente invention.
Les FIGURES 61A et 61B illustrent schématiquement une architecture d'un système à base de transistors GAA selon un mode de réalisation de la présente invention.
Les FIGURES 62A et 62B illustrent schématiquement une architecture d'un dispositif microélectronique à base de transistors GAA selon un autre mode de réalisation de la présente invention.
La FIGURE 63 illustre schématiquement une architecture d'un dispositif microélectronique à base de transistors GAA selon un autre mode de réalisation de la présente invention.
La FIGURE 64 illustre schématiquement une architecture d'un dispositif microélectronique à base de transistors GAA selon un autre mode de réalisation de la présente invention.
Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions des différentes structures (couches, motifs) ou zones ne sont pas représentatives de la réalité. Certains éléments des dispositifs microélectroniques, tels que la grille et/ou les espaceurs horizontaux, ont été retirés sur certaines figures, en particulier sur les figures 59A, 59B, 60, 61A, 62A, 63, 64, de façon à améliorer la clarté. L'homme du métier saura parfaitement réintroduire ces éléments qui apparaissent notamment sur les figures 59C, 61B, 62B.

### DESCRIPTION DÉTAILLÉE

Avant d'entamer une revue détaillée de modes de réalisation de l'invention, il est rappelé que, de manière facultative, l'invention comprend au moins l'une quelconque des caractéristiques optionnelles suivantes qui peuvent être utilisées en association ou alternativement.

Selon un exemple, le retrait de l'au moins une couche sacrificielle comprend :
- un premier retrait configuré pour former le premier espace au niveau des première et deuxième parties périphériques avant le retrait des grilles sacrificielles, et
- un deuxième retrait configuré pour former le deuxième espace au niveau des parties centrales après le retrait des grilles sacrificielles.

Selon un exemple, pour chacun des transistors, au moins l'un parmi la source et le drain s'étend principalement selon la deuxième direction y.

Selon un exemple, les ouvertures sont formées de sorte à ce que deux ouvertures adjacentes définissent entre elles et dans le premier matériau semiconducteur un motif de transistors.

Selon un exemple, les grilles sacrificielles sont formées directement en bordure de l'une au moins parmi les premières et deuxièmes parties périphériques.

Selon un exemple, le procédé comprend en outre des gravures en escalier dans une zone de lignes de source, de façon à atteindre les sources des différents niveaux n_{z}, et une formation de contacts en escalier sur les sources des différents niveaux n_{z}.

Selon un exemple, le premier matériau semi-conducteur est du silicium et le deuxième matériau semi-conducteur est un alliage de silicium-germanium.

Selon un exemple, le substrat est un substrat de type semiconducteur sur isolant comprenant une couche mince de semiconducteur.

Selon un exemple, l'empilement comprend ladite couche mince de semiconducteur.

Selon un exemple, ladite couche mince de semiconducteur est l'une parmi la couche sacrificielle et les au moins deux couches en un premier matériau semi-conducteur.

Selon un exemple, chaque couche de l'empilement présente une épaisseur comprise entre 5nm et 50nm, par exemple de l'ordre de 15nm.

Selon un exemple, le retrait de l'au moins une couche sacrificielle se fait par gravure sélective du deuxième matériau semiconducteur vis-à-vis du premier matériau semiconducteur avec une sélectivité de gravure entre le deuxième matériau semiconducteur et le premier matériau semiconducteur supérieure ou égale à 5:1.

Selon un exemple, chaque partie centrale de chaque motif de transistors comprend un empilement d'au moins X canaux, chaque première partie périphérique de chaque motif de transistors comprend un empilement d'au moins X sources, et chaque deuxième partie périphérique de chaque motif de transistors comprend un empilement d'au moins X drains, avec X ≥ 3 et de préférence X ≥ 4 et de préférence X ≥ 10. Ainsi, chaque motif de transistors est destiné à former au moins X transistors empilés. On rappelle que dans le cadre de la présente invention, deux éléments dits empilés ne sont pas nécessairement au contact l'un de l'autre. Tel est le cas des canaux de chaque partie centrale, qui sont séparés les uns des autres successivement par au moins une couche sacrificielle, un deuxième espace, un matériau de grille. Tel est le cas des sources et des drains de chaque première et deuxième partie périphérique, qui sont séparés les uns des autres successivement par au moins une couche sacrificielle, un premier espace, une couche diélectrique.

Selon un exemple, les grilles des transistors sont connectées électriquement entre elles et les sources des transistors sont isolées électriquement entre elles. Des sources indépendantes permettent d'alimenter indépendamment les transistors. Cela permet par exemple d'exécuter des opérations logiques sur chaque niveau indépendamment.

Selon un exemple, les grilles des transistors sont connectées électriquement entre elles dans une zone de lignes de mots d'un système microélectronique de type mémoire RAM (acronyme de Random Access Memory).

Selon un exemple, les sources occupant différents niveaux n_{z} sont connectées en escalier, indépendamment les unes des autres, dans une zone de lignes de source d'un système microélectronique de type mémoire RAM. Cela permet d'alimenter les transistors et/ou les points mémoire de façon indépendante sur chaque niveau de la matrice de cellules mémoire.

Selon un exemple, le procédé comprend les étapes suivantes :
- Former sur un substrat s'étendant selon des première et deuxième directions un empilement selon une troisième direction comprenant au moins deux couches en un premier matériau semi-conducteur séparées par au moins une couche sacrificielle en un deuxième matériau semi-conducteur, chaque couche en un premier matériau semi-conducteur définissant un niveau d'altitude donnée selon la troisième direction,
- Former des motifs de transistors par gravure anisotrope selon la troisième direction de zones de l'empilement, lesdits motifs comprenant au moins deux transistors empilés selon la troisième direction z, chacun de ces transistors comprenant un canal sous forme de fil s'étendant selon la première direction x, une source s'étendant selon la deuxième direction y, et un drain,
- Remplir lesdites zones par un matériau de grille sacrificielle,
- Former des grilles sacrificielles par gravure anisotrope selon la troisième direction d'une partie seulement dudit matériau de grille sacrificielle, lesdites grilles sacrificielles s'étendant à cheval sur les canaux des transistors,
- Former des espaceurs longitudinaux de part et d'autre des grilles sacrificielles, lesdits espaceurs longitudinaux s'étendant principalement selon la deuxième direction y et étant destinés à couvrir les sources et les drains des transistors en projection selon la troisième direction z dans un plan xy,
- Former des première et deuxième ouvertures de part et d'autre desdits espaceurs longitudinaux et en bordure des espaceurs longitudinaux selon la première direction x, les premières ouvertures exposant les drains de transistors et les deuxièmes ouvertures exposant les sources,
- Graver partiellement l'au moins une couche sacrificielle sélectivement par rapport aux couches en un premier matériau semi-conducteur, à partir desdites première et deuxième ouvertures,
- Remplir par un matériau diélectrique un espace laissé par la gravure partielle de l'au moins une couche sacrificielle, de façon à isoler les sources entre elles et les drains entre eux,
- Retirer les grilles sacrificielles de façon à exposer les canaux des transistors,
- Graver l'au moins une couche sacrificielle sélectivement par rapport aux couches en un premier matériau semi-conducteur, à partir des emplacements de grilles sacrificielles retirées, de façon à dégager les canaux des transistors,
- Déposer un matériau diélectrique de grille puis un matériau métallique de grille autour des canaux des transistors, de façon à former des grilles enrobant les canaux des transistors.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif. En particulier, le nombre de niveaux de l'empilement peut être supérieur à 4, voire supérieur à 10. Le nombre et/ou la forme des ouvertures dans l'empilement, les motifs de transistors illustrés sur les figures peuvent varier et être combinés de manière à former un autre mode de réalisation qui n'est pas nécessairement illustré ou décrit. Un tel mode de réalisation n'est évidemment pas exclu de l'invention.

La présente invention trouve pour domaine préférentiel d'application l'intégration 3D de systèmes micro-électroniques exécutant des fonctions logiques et de mémoire.

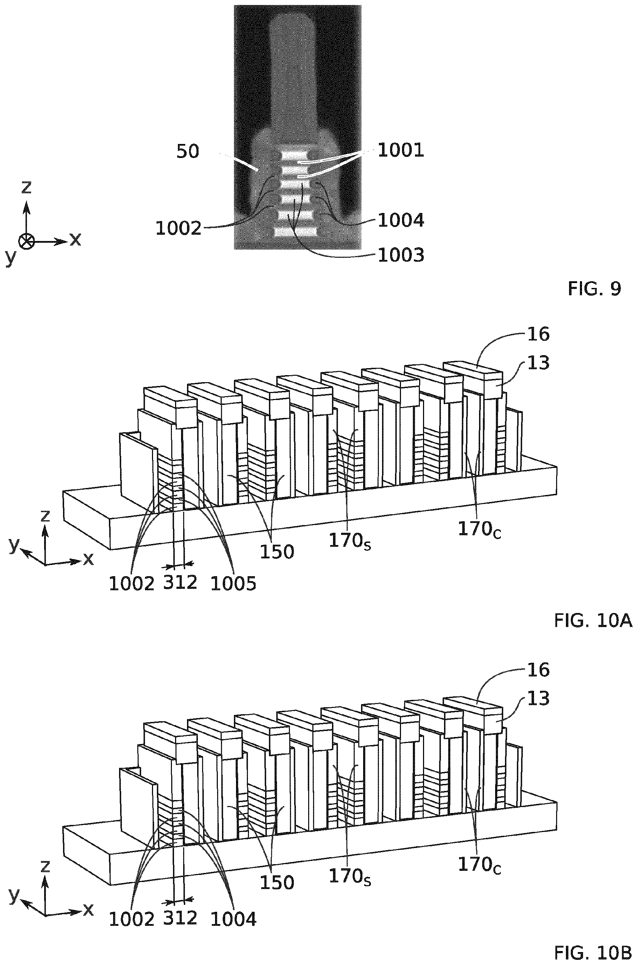

La présente invention prévoit notamment de réaliser une architecture 3D comprenant une forte densité de nanofils superposés sur différents niveaux. Cette architecture 3D est notamment configurée pour connecter électriquement chaque nanofil de façon indépendante. Chaque nanofil est de préférence entouré par une grille enrobante de façon à obtenir un transistor GAA. Cette grille est de préférence bordée par des espaceurs longitudinaux. Ces espaceurs peuvent couvrir les sources et les drains des différents transistors. Dans les exemples décrits dans la suite et illustrés par les figures d'accompagnement, en particulier aux figures 10A, 10B, 13F, 35, 48, 49, 59A, 59C, 61B, il apparaît ainsi clairement que la grille est bordée par des espaceurs longitudinaux s'étendant de part et d'autre de la grille principalement selon y, lesdits espaceurs longitudinaux couvrant la source et le drain de chaque transistor. Les sources et les drains des transistors superposés selon z sont donc situés sous les espaceurs de grille longitudinaux. Cela permet d'augmenter la densité de transistors dans l'architecture 3D.

Selon un exemple, pour chaque canal de niveau nz d'altitude donnée, la source et le drain connectés audit canal s'étendent uniquement selon ledit niveau nz.

Selon un exemple, les sources des transistors sont séparées entre elles selon la troisième direction z par au moins un espaceur horizontal.

Selon un exemple, les drains des transistors sont séparés entre eux selon la troisième direction z par au moins un espaceur horizontal.

Selon un exemple l'au moins un espaceur horizontal est en un matériau diélectrique.

Selon un exemple les sources et/ou les drains sont au moins en partie directement en contact avec la grille, au niveau d'au moins un côté de la grille. Cela permet d'augmenter la compacité du dispositif. Cela permet de densifier l'intégration des dispositifs dans un système.

Selon un exemple, les sources et/ou les drains de différents niveaux n_{z} sont contactés électriquement entre eux par au moins un contact commun s'étendant selon la troisième direction z, en bordure desdits sources et/ou drains.

Selon un exemple, les sources et/ou les drains de différents niveaux n_{z} sont contactés électriquement indépendamment les uns des autres par des contacts en escalier.

Selon un exemple, une pluralité de dispositifs microélectroniques adjacents selon une direction d'un plan normal à la troisième direction z, forment un système microélectronique dans lequel les sources et/ou les drains d'un niveau n_{z} d'altitude donnée de deux dispositifs adjacents sont communs audits deux dispositifs adjacents. Cela permet d'augmenter la compacité du système. Cela permet de densifier l'intégration des dispositifs au système.

Selon un exemple, une pluralité de dispositifs microélectroniques adjacents selon un plan comprenant la troisième direction z, forment un système microélectronique dans lequel les sources et/ou les drains d'un niveau n_{z} d'altitude donnée de deux dispositifs adjacents sont communs audits deux dispositifs adjacents. Cela permet d'augmenter la compacité du système. Cela permet de densifier l'intégration des dispositifs au système.

Selon un exemple, les sources et/ou les drains d'un niveau n_{z} d'altitude donnée sont séparés des sources et/ou des drains d'un niveau n_{z-1} et/ou d'un niveau n_{z+1} par au moins un espaceur horizontal.

Selon un exemple, les sources et/ou les drains d'un niveau n_{z} d'altitude donnée s'étendent principalement selon une deuxième direction y normale aux première et troisième directions x, z, et sont contactés électriquement aux sources et/ou aux drains d'un autre niveau n_{z} par un contact commun situé à une extrémité selon ladite deuxième direction y.

Sauf incompatibilité, il est entendu que le dispositif microélectronique, le procédé de fabrication, et le système peuvent comprendre, *mutatis mutandis,* l'ensemble des caractéristiques optionnelles ci-dessus.

Il est précisé que dans le cadre de la présente invention, le terme « sur », « surmonte », « recouvre » ou « sous-jacent » ou leurs équivalents ne signifient pas « au contact de ». Ainsi par exemple, la présence d'un espaceur ou d'une couche sur ou qui recouvre un élément structurel, ne signifie pas obligatoirement que l'espaceur ou que la couche sont directement au contact de l'élément structurel mais cela signifie que l'espaceur ou que la couche recouvre au moins partiellement l'élément structurel en étant soit directement à son contact, soit en étant séparée de celui-ci par au moins une autre couche, canal, ou tout autre élément. De même, deux éléments empilés sont situés en partie au moins au droit l'un de l'autre sans nécessairement être en contact l'un de l'autre.

On entend par un élément structurel, une couche, « à base » d'un matériau A, un élément structurel, une couche comprenant ce matériau A uniquement ou ce matériau A et éventuellement d'autres matériaux, par exemple des éléments dopants ou des éléments d'alliage. Ainsi, un espaceur à base de nitrure de silicium SiN peut par exemple comprendre du nitrure de silicium non stœchiométrique (SiN), ou du nitrure de silicium stœchiométrique (Si₃N₄), ou encore un oxy-nitrure de silicium (SiON).

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7.

Le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Le terme « motif de transistors » désigne l'élément à partir duquel les transistors empilés sont formés. La structure de cet élément est notamment destinée à évoluer lors des étapes du procédé. Ainsi, les motifs de transistors comprennent les couches en un premier matériau semi-conducteur et peuvent comprendre des couches sacrificielles et/ou des couches diélectriques, continues ou discontinues.

Dans la présente demande de brevet, on parlera préférentiellement d'épaisseur pour une couche, de hauteur pour un dispositif (transistor ou grille par exemple) et de profondeur pour une cavité ou une gravure. L'épaisseur est prise selon une direction normale au plan d'extension principal de la couche, la hauteur et la profondeur sont prises selon une direction normale au plan de base du substrat.

Sauf indication contraire, sur les figures, la hauteur et la profondeur sont prises selon l'axe z du repère orthonormé xyz.

Un élément situé au droit ou à l'aplomb d'un autre élément signifie que ces deux éléments sont situés tous deux sur une même ligne normale au plan de base du substrat, i.e. sur une même ligne orientée verticalement selon z sur les figures.

Un élément « bordant » un autre élément signifie que cet élément entoure partiellement ou totalement l'autre élément. Sauf mention explicite, ce terme s'entend d'un recouvrement partiel.

Les termes « sensiblement », « environ », « de l'ordre de » signifient « à 10% près » ou, lorsqu'il s'agit d'une orientation angulaire, « à 10° près » et de préférence « à 5° près ». Ainsi, une direction sensiblement normale à un plan signifie une direction présentant un angle de 90±10° par rapport au plan.

Pour déterminer la géométrie et la disposition des différents éléments constitutifs d'un dispositif (tel qu'un transistor ou une cellule mémoire) ou d'un système microélectronique (tel qu'une mémoire résistive de type OxRAM), on peut procéder à des analyses de microscopie électronique, en particulier de Microscopie Electronique à Balayage (MEB) ou de Microscopie Electronique en Transmission (MET ou TEM).

Les compositions chimiques des différents éléments ou couches peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de couches ou d'éléments de faibles dimensions. Elle peut être mise en œuvre sur des coupes métallurgiques au sein d'un MEB ou d'un MET.

Ces techniques permettent de suivre les différentes étapes mises en œuvre par un procédé de fabrication de transistors ou de cellules mémoires en intégration 3D, par exemple au travers d'analyses sur des prélèvements de dispositifs en cours de fabrication. L'utilisation de couches sacrificielles et de grilles sacrificielles peut notamment être un indice de mise en œuvre du procédé selon l'invention.

La présente invention permet de fabriquer un dispositif microélectronique comprenant au moins deux transistors de type GAA superposés. Ces transistors superposés peuvent ainsi être intégrés dans des systèmes logiques présentant des architectures 3D. Ces transistors peuvent notamment être associés à d'autres éléments structuraux ou fonctionnels de façon à concevoir des systèmes complexes.

La description qui suit présente un exemple non limitatif de mise en œuvre de l'invention dans un contexte d'élaboration d'un système 3D complexe. Le cadre de cette description n'est évidemment pas limitatif de l'invention. Plus précisément, la présente invention ne se limite pas aux procédés de réalisation de dispositifs microélectroniques comportant des cellules mémoire.

Toutes les caractéristiques, étapes et effets techniques mentionnés dans la description détaillée en référence à un dispositif mémoire sont applicables et combinables à un mode de réalisation d'un dispositif micro-électronique ne comprenant pas ou ne formant pas une cellule mémoire.

Le procédé proposé permet de fabriquer de manière simple, reproductible et peu onéreuse un dispositif microélectronique comprenant au moins deux transistors et de préférence au moins quatre transistors. Chaque transistor comprend un canal sous forme de fil s'étendant selon une première direction x, une grille entourant ledit canal, une source et un drain. Les transistors sont empilés selon une troisième direction z et occupent chacun un niveau n_{z}, n_{z}=n₁...n₄, d'altitude donnée selon la troisième direction z.

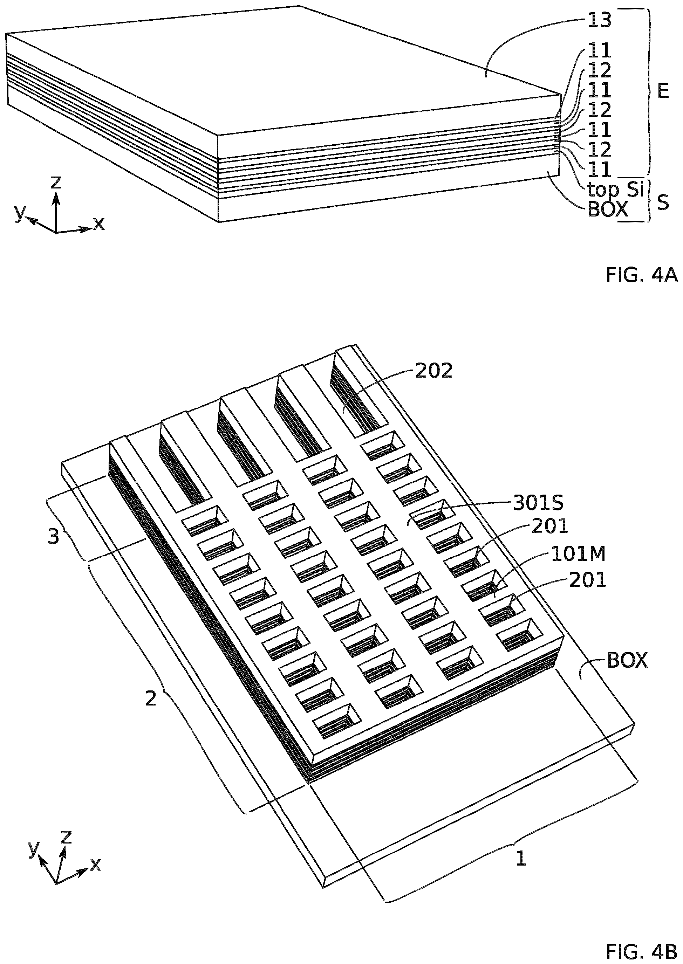

Pour cela, le procédé proposé peut prévoir les étapes suivantes qui sont brièvement mentionnées ci-dessous et qui seront décrites en détail dans la suite de la description :
Former sur un substrat un empilement de couches alternées en un premier matériau semi-conducteur et en un deuxième matériau semi-conducteur. Cette étape illustrée aux figures 4A, 19 et 20 par exemple, sera décrite en détail par la suite.

Former à partir de cet empilement des ouvertures définissant des motifs de transistors. Cette étape illustrée aux figures 4B, 21 et 22 par exemple, sera décrite en détail par la suite.

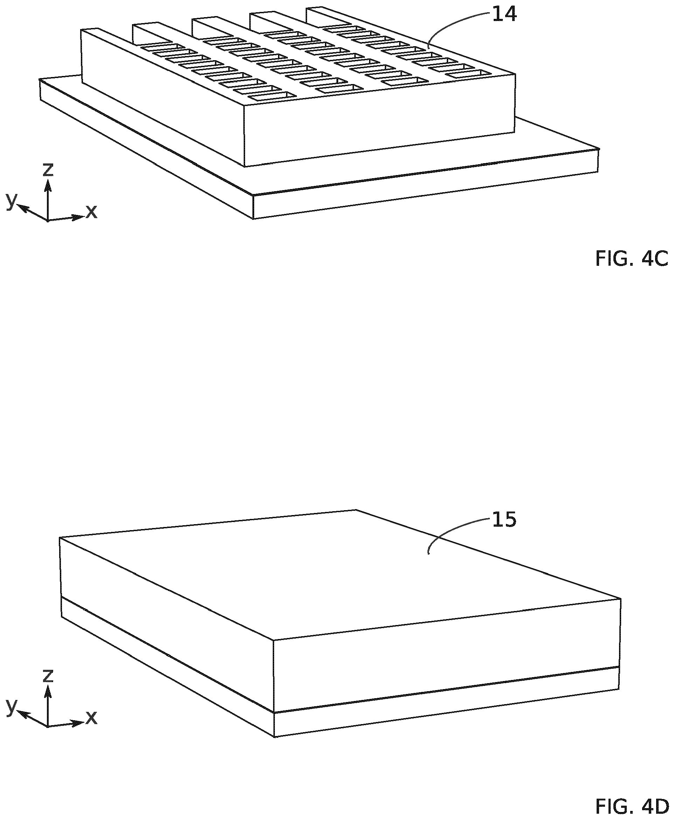

Former des grilles sacrificielles à cheval sur les parties centrales des motifs de transistors. Cette étape illustrée aux figures 4C-4F, et 29-33 par exemple, sera décrite en détail par la suite.

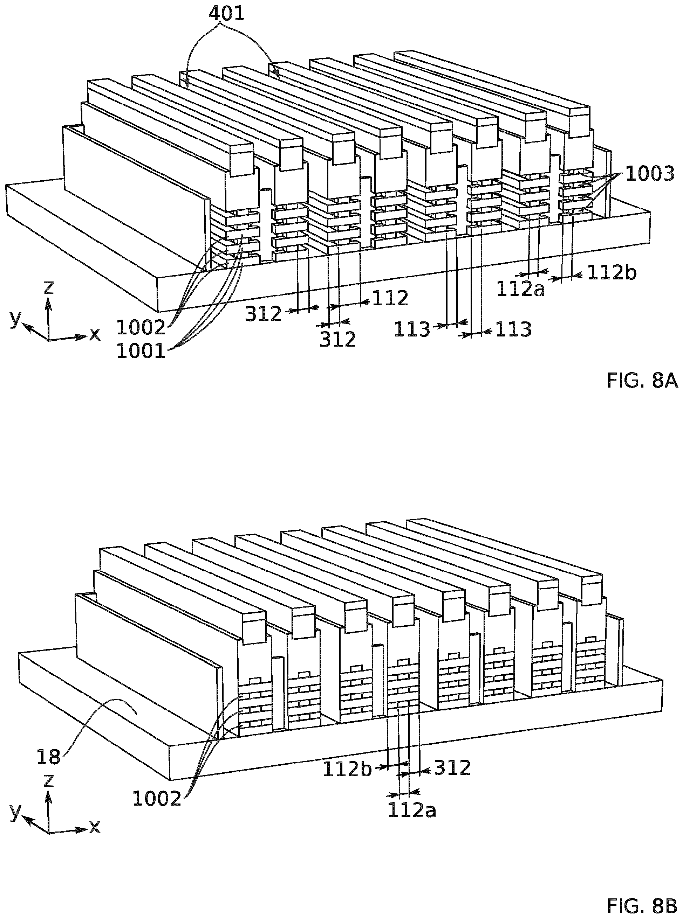

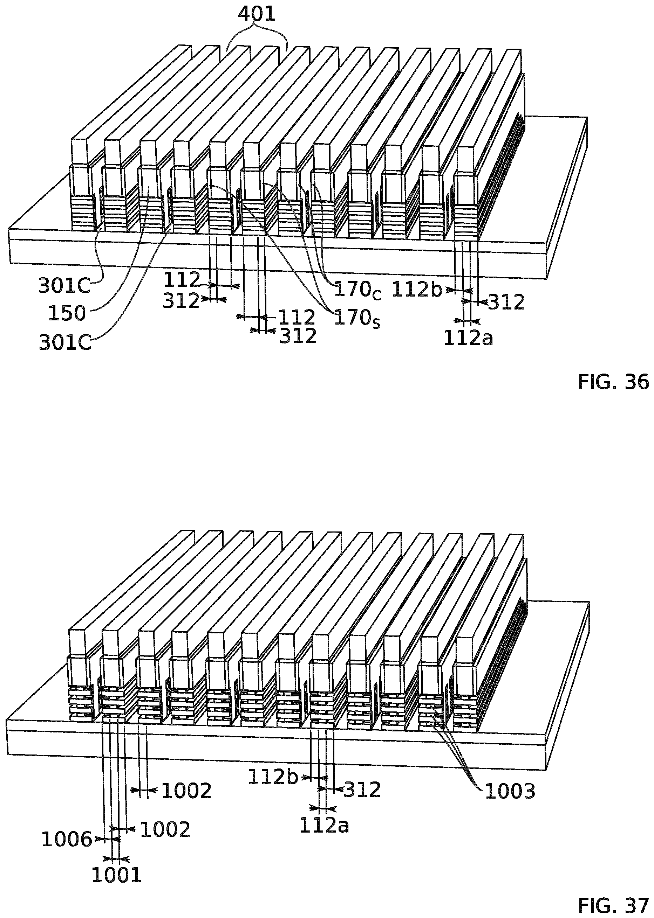

Retirer le deuxième matériau semi-conducteur de l'au moins une couche sacrificielle à partir des ouvertures de sorte à laisser un premier espace au niveau des parties périphériques des motifs de transistors. Cette étape illustrée aux figures 8A et 37 par exemple, sera décrite en détail par la suite.

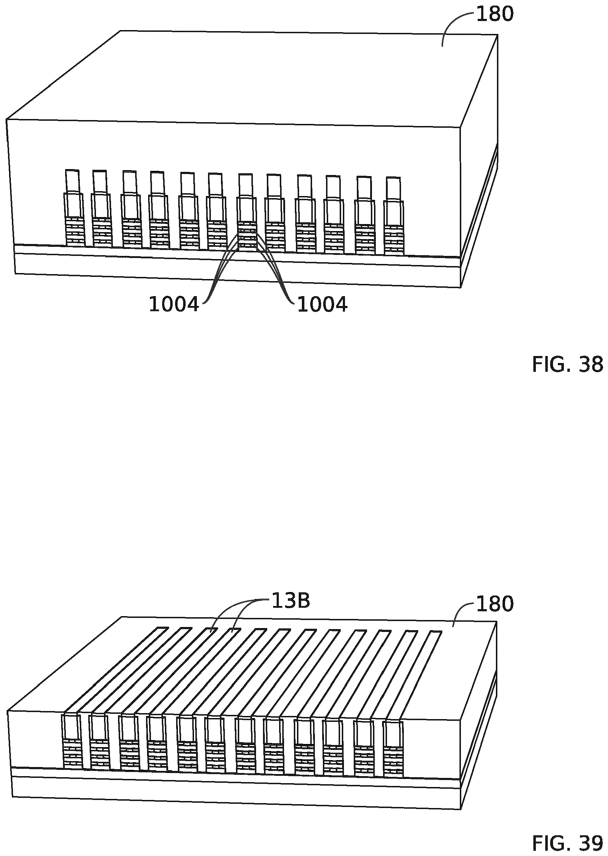

Remplir ledit premier espace, par un deuxième matériau diélectrique. Cette étape illustrée aux figures 8B et 38 par exemple, sera décrite en détail par la suite.

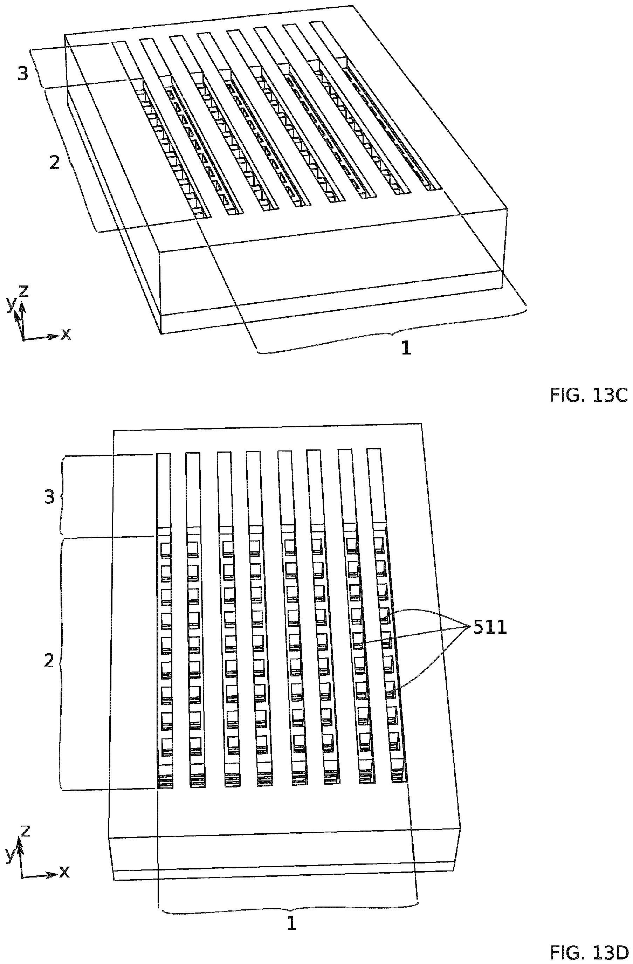

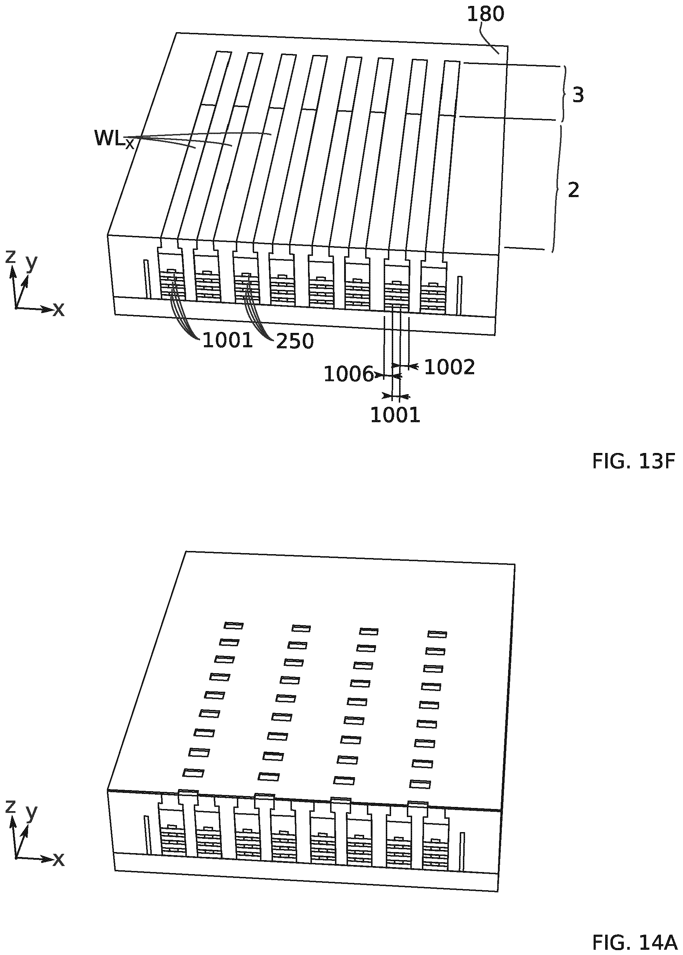

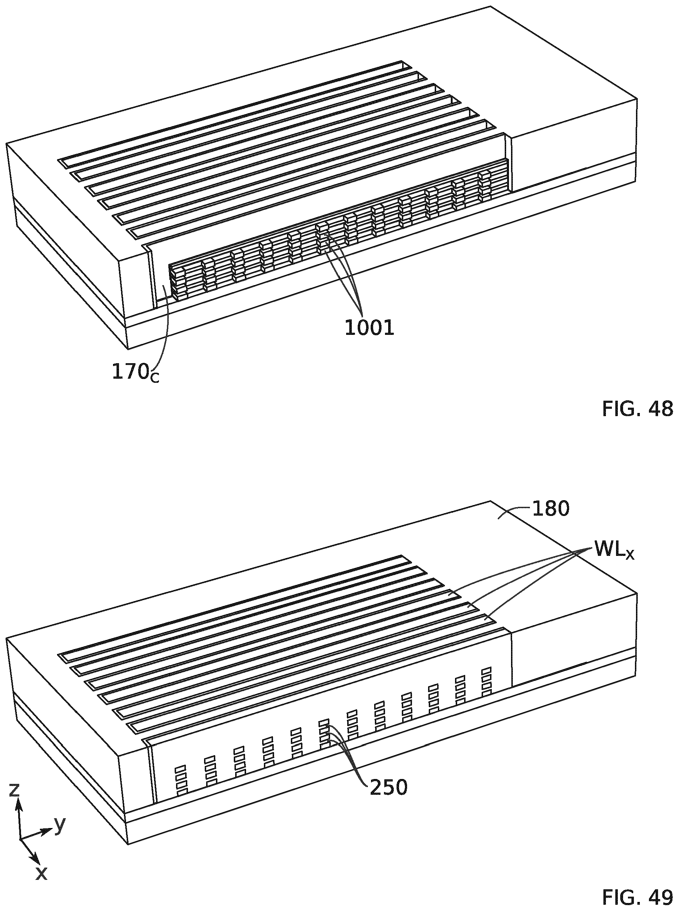

Retirer les grilles sacrificielles de sorte à dégager entièrement les canaux des transistors. Cette étape illustrée aux figures 13C-13E et 46-48 par exemple, sera décrite en détail par la suite.
- Former des grilles dites enrobantes entourant totalement les canaux des transistors d'au moins un niveau n_{z}. Cette étape illustrée aux figures 13F et 49 par exemple, sera décrite en détail par la suite.

L'invention va maintenant être décrite au travers de deux exemples de réalisation d'une mémoire résistive de type OxRAM. Ces deux exemples sont organisés en deux sections respectivement dénommées « Exemple 1 » et « Exemple 2 ». Les étapes de fabrication d'une mémoire selon ces exemples sont subdivisées en sous-sections respectivement dénommées « formation des grilles sacrificielles », « isolation des sources », « structuration de la zone sourcelines », « structuration de la zone wordlines », « structuration de la zone bitlines », « formation des contacts ». Ces sous-sections sont définies par souci de clarté et ne sont pas nécessairement strictement successives.

La figure 2 présente un schéma fonctionnel d'une telle mémoire résistive OxRAM, formée à partir d'une pluralité de cellules mémoires 10_{x,y,z,} comprenant chacune un élément résistif et un transistor. Ces cellules mémoires 10_{x,y,z} sont également dénommées cellules 1T1R.

Les cellules mémoires 10_{x,y,z} sont typiquement organisées de façon matricielle sur différents niveaux d'intégration. Un niveau d'intégration est situé à une altitude z donnée selon l'axe Z. Les cellules mémoires 10_{x,y,z} sont ainsi repérées par leurs coordonnées x et y pour un niveau z donné.

Afin d'adresser indépendamment chaque cellule mémoire 10_{x,y,z} de cette matrice 3D, des lignes de connexion sont dessinées. Chaque cellule mémoire 10_{x,y,z} est ainsi connectée à une ligne d'alimentation ou d'écriture dite sourceline SL_{z}, une ligne de commande ou de mots dite wordline WLₓ, et une ligne de lecture ou de données dite bitline BL_{y}.

Dans ces exemples, les sourcelines sont portées par les niveaux z, les wordlines s'étendent selon Y et les bitlines s'étendent selon X. Pour chaque cellule mémoire, l'élément résistif est relié à une bitline BL_{y}, la source du transistor est reliée à une sourceline SL_{z}, et la grille du transistor est reliée à une wordline WLₓ. Les wordlines WL₁, WL₂, WL₃, WL₄, WL₅, WL₆, WL₇, WL₈ sont par exemple au nombre de 8 (x = [1 ...8]), de façon à encoder une information sur 8 bits. Les niveaux portant les sourcelines SL₁, SL₂, SL₃, SL₄ sont par exemple au nombre de 4 (z = [1 ...4]) et nommés dans la suite n1, n2, n3, n4 ou, par contraction, niveaux SL₁, SL₂, SL₃, SL₄. Les bitlines BL₁, BL₂, BL₃, BL₄, BL₅, BL₆, BL₇, BL₈ sont par exemple au nombre de 8 (y = [1...8]), ou plus (y = [1... n]), en fonction du format logique requis pour la mémoire. Le nombre limité de cellules mémoires 10_{x,y,z} de ces exemples permet d'illustrer les caractéristiques principales de l'invention de façon claire et concise. Ces exemples n'excluent pas d'autres possibilités d'organisation de la matrice 3D.

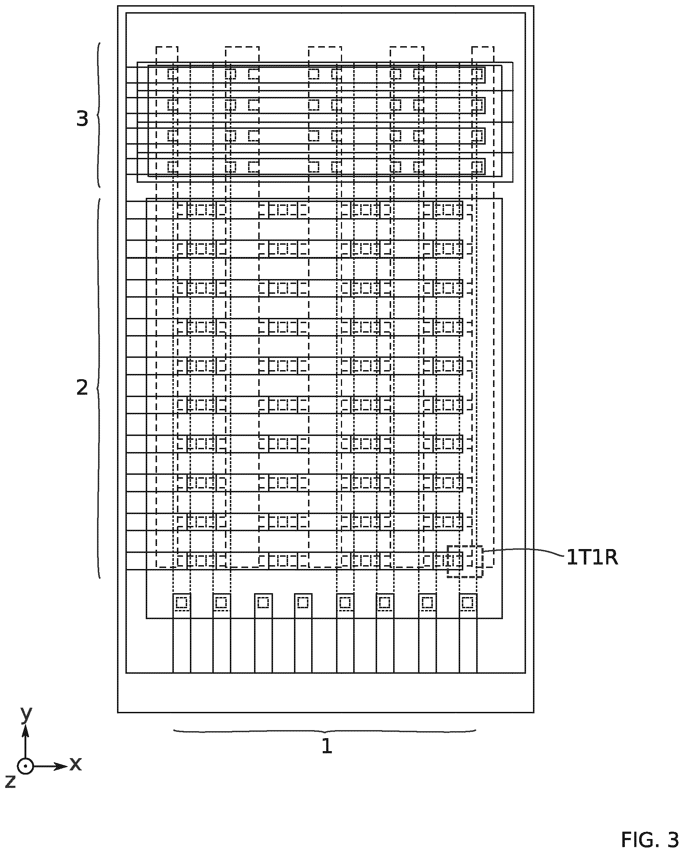

La figure 3 présente un exemple d'agencement des éléments structurels de la mémoire résistive OxRAM. Les cellules mémoires 1T1R forment une matrice dans le plan XY au croisement de la zone de wordlines 1 et de la zone de bitlines 2. Cet agencement peut comprendre une zone de sourcelines 3 déportée, jouxtant la matrice, de façon à faciliter la connexion des sourcelines.

Les éléments structurels de cette mémoire résistive sont principalement les transistors ou transistors de sélection, les éléments mémoires ou points mémoire, et les lignes de connexions wordlines, bitlines, sourcelines.

Selon l'invention, les transistors 101 sont empilés sur plusieurs niveaux d'intégration (selon l'axe z). Ces niveaux n₁, n₂, n₃, n₄ comprennent notamment les sources 1002 des transistors. Ils sont isolés électriquement les uns par rapport aux autres par l'intermédiaire d'une étape de formation de grilles sacrificielles 150. Ces grilles sacrificielles 150 sont ensuite remplacées par des grilles fonctionnelles enrobantes, de type GAA. Ce principe général permet d'obtenir une matrice 3D de transistors GAA dense. Dans les exemples illustrés et décrits ci-dessous, des zones de wordlines 1, bitlines 2 et sourcelines 3 sont également définies et des éléments mémoires 102 résistifs sont formés de façon à obtenir une mémoire OxRAM dense en intégration 3D.

Un premier exemple de réalisation d'une mémoire résistive de type OxRAM va maintenant être décrit en référence aux figures 4A à 18 dans la section suivante :

### Exemple 1

### Formation des grilles sacrificielles

Les figures 4A et 4B illustrent la formation de l'empilement et la définition des motifs de transistors. Les figures 4C à 4G illustrent des étapes de formation des grilles sacrificielles au niveau des motifs de transistors.

Comme illustré à la figure 4A, une première étape consiste à réaliser un empilement E de couches semi-conductrices 11, 12 sur un substrat S. Le substrat S peut être un substrat de type SOI (Silicon On Insulator) comprenant, selon la terminologie courante pour l'homme du métier, une couche de silicium épaisse dite « Si bulk » (non représentée sur la figure 4A), une couche d'oxyde de silicium dite « BOX » (Burried Oxide) et une couche de silicium mince dite « top Si ». L'épaisseur du top Si peut être typiquement de l'ordre de 12nm. L'épaisseur du BOX peut être typiquement comprise entre 25nm et 145nm. Alternativement, le substrat S peut être un substrat massif « Si bulk ». Alternativement, le substrat est de type GeOI ou SGOI (respectivement Germanium On Insulator ou Silicon-Germanium On Insulator) connu de l'homme du métier. Dans ce dernier cas, la couche au contact du BOX est une couche sacrificielle en SiGe. Cela permet *in fine* de former des transistors présentant tous une configuration GAA, sur chaque niveau.

L'empilement E comprend typiquement une alternance de couches 11 en silicium-germanium (SiGe) et de couches 12 en silicium (Si).

La concentration du Ge dans l'alliage SiGe peut être de 20%, 30% ou 45% par exemple. Cette concentration de germanium est choisie de façon à permettre une bonne sélectivité de la gravure du SiGe par rapport au Si, lors des étapes de gravure sélective. Plus la concentration de Ge sera importante, plus la sélectivité au Si sera grande lors du retrait ultérieur du SiGe. Cet empilement E est avantageusement formé par épitaxie des couches de SiGe 11 et de Si 12. Cette étape de formation de l'empilement E est peu coûteuse et bien connue de l'homme du métier. Les épaisseurs des couches Si et SiGe peuvent être typiquement de l'ordre de 15nm, et plus généralement comprises entre 5nm et 50nm par exemple. De façon connue afin d'éviter la formation de défauts structuraux, les épaisseurs maximales permises pour les couches 11 SiGe dépendent notamment de la concentration en Ge choisie.

Dans l'exemple illustré à la figure 4A, quatre couches de Si (la couche topSi du substrat et trois couches Si 12 épitaxiées) sont alternées avec quatre couches de Ge 11 épitaxiées. Un super réseau Si/SiGe est ainsi obtenu. Le nombre de couches de Si et de SiGe peut naturellement être augmenté. Cela permet *in fine* d'augmenter le nombre de transistors et de cellules mémoires.

Une couche de masque dur 13, de préférence en nitrure de silicium SiN, est ensuite déposée sur le super réseau Si/SiGe.

Tel qu'illustré à la figure 4B, une étape classique de lithographie/gravure est réalisée afin de définir des motifs de transistors 101M, des motifs de sources 301S et des ouvertures 201, 202. La gravure est anisotrope. Elle est configurée pour graver le super réseau Si/SiGe sur toute sa hauteur, en s'arrêtant sur le BOX. Elle peut être effectuée par plasma en utilisant une chimie de gravure HBr/O₂. Les motifs de transistors 101M peuvent présenter une longueur ℓ_{T} selon X comprise entre 100 nm et 500 nm. Ils présentent de préférence une largeur L_{T} selon Y comprise entre 10 nm et 80 nm, par exemple de l'ordre de 40nm. Cela permet d'obtenir une pluralité de nanofils de Si superposés et destinés à former les canaux des transistors.

Les ouvertures 202 dans la zone sourcelines 3 sont significativement plus larges que les ouvertures 201 de la matrice définie par les zones wordlines 1 et bitlines 2. Cela permet de réserver des emplacements suffisamment larges pour la formation ultérieure des contacts de sourcelines, en particulier pour des contacts sourcelines en escalier.

Les figures 4C et 4D illustrent respectivement des étapes de dépôt d'une couche 14 d'oxyde de silicium SiO₂ et d'une couche 15 de silicium polycristallin (polySi). Le SiO₂ est de préférence un oxyde stœchiométrique déposé par CVD, dit TEOS du nom du précurseur de silicium (TetraEthyl OrthoSilicate) généralement utilisé. Ce dépôt est conforme. L'épaisseur de SiO₂ déposé peut typiquement être de quelques nanomètres, par exemple 7 nm. Le polySi est déposé de façon à remplir les ouvertures 201, 202. L'épaisseur de polySi déposé peut typiquement être de quelques centaines de nanomètres, par exemple 380 nm. Ces dépôts successifs forment un empilement SiO₂/polySi s'apparentant à un empilement de grille classique. La structuration de cet empilement permet de former des pseudo-grilles dénommées grilles sacrificielles dans cette demande. Ces grilles sacrificielles sont en effet conservées lors d'étapes intermédiaires de fabrication des dispositifs, puis retirées pour être finalement remplacées par des grilles fonctionnelles. Selon une possibilité alternative, le polySi peut être remplacé par un silicium amorphe.

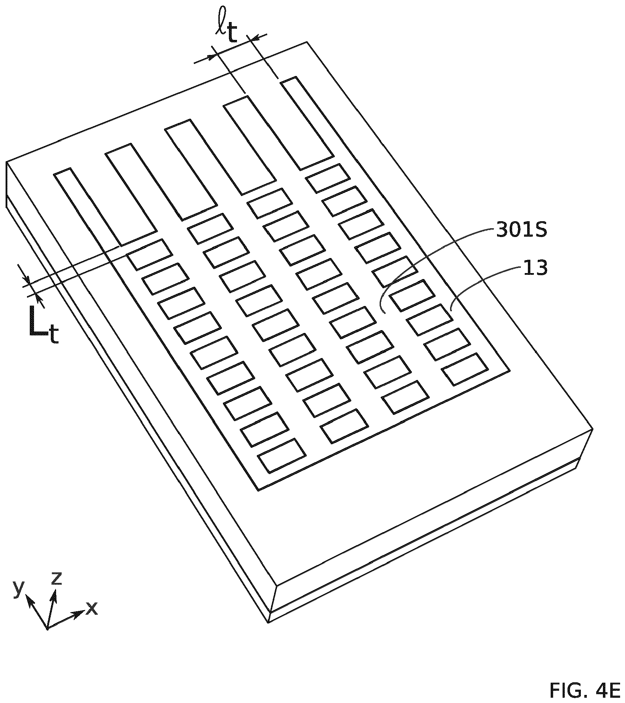

La figure 4E illustre une étape de planarisation, typiquement par polissage mécano-chimique CMP, configurée pour être arrêtée sur le masque dur 13.

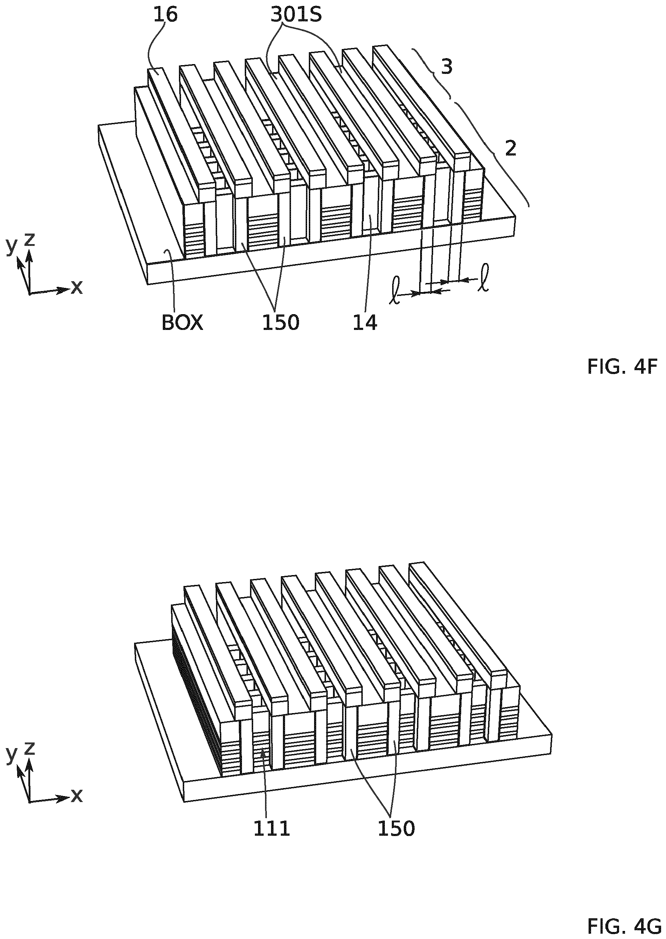

Un autre masque dur 16 peut ensuite être déposé sur toute la surface de la plaque, couvrant le masque dur 13 et le polySi exposé à l'issue de la planarisation (non illustré). Ce masque dur 16 comprend par exemple une couche de nitrure de silicium SiN d'épaisseur 90 nm environ surmontée d'une couche d'oxyde de silicium d'épaisseur 36 nm environ. Le masque dur 16 est structuré par lithographie/gravure de façon à définir les grilles sacrificielles. Le masque dur 16 couvre ainsi des portions de motifs de transistors 101M directement liées aux motifs de sources 301S (figure 4F). Ces portions de motifs de transistors 101M sont dites périphériques. Elles présentent de préférence une dimension ℓ selon X comprise entre 10 nm et 150 nm, par exemple 50 nm. Cette dimension ℓ peut être proportionnelle à la longueur ℓ_{T} des motifs de transistors 101M, par exemple ℓ= k.ℓ_{T} avec 0.1 ≤ k ≤ 0.4.

Les grilles sacrificielles 150 sont formées entre les portions périphériques, par gravure anisotrope du polySi en dehors des zones couvertes par le masque dur 16, tel qu'illustré à la figure 4F.

La gravure anisotrope du polySi selon Z peut être effectuée par plasma en chimie CH₂F₂ SF₆ N₂ He et/ou HBr / O₂ / He. La couche 14 de TEOS et l'oxyde enterré (BOX) servent avantageusement de couche d'arrêt lors de cette gravure du Poly-Si. Les grilles sacrificielles 150 de dimension ℓ selon X sont ainsi formées dans les zones « bitline » 2 et « sourceline » 3. Dans la zone bitline 2, les grilles sacrificielles 150 s'étendent entre les motifs de transistors. Elles bordent de part et d'autre, selon Y, les portions périphériques situées à chaque extrémité des motifs de transistors. Dans la zone sourceline 3, les grilles sacrificielles 150 s'étendent de façon continue selon Y.

La figure 4G illustre le retrait de la couche 14 d'oxyde TEOS, après gravure du polySi. Ce retrait permet d'exposer une portion centrale 111 des motifs de transistors, entre les portions périphériques 112.

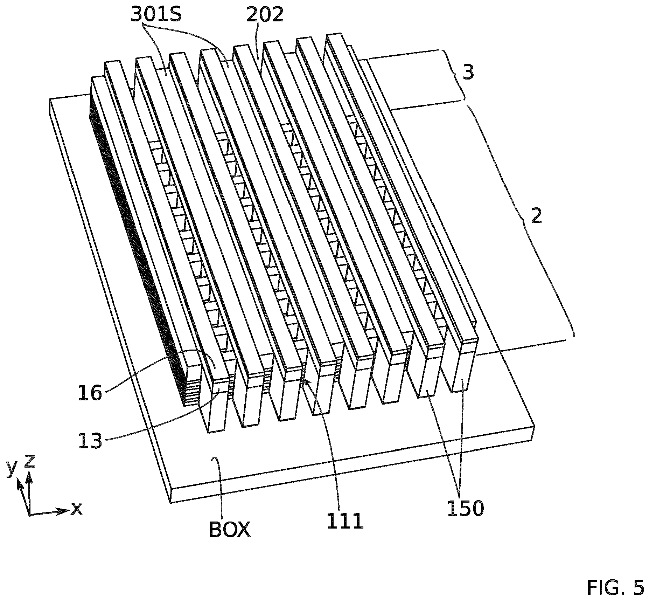

La figure 5 illustre la zone bitline 2 dans laquelle se trouvent les portions centrales 111 des motifs de transistors exposées, et la zone sourceline 3 dans laquelle les ouvertures 202 sont bordées par les grilles sacrificielles 150.

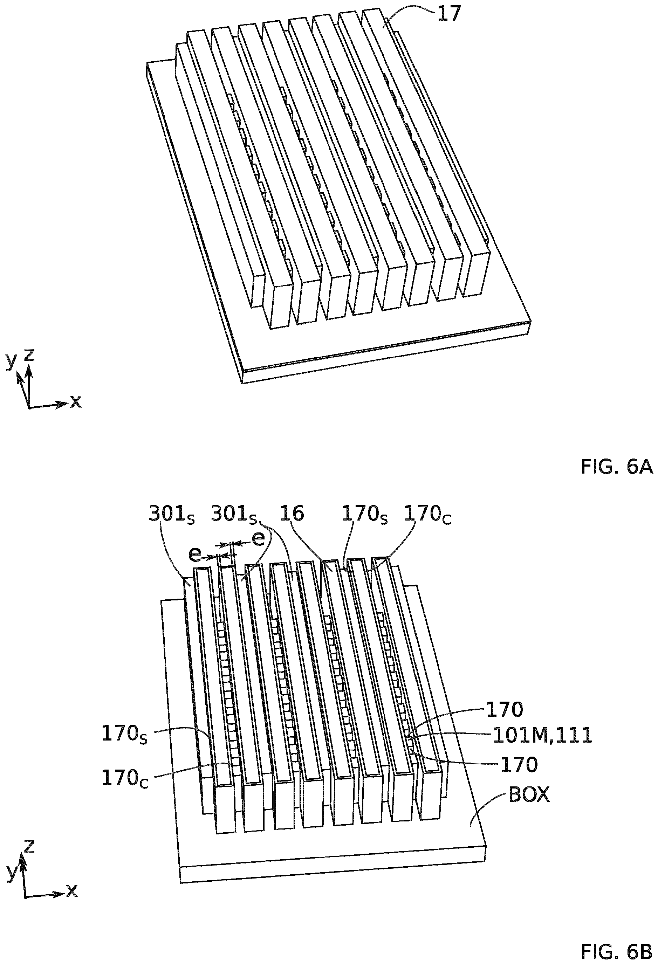

Les figures 6A et 6B illustrent la formation d'espaceurs 170, 170_{c}, 170ₛ. Les espaceurs 170_{c}, 170ₛ s'étendent principalement selon y de part et d'autres des grilles sacrificielles 150. Ces espaceurs 170_{c}, 170ₛ sont dits longitudinaux. Les espaceurs 170 s'étendent principalement selon x de part et d'autres des motifs de transistors 101M. Ces espaceurs 170 sont dits transverses. Les espaceurs 170, 170_{c}, 170ₛ sont typiquement formés à partir d'un dépôt d'une couche 17 de SiN (figure 6A) conforme suivi d'une gravure anisotrope de cette couche 17 de SiN (figure 6B). L'épaisseur e de la couche de SiN peut être comprise entre 10 nm et 50 nm, par exemple de l'ordre de 20 nm. A l'issue de la gravure des espaceurs, le masque dur 16 et le BOX sont exposés. Les espaceurs 170_{c}, 170ₛ présentent une largeur selon X égale à e et couvrent les flancs du masque dur 16. Les motifs de sources 301S sont ainsi en partie couverts par ces espaceurs 170ₛ sur leurs côtés bordant les masques durs 16. Les espaceurs 170ₛ forment sur les côtés des motifs de sources 301S une surépaisseur de SiN visant à protéger l'empilement Si/SiGe lors d'une gravure ultérieure. Les espaceurs 170_{c} couvrent les portions périphériques 112 de motifs de transistors 101M. Les espaceurs 170 couvrent les flancs des portions centrales 111 de motifs de transistors 101M.

Les parties de la couche de SiN s'étendant dans des plans parallèles au plan de base XY, entre les espaceurs transverses, sont ensuite ouvertes par une première gravure anisotrope, par exemple par plasma en utilisant une chimie fluorocarbonnée, par exemple à base de CH₂F₂ O₂ ou CH₃F/O₂ et CHF₃. Une telle première gravure anisotrope est connue de l'homme du métier. L'empilement Si/SiGe sous-jacent aux parties ouvertes est ensuite gravé sur toute sa hauteur, avec arrêt sur la couche d'oxyde enterré (BOX), par une deuxième gravure anisotrope, par exemple par plasma en utilisant une chimie HBr/O₂.

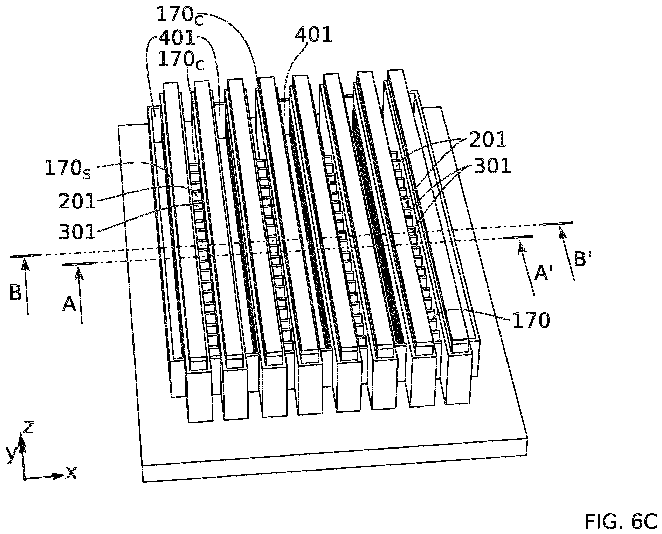

La figure 6C illustre la structure obtenue après ces première et deuxième gravures anisotropes. En particulier, les motifs de sources 301S ont été partiellement gravés et laissent place à des ouvertures 401 bordées par les empilements Si/SiGe surmontés des espaceurs 170ₛ. Les portions centrales 111 des motifs de transistors 101M ont été gravées et laissent place à des ouvertures 301 bordées par les espaceurs 170, 170_{c}. Ces ouvertures 301 débouchant sur les portions périphériques des motifs de transistors sont avantageusement délimitées par les espaceurs 170, 170_{c}. Cela permet de relâcher les contraintes de résolution en lithographie pour remplir ultérieurement ces ouvertures 301.

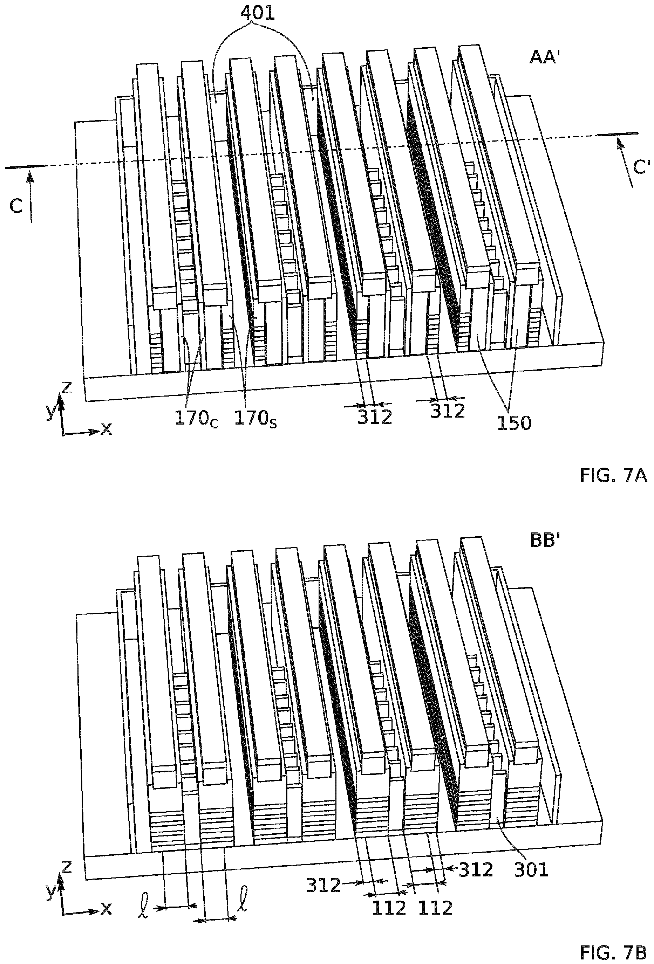

Deux coupes transverses dans la structure illustrée en figure 6C sont présentées aux figures 7A et 7B.

La figure 7A montre une coupe transverse passant au travers d'ouvertures 201, selon la ligne AA' matérialisée sur la figure 6C. Cette coupe transverse est similaire à une coupe transverse passant au travers d'ouvertures 401 (non illustrée). Il apparaît que les grilles sacrificielles 150 forment une série de piliers permettant un ancrage latéral des multicouches Si/SiGe ainsi structurés en « peigne ». Les portions périphériques 312 des motifs de sources 301S sont continues le long de l'axe Y. Un premier côté de ces portions périphériques 312 débouche sur les ouvertures 401. Un deuxième côté de ces portions périphériques 312 est attaché aux grilles sacrificielles 150. Préférentiellement, les couches Si de ces portions périphériques 312 formeront ultérieurement les sources des transistors.

La figure 7B montre une coupe transverse passant au travers d'ouvertures 301, selon la ligne BB' matérialisée sur la figure 6C. Les dents du « peigne» correspondent aux portions périphériques 112 des motifs de transistors 101M, de longueur ℓ selon X. Préférentiellement, les couches Si de ces portions périphériques 112 formeront ultérieurement les canaux et les drains des transistors.

### Isolation des sources

Afin de pouvoir adresser indépendamment chacun des transistors de la matrice 3D, il est nécessaire d'isoler au moins en partie les transistors entre eux. Ces transistors sont formés à partir des couches Si de l'empilement Si/SiGe. Les couches SiGe sont donc de préférence retirées et remplacées par des couches électriquement isolantes. Les couches SiGe sont dites sacrificielles. Elles sont utilisées pour la formation de l'empilement puis retirées pour isoler les transistors, et en particulier les sources de ces transistors.

Avantageusement, une étape d'isolation des sources alimentant les canaux des transistors est effectuée. Ces sources sont formées à partir des couches Si des portions périphériques 312 des motifs de sources 301S illustrées aux figures 7A, 7B.

Tel qu'illustré à la figure 8A, des portions des couches SiGe de l'empilement sont gravées à partir des ouvertures 301, 401. Cette gravure est sélective vis-à-vis du silicium, et de préférence isotrope. Une solution de gravure à base d'acide acétique, d'acide fluorhydrique HF et d'eau oxygénée H₂O₂ peut être utilisée.

La gravure est configurée de manière à ce que les couches SiGe des portions périphériques 312 soient gravées au travers des ouvertures 401. Le front de gravure à partir des ouvertures 401 s'arrête ainsi sensiblement à l'aplomb des grilles sacrificielles 150. Les sources 1002 sont dès lors suspendues.

La gravure des couches SiGe s'effectue de préférence également au travers des ouvertures 301. La gravure sélective des couches SiGe se fait ainsi de part et d'autre de l'empilement, au niveau des motifs de transistors, tel qu'illustré à la figure 8A. Des parties 113 de couches SiGe des portions périphériques 112 sont ainsi gravées. Ces parties 113 forment un premier espace qui sera ultérieurement rempli par un matériau diélectrique. La gravure est de préférence arrêtée au temps avant que les couches SiGe soient totalement retirées. Des portions 1003 de SiGe sont ainsi conservées. Les portions périphériques 112 sont ainsi subdivisées en parties 112a, 112b. Les parties 112a comprennent les futurs canaux 1001 en Si alternés avec les portions 1003 en SiGe. Les parties 112b comprennent les futurs drains 1006 en Si suspendus. La définition des drains 1006 et des canaux 1001 peut ainsi se faire lors de cette étape de gravure partielle du SiGe. Cette gravure partielle permet également d'éviter un risque d'effondrement des canaux 1001 de transistors.

Les grilles sacrificielles en Poly-Si permettent notamment de maintenir les couches Si lors de la gravure SiGe. Elles forment une structure de piliers d'accroché pour les couches Si.

La figure 8B illustre le dépôt d'une couche 18 diélectrique, par exemple SiN, destinée à remplir les cavités formées par le retrait du SiGe. Les sources 1002 sont ainsi isolées électriquement entre elles.

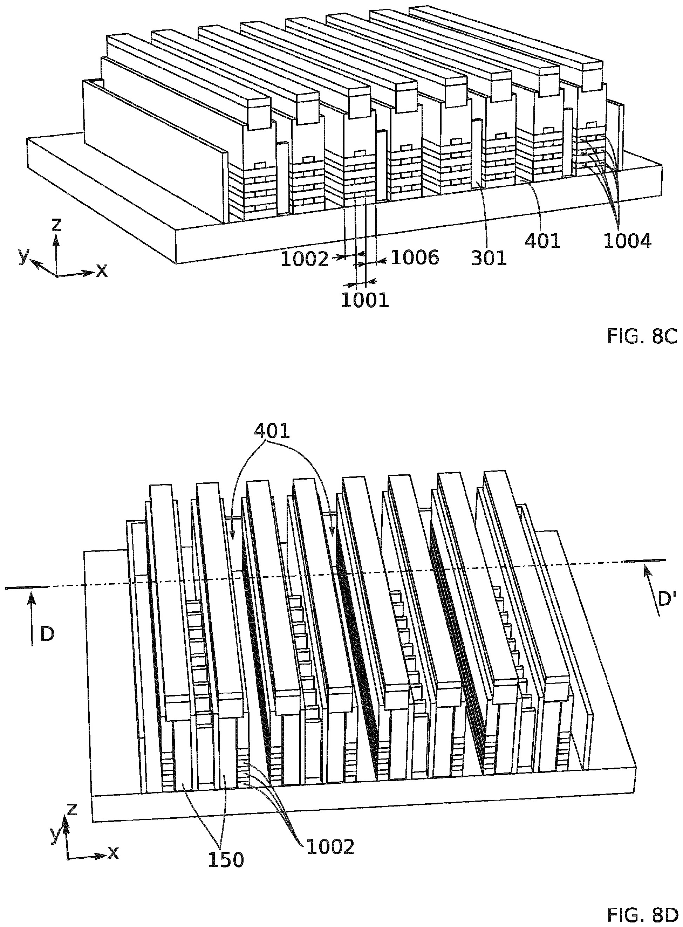

La couche 18 est ensuite partiellement gravée, par exemple à l'aide d'une solution d'acide phosphorique H₃PO₄ dilué ou d'acide acétique ou d'eau oxygénée H₂O₂, de façon à exposer les flancs sensiblement parallèles au plan YZ des couches Si, du côté des ouvertures 401 et du côté des ouvertures 301. Le BOX est de préférence également exposé lors de cette gravure de la couche 18, tel qu'illustré à la figure 8C. Les figures 8A à 8C illustrent ces étapes de retrait du SiGe et d'isolation des sources selon une coupe transverse passant par les ouvertures 301.

La figure 8D illustre l'état de la structure après ces étapes de retrait du SiGe et d'isolation des sources selon une coupe transverse passant par les ouvertures 201. Il apparaît clairement que les grilles sacrificielles 150 servent de support aux sources 1002.

La figure 9 est une image de microscopie électronique à balayage en transmission (STEM) illustrant un dispositif obtenu après isolation des sources 1002, tel que schématisé à la figure 8C.

Les portions de SiGe 1003 restants sont visibles entre les canaux 1001 des transistors. Les bouchons 1004 formés par le dépôt de la couche SiN 18 sont également visibles de part et d'autre des portions SiGe 1003. La couche de protection 50 est une épitaxie réalisée pour d'autres besoins.

Les figures 10A et 10B présentent des agrandissements de la structure obtenue respectivement avant et après isolation. Ainsi, la figure 10A illustre de façon agrandie une coupe transverse selon la ligne CC' représentée sur la figure 7A, passant au travers des ouvertures 401 de la zone sourceline. La figure 10B illustre de façon agrandie une coupe transverse selon la ligne DD' représentée sur la figure 8D, passant au travers des ouvertures 401 de la zone sourceline.

Les grilles sacrificielles 150, les espaceurs 170_{c}, 170ₛ, les masques durs 13 et 16, et les sources 1002 sont visibles sur les deux figures 10A, 10B. Les portions SiGe 1005 des portions périphériques 312 des motifs de sources 301S présentes avant isolation (figure 10A) sont remplacées par les bouchons SiN 1004 dans les portions périphériques 312 des motifs de sources 301S après isolation (figure 10B).

### Structuration de la zone sourcelines

Après isolation des sources 1002, les ouvertures 401, 301, 201 entre les lignes de masque dur 16 sont remplies de préférence par un oxyde TEOS 180. La structure est ensuite planarisée par CMP jusqu'à retrait du masque dur 16, de façon à exposer le masque dur 13.

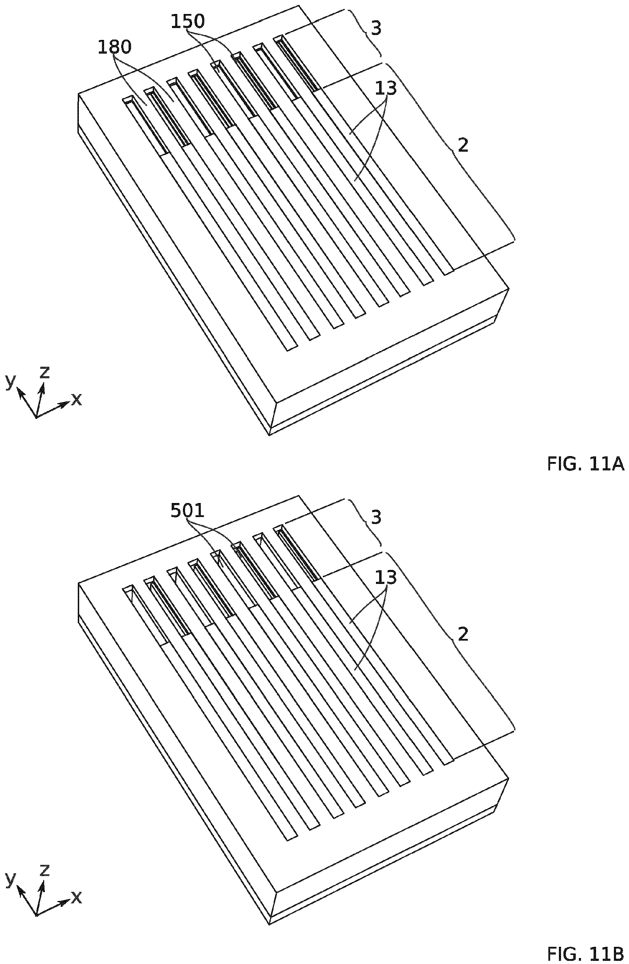

Par une étape de lithographie / gravure classique, ce masque dur 13 peut alors être retiré dans la zone sourceline 3, de façon à exposer le polySi des grilles sacrificielles 150, tel qu'illustré à la figure 11A. Le masque dur 13 SiN peut être gravé à l'aide d'une solution d'acide phosphorique H₃PO₄ dilué, ou par gravure sèche plasma à base d'espèces fuorocarbonnées (par exemple CH₂F₂/O₂).

Les grilles sacrificielles 150 de la zone sourceline 3 sont ensuite retirées, tel qu'illustré à la figure 11B. Le polySi des grilles sacrificielles peut être gravé à l'aide d'une solution d'hydroxyde de tétraméthylammonium (TMAH) ou d'hydroxyde de tétraéthylammonium (TEAH). L'oxyde TEOS des grilles sacrificielles peut être gravé à l'aide d'un plasma en chimie fluorocarbonnée, par exemple en chimie CF₄ / CH₂F₂/ He.

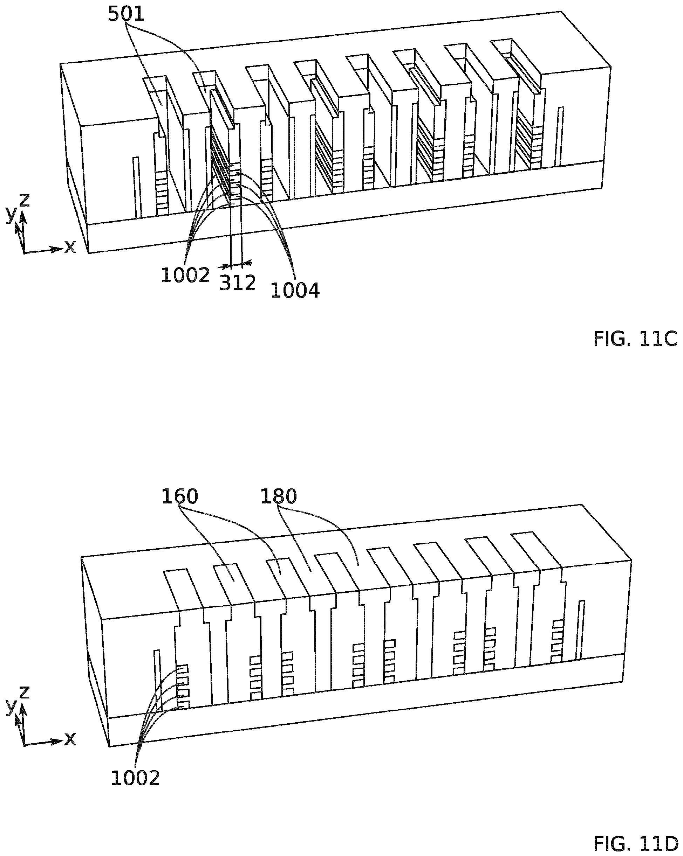

Dans l'exemple illustré à la figure 11C, le retrait des grilles sacrificielles 150 forme des ouvertures 501. Ces ouvertures 501 exposent le deuxième côté des portions périphériques 312 comprenant l'empilement des sources 1002 isolées entre elles par les bouchons de SiN 1004. Les grilles sacrificielles ont ainsi permis de former un support aux sources 1002 lors du remplacement des portions de SiGe 1005 par les bouchons de SiN 1004 dans les portions périphériques 312. Pour des portions SiGe 1005 présentant une largeur selon X inférieure ou égale à 100 nm, ce remplacement peut se faire en une seule étape tel qu'illustré précédemment par les figures 7A à 8D.

En revanche, si les portions SiGe 1005 présentent une largeur selon X supérieure à 100 nm, par exemple 150 nm ou 200 nm, le retrait complet de ces portions 1005 peut induire un effondrement ou collage des sources 1002 les unes sur les autres. Dans ce cas, un retrait partiel des portions 1005 sur une largeur selon X inférieure à 100 nm peut d'abord être effectué à partir des ouvertures 401 débouchant sur le premier côté des portions périphériques 312 (non illustré). Puis, après retrait des grilles sacrificielles, un retrait complémentaire des portions 1005 sur une largeur selon X restante peut être effectué à partir des ouvertures 501 débouchant sur le deuxième côté des portions périphériques 312. Dans ce cas, les grilles sacrificielles forment d'abord un support lors du premier retrait partiel du SiGe intercalé entre les sources, puis, en les retirant, ces grilles sacrificielles permettent un accès pour le deuxième retrait complémentaire du SiGe intercalé entre les sources. Ce remplacement en deux étapes par l'intermédiaire des grilles sacrificielles permet par exemple de dimensionner les sources de façon à ce qu'elles présentent une largeur comprise entre 1 fois et 2 fois la largeur critique d'effondrement des sources, i. e. la largeur au-delà de laquelle les sources sont susceptibles de s'effondrer.

Après retrait des grilles sacrificielles dans la zone sourceline 3, les ouvertures 501 sont remplies de préférence par un dépôt de SiN 160. Ce dépôt est suivi d'une planarisation par CMP avec arrêt sur la couche d'oxyde TEOS 180, tel qu'illustré à la figure 11D.

Les sources 1002 sont ainsi complètement isolées entre elles dans les zones sourceline 3.

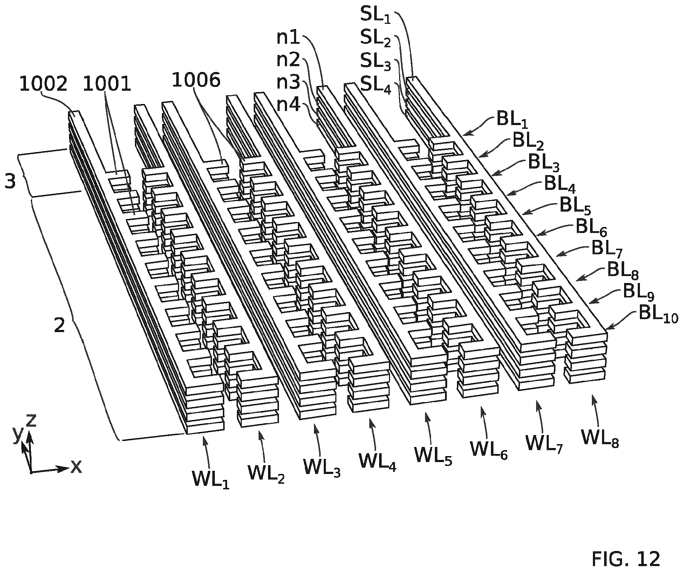

La figure 12 montre uniquement les éléments à base de Si de la structure. Les sources 1002 desservant les canaux 1001 de transistors dans la zone bitline 2, sous forme de peignes, sont ainsi clairement visibles. Ce « squelette » de silicium peut notamment permettre de former une matrice 3D comprenant 8 wordlines WL₁, WL₂, WL₃, WL₄, WL₅, WL₆, WL₇, WL₈, 4 niveaux n1, n2, n3, n4 de sourcelines SL₁, SL₂, SL₃, SL₄ et 10 bitlines BL₁, BL₂, BL₃, BL₄, BL₅, BL₆, BL₇, BL₈, BL₉, BL₁₀.

### Structuration de la zone wordlines

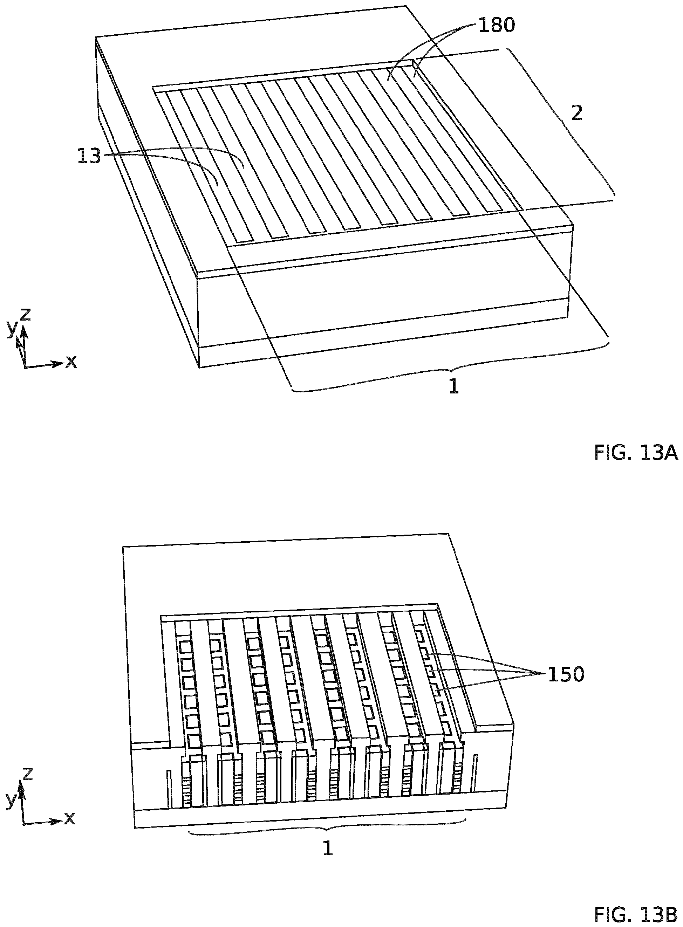

La figure 13A illustre un masquage, par exemple par lithographie, permettant de protéger la zone sourceline 3 tout en exposant la zone wordlines 1. Dans la suite, les WL sont réalisées au niveau des lignes de masque dur 13.

Tel qu'illustré à la figure 13B, une gravure du masque dur 13 est effectuée de manière à exposer le polySi des grilles sacrificielles 150 de la zone wordlines 1. Cette gravure du masque dur 13 en SiN peut se faire par plasma, par exemple à l'aide d'une chimie de plasma CH₂F₂/O₂ ou CHF₃/He et CH₃F/O₂/He/CH₄.

Les grilles sacrificielles 150 de la zone wordlines 1 sont ensuite retirées, tel qu'illustré aux figures 13C, 13D. Le polySi des grilles sacrificielles peut être gravé à l'aide d'une solution d'hydroxyde de tétraméthylammonium (TMAH) ou d'hydroxyde de tétraéthylammonium (TEAH) (figure 13C). L'oxyde TEOS des grilles sacrificielles peut être gravé à l'aide d'un plasma en chimie fluorocarbonnée, par exemple en chimie CF₄ / CH₂F₂/ He (figure 13D).

Dans l'exemple illustré à la figure 13D, le retrait des grilles sacrificielles 150 forme des ouvertures 511. Ces ouvertures 511 sont bordées par deux portions périphériques 112 de motifs de transistors 101M, un premier côté de portions périphériques 312 comprenant l'empilement des sources 1002 isolées entre elles, et un espaceur 170_{c} (non visible).

Les portions périphériques 112 de motifs de transistors 101M comprennent ici chacune une partie 112a formée d'un empilement de nanofils en Si entre lesquels se trouvent des portions 1003 de SiGe, et une partie 112b formée d'un empilement de nanofils en Si entre lesquels se trouvent des bouchons 1004 de SiN.

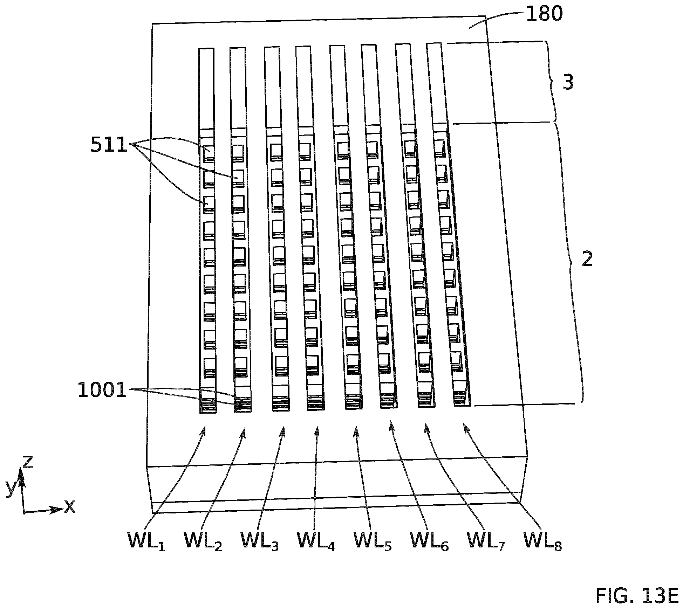

La figure 13E illustre la gravure sélective des portions 1003 de SiGe. Cela permet de former un deuxième espace qui sera ensuite rempli de façon à former une grille fonctionnelle. Cette gravure présente une bonne sélectivité S_{SiGe:Si} par rapport au Si, de préférence S_{SiGe:Si} > 5:1. Cela permet de graver le SiGe tout en préservant les nanofils Si et les parties des sources 1002 exposées au niveau du premier côté des portions périphériques 312. Cette gravure présente également une bonne sélectivité S_{SiGe:SiN} par rapport au SiN, de préférence S_{SiGe:SiN} > 5:1. Cela permet de graver le SiGe tout en préservant les espaceurs 170_{c} en SiN et les bouchons 1004. La gravure est ainsi confinée le long des WL, en étant stoppée latéralement par les espaceurs SiN 170_{c} et le premier côté des portions périphériques 312.

A l'issue de la gravure, les canaux 1001 des transistors en Si sont suspendus entre les ouvertures 511 d'une même wordline WLₓ (x = 1...8) (figure 13E).

La figure 13F illustre la formation des grilles fonctionnelles à la place des grilles sacrificielles. Des dépôts successifs de matériaux utilisés pour la formation de grilles fonctionnelles permettent de former les grilles fonctionnelles 250 autour de chaque canal 1001. Ces grilles fonctionnelles peuvent être formées à partir d'un dépôt de matériau à haute constante diélectrique dit high-k, par exemple HfO₂ sur une épaisseur de 2nm, suivi d'un dépôt de TiN sur une épaisseur de 3nm, suivi d'un dépôt de tungstène W visant à remplir les ouvertures 511 et les wordlines WLₓ délimitées par l'oxyde TEOS 180. Une planarisation par CMP avec arrêt sur l'oxyde TEOS 180 permet au besoin d'enlever les couches métalliques excédentaires. Les wordlines WLₓ (x = 1...8) sont ainsi définies. Les transistors de la matrice 3D sont donc des transistors MOS à grille enrobante (Gate-All-Around) à base de nanofils Si empilés.

La figure 13F permet de distinguer en coupe les sources 1002 des transistors, les canaux 1001 entourés par les grilles enrobantes 250, et des parties de nanofil formant les drains 1006 des transistors. Les sources 1002 s'étendent selon Y jusque dans la zone sourceline 3. Les drains 1006 s'étendent selon X jusqu'aux zones d'ouvertures 301 remplies d'oxyde 180.

### Structuration de la zone bitlines

L'étape suivante consiste à enlever l'oxyde 180 des zones d'ouvertures 301, de façon à accéder aux drains 1006 des transistors.

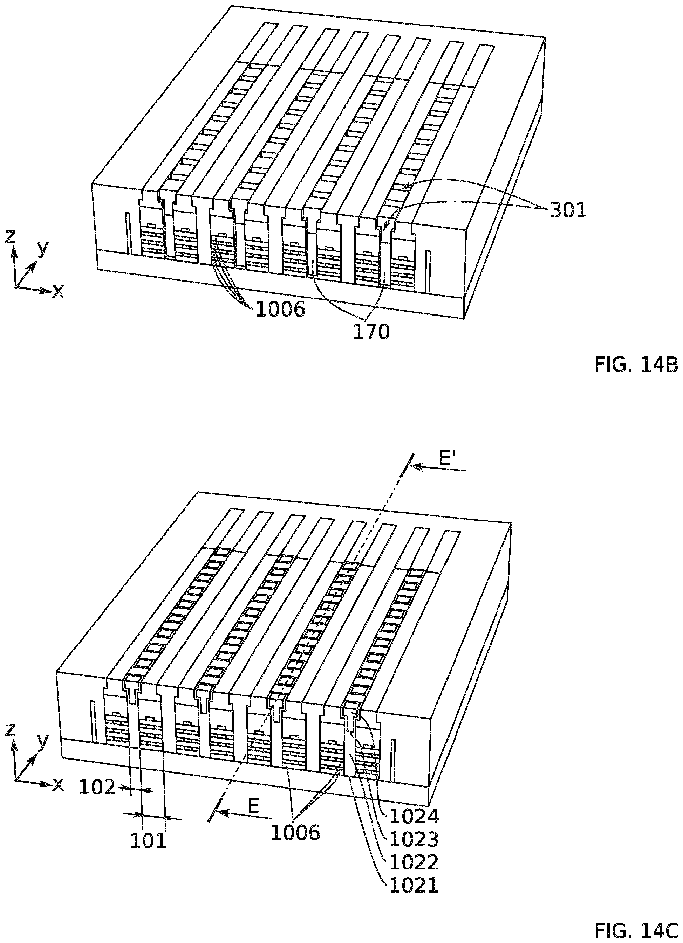

La figure 14A illustre une étape de lithographie préalable à la gravure de l'oxyde 180 au niveau des zones d'ouvertures 301. Avantageusement, les contraintes d'alignement liées à cette étape de lithographie sont diminuées grâce à la présence des espaceurs 170 noyés dans l'oxyde 180. Une gravure sélective de l'oxyde 180 vis-à-vis du nitrure SiN des espaceurs 170 permet dès lors d'exposer « automatiquement » les ouvertures 301 débouchant sur les drains 1006, tel qu'illustré à la figure 14B. La formation ultérieure des éléments résistifs des points mémoire précisément au niveau des ouvertures 301 est ainsi avantageusement assistée par la présence des espaceurs 170 définissant les ouvertures 301. Cette étape de lithographie/gravure de l'oxyde 180 destinée à ouvrir les zones de points mémoire est dite « auto-alignée », du fait de la présence des espaceurs 170 guidant la gravure de l'oxyde 180.

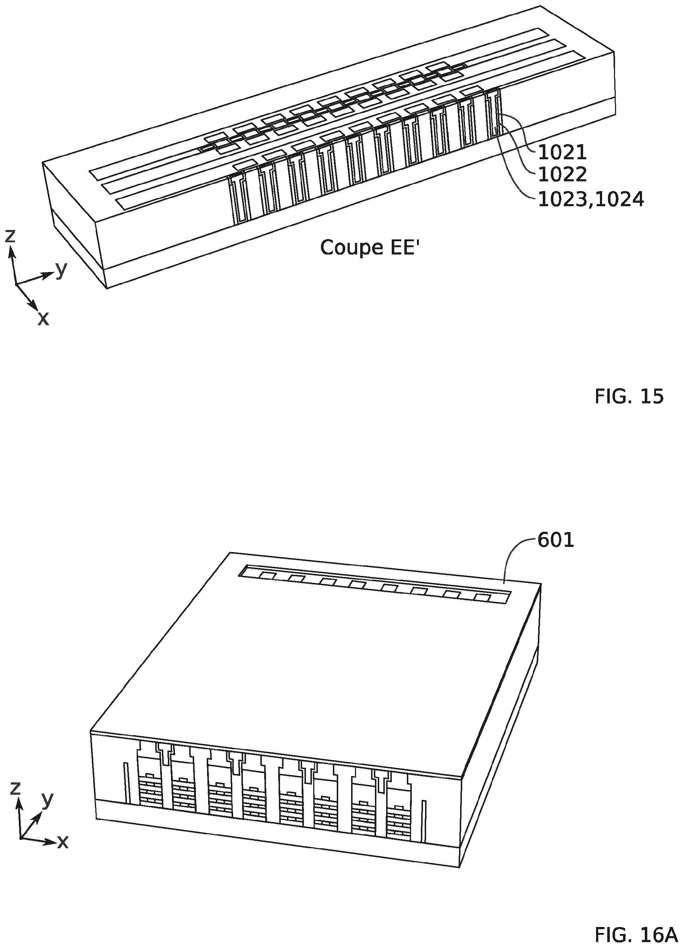

Après gravure de l'oxyde 180, les ouvertures 301 sont remplies par dépôts successifs de façon à former les éléments mémoire ou points mémoire 102, tel qu'illustré aux figures 14C et 15, respectivement selon une coupe transverse et une coupe longitudinale. Dans le cas d'une mémoire résistive de type OxRAM, ces points mémoire peuvent être à base de HfO₂.

Par exemple, ces points mémoire peuvent être réalisés par dépôt d'une couche HfO₂ 1021, par exemple d'épaisseur 5nm, suivi d'un dépôt d'une couche de Ti 1022, par exemple d'épaisseur 5nm, suivi d'un dépôt d'une couche de TiN 1023, par exemple d'épaisseur supérieure à 5nm suivi d'un dépôt d'une couche de W 1024, par exemple d'épaisseur 300nm. La couche de W 1024 peut typiquement s'étendre en dehors des ouvertures 301. Elle est alors planarisée par CMP avec arrêt sur la couche d'oxyde 180.

Les points mémoire 102 ainsi formés sont directement au contact des drains 1006 des transistors de sélection. Selon une possibilité, les drains 1006 peuvent être préalablement siliciurés avant le dépôt des couches formant les éléments mémoire 102. L'auto-alignement des points mémoires avec les drains 1006 des transistors de sélection permet notamment de rapprocher ces deux éléments formant une cellule mémoire résistive. Cela permet d'augmenter la densité de cellules mémoire résistives au sein de la matrice 3D.

En particulier, chaque élément mémoire 102 présente un bord ou flanc au contact d'un bord ou flanc d'un espaceur 170_{c} surmontant l'empilement formant les drains des transistors. Ces bords ou flancs s'étendent principalement selon des plans parallèles au plan yz.

### Formation des contacts

La figure 16A illustre une étape de lithographie visant à former des contacts dans la zone sourceline 3 de la matrice 3D. Les contacts à former dans la zone sourceline 3 sont de préférence des contacts en escalier. Une séquence d'étapes de lithographie/gravure permet alors, de façon connue, de former de tels contacts en escalier, sur chacun des niveaux de source. Typiquement, une première ligne 601 de motifs de contacts est définie par lithographie (figure 16A).

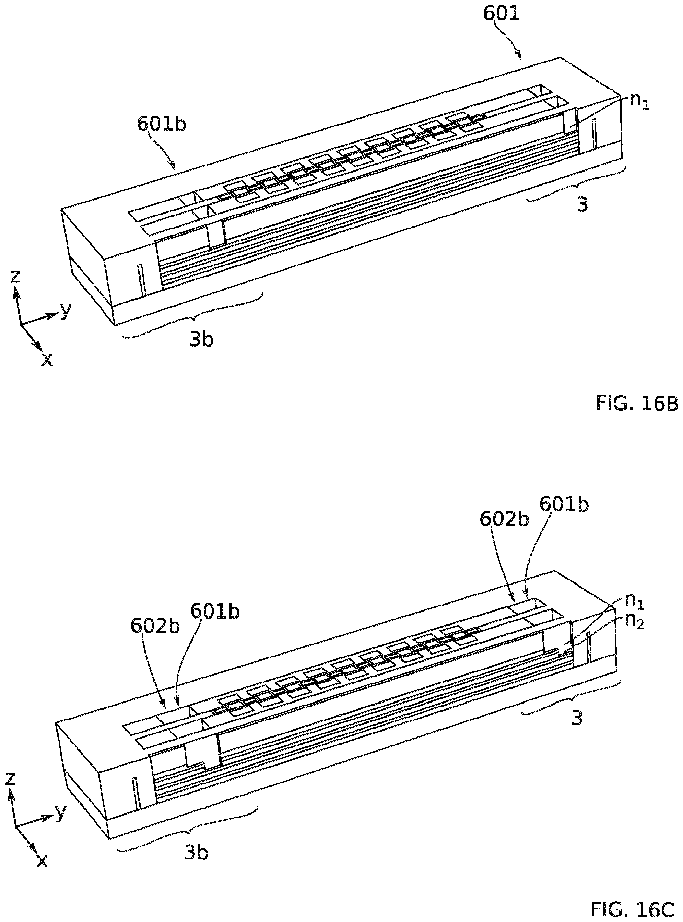

Une première gravure configurée pour atteindre et graver le premier niveau n1 de source est alors effectuée (figure 16B).

Une deuxième lithographie peut ensuite permettre de définir une deuxième ligne 602 de motifs de contacts, tout en gardant la première ligne 601 exposée. Une deuxième gravure similaire à la première gravure est effectuée. Cela permet d'atteindre et graver simultanément le premier niveau n₁ de source au niveau de la deuxième ligne 602 et le deuxième niveau n₂ de source au niveau de la première ligne 601 (figure 16C).

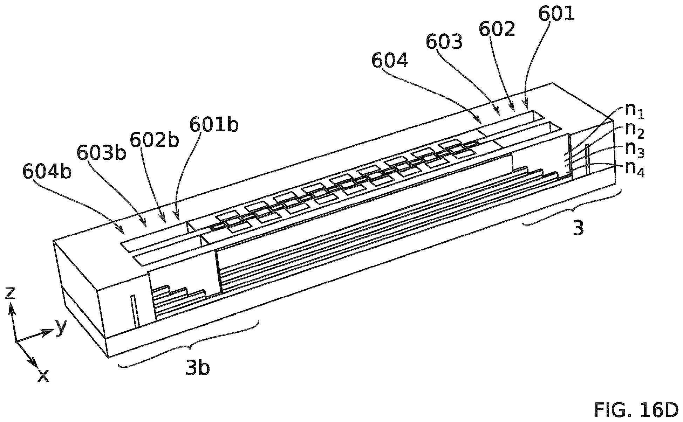

Une troisième lithographie peut ensuite permettre de définir une troisième ligne 603 de motifs de contacts, tout en gardant les première et deuxième lignes 601, 602 exposées. Une troisième gravure similaire aux première et deuxième gravures est effectuée. Cela permet d'atteindre et graver simultanément le premier niveau n₁ de source au niveau de la troisième ligne 603, le deuxième niveau n₂ de source au niveau de la deuxième ligne 602 et le troisième niveau n₃ de source au niveau de la première ligne 601 (figure 16D).

n₄, Dans l'exemple illustré ici comprenant 4 niveaux de sources n₁, n₂, n₃, une quatrième et dernière lithographie/gravure permet d'atteindre et d'exposer le premier niveau n₁ de source au niveau d'une quatrième ligne 604 (figure 16D).

Les 4 niveaux de sources n₁, n₂, n₃, n₄ sont ainsi respectivement exposés en escalier au niveau des lignes 604, 603, 602, 601. Cela permet de former ensuite des contacts en escalier permettant de connecter indépendamment les différents niveaux de sources.

Les niveaux de sources n₁, n₂, n₃, n₄ peuvent être exposés via les lignes 604, 603, 602, 601 dans la zone sourceline 3, et éventuellement via des lignes 604b, 603b, 602b, 601b dans une autre zone sourceline 3b tel qu'illustré sur les figures 16B à 16D.

Selon une possibilité, la réduction de cote de la résine utilisée lors de la lithographie/gravure, classiquement appelée « trimming », peut avantageusement être mise à profit pour réduire le nombre d'étapes de lithographie.

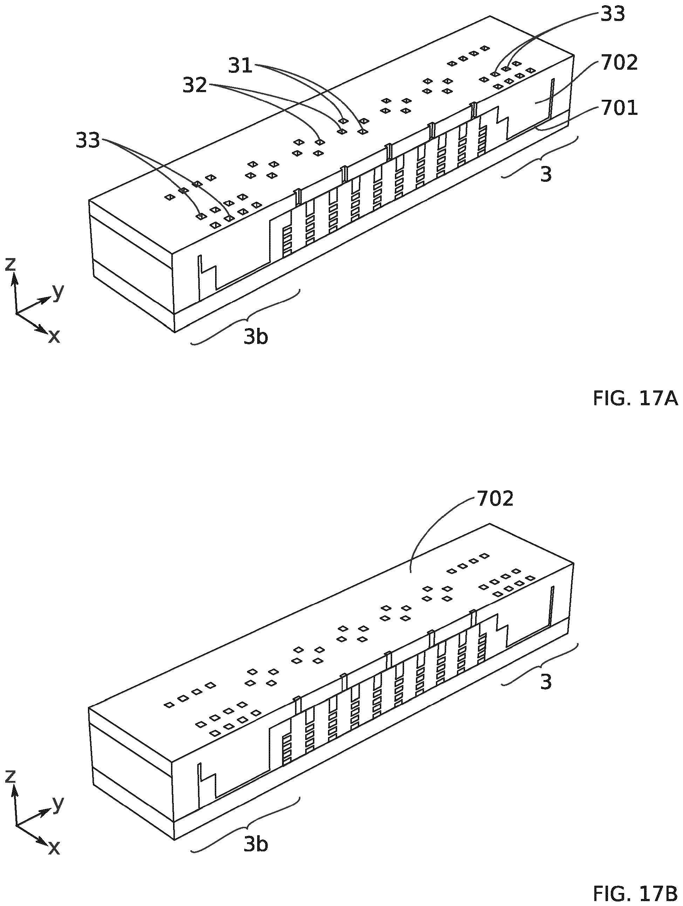

Après avoir gravé les différentes couches de Si/SiN pour accéder aux niveaux de sources, une couche de nitrure 701 d'épaisseur comprise entre 5nm et 20nm, par exemple environ 10nm est déposée dans les zones sourceline 3, 3b. Une couche d'oxyde 702 SiO2 épaisse est ensuite déposée sur l'ensemble de la structure et planarisée par CMP, tel qu'illustré à la figure 17A.

Les trous de contacts 31, 32, 33 sont ensuite formés par lithographie/gravure au travers de la couche d'oxyde 702 (figure 17A). Les trous de contact 31 sont dédiés à la connexion des wordlines avec les grilles des transistors de sélection. Les trous de contact 32 sont dédiés à la connexion des bitlines avec les points mémoire. Les trous de contact 33 sont dédiés à la connexion des sourcelines avec les sources des transistors de sélection.

La couche de nitrure 701 sert de couche d'arrêt pour la gravure des trous de contacts 33 dans les zones sourceline 3, 3b. Les couches de tungstène des grilles fonctionnelles et des points mémoire servent de couche d'arrêt pour la gravure des trous de contacts 31, 32. La couche de nitrure 701 est ensuite gravée au niveau des trous de contacts 33 pour exposer le silicium des sources.

Les contacts sont alors formés en remplissant les trous de contact 31, 32, 33 par dépôts successifs de TiN d'épaisseur environ 7nm et de tungstène W d'épaisseur environ 200 nm. Une planarisation par CMP avec arrêt sur la couche d'oxyde 702 permet d'obtenir une matrice 3D de cellules mémoire intégrable, telle qu'illustrée à la figure 17B.

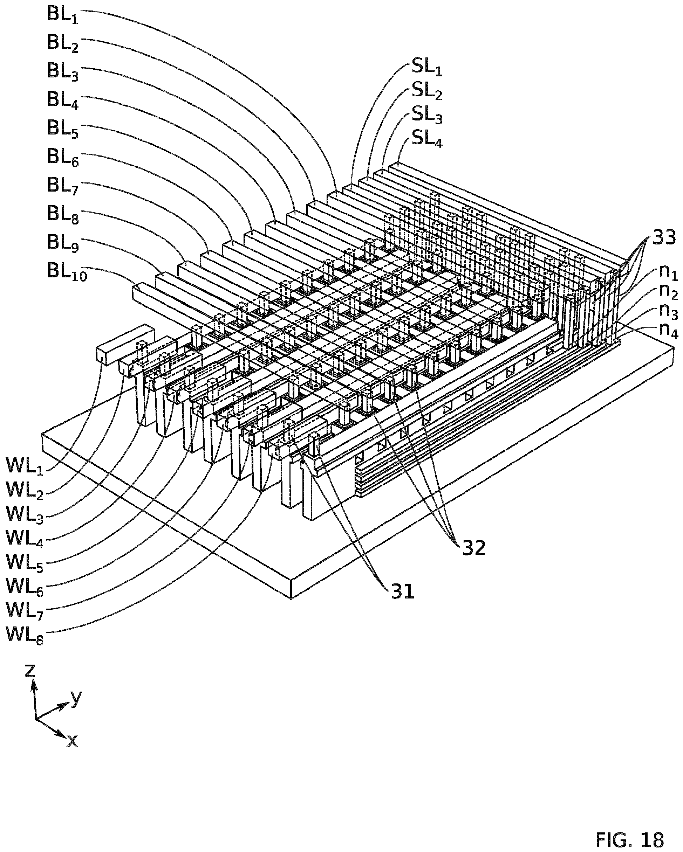

La figure 18 montre une telle matrice 3D de cellules mémoire sans la couche 702, pour plus de clarté. Les lignes de contact sourceline SL1, SL2, SL3, SL4, wordlines WL₁, WL₂, WL₃, WL₄, WL₅, WL₆, WL₇, WL₈ et bitline BL₁, BL₂, BL₃, BL₄, BL₅, BL₆, BL₇, BL₈, BLg, BL₁₀ sont également visibles en transparence sur cette figure 18. Les contacts 31, 33 illustrés ici correspondent à une autre possibilité d'intégration de la matrice 3D, légèrement différente de celle illustrée par les figures 17A, 17B. De façon évidente, ces contacts peuvent être définis selon différents plans organisationnels, en fonction des contraintes d'intégration.

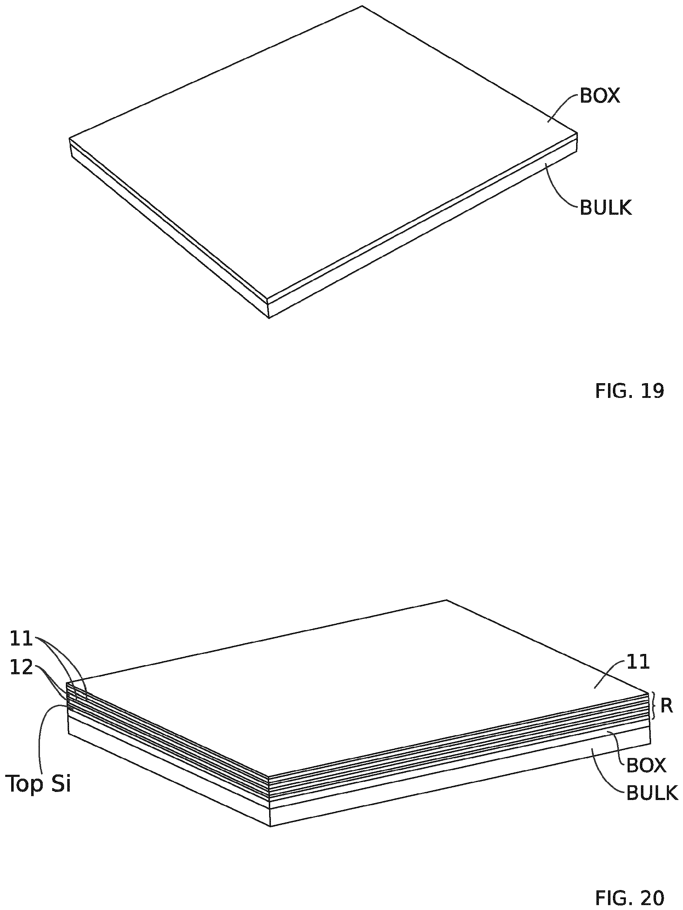

Un deuxième exemple de réalisation d'une mémoire résistive de type OxRAM va maintenant être décrit en référence aux figures 19 à 57 dans la section suivante. Seules les caractéristiques distinctes du premier exemple de réalisation sont décrites en détail ci-après, les autres caractéristiques non décrites ou partiellement décrites étant réputées sensiblement identiques à celles du premier exemple de réalisation.

### Exemple 2

Dans cet exemple, certaines étapes de fabrication sont interverties par rapport à l'enchaînement d'étapes du premier exemple de réalisation. Cela permet de diminuer le nombre d'étapes total. Cela permet également de simplifier la réalisation technique de certaines parties de la mémoire 3D.

Comme précédemment, sur un substrat SOI comprenant un support en silicium noté BULK, une couche mince d'oxyde SiO₂ notée BOX, et une couche mince de Si notée topSi, des couches minces en SiGe 11 et en Si 12 sont alternativement formées par épitaxie.

La figure 19 illustre uniquement le BULK et le BOX du substrat SOI.

La figure 20 illustre le super réseau Si/SiGe noté R comprenant le topSi et les couches SiGe 11 et Si 12 alternées.

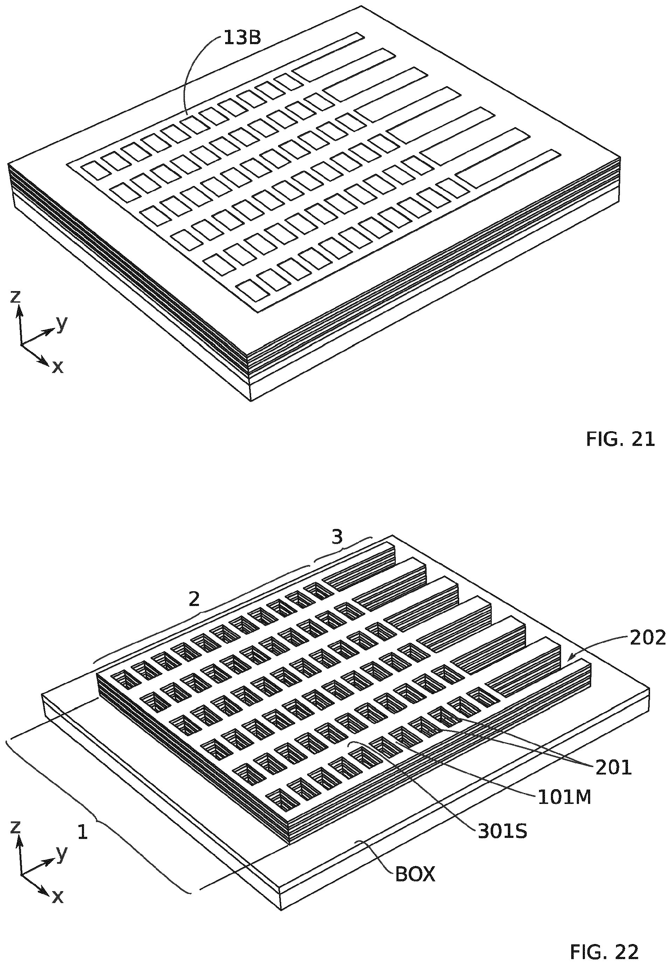

La figure 21 illustre une étape de lithographie visant à définir les différentes zones sourcelines, wordlines, bitlines par un premier masque 13B.

La figure 22 illustre la gravure anisotrope selon Z de l'empilement E avec arrêt sur le BOX. Elle peut être effectuée comme précédemment par plasma en utilisant une chimie de gravure HBr/O₂.

Elle permet de définir les motifs de transistors 101M, les motifs de sources 301S et les ouvertures 201, 202. Les ouvertures 202 dans la zone sourcelines 3 sont significativement plus larges que les ouvertures 201 de la matrice définie par les zones wordlines 1 et bitlines 2. Cela permet de réserver des emplacements suffisamment larges pour la formation des contacts de sourcelines, en particulier pour les contacts sourcelines en escalier.

### Formation des contacts

Dans cet exemple, la formation des contacts en escalier est effectuée préalablement aux autres étapes.

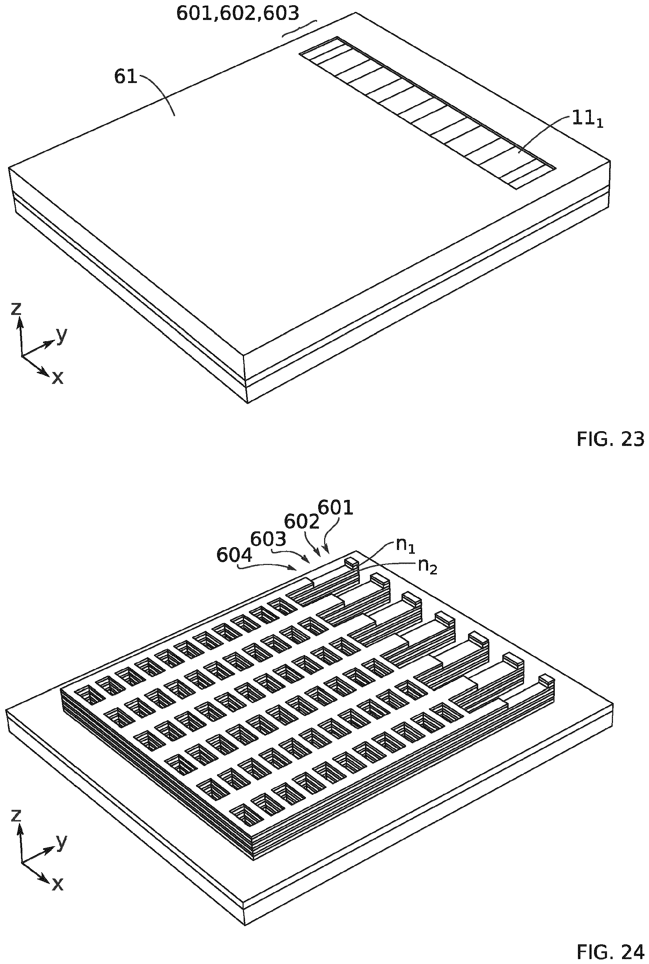

La figure 23 illustre une étape de lithographie visant à former des contacts dans la zone sourceline 3 de la matrice 3D. Les contacts à former dans la zone sourceline 3 sont de préférence des contacts en escalier. Une séquence d'étapes de lithographie/gravure permet alors, de façon connue, de former de tels contacts en escalier, sur chacun des niveaux de source. Typiquement, un dépôt de résine 61 est d'abord effectué de manière à couvrir l'ensemble des zones sourceline 3, wordlines 1 et bitlines 2 structurées précédemment. Cela permet de protéger les zones en dehors de la zone d'intérêt pour la formation des contacts en escalier. Une première ouverture dans la zone sourceline 3 permettant d'exposer la couche SiGe 11₁ relative au niveau n₁, au niveau des lignes 601, 602, 603 de motifs de contacts, est définie par lithographie (figure 23).

Une première gravure configurée pour atteindre et graver le premier niveau n1 de Si est alors effectuée (figure 24).

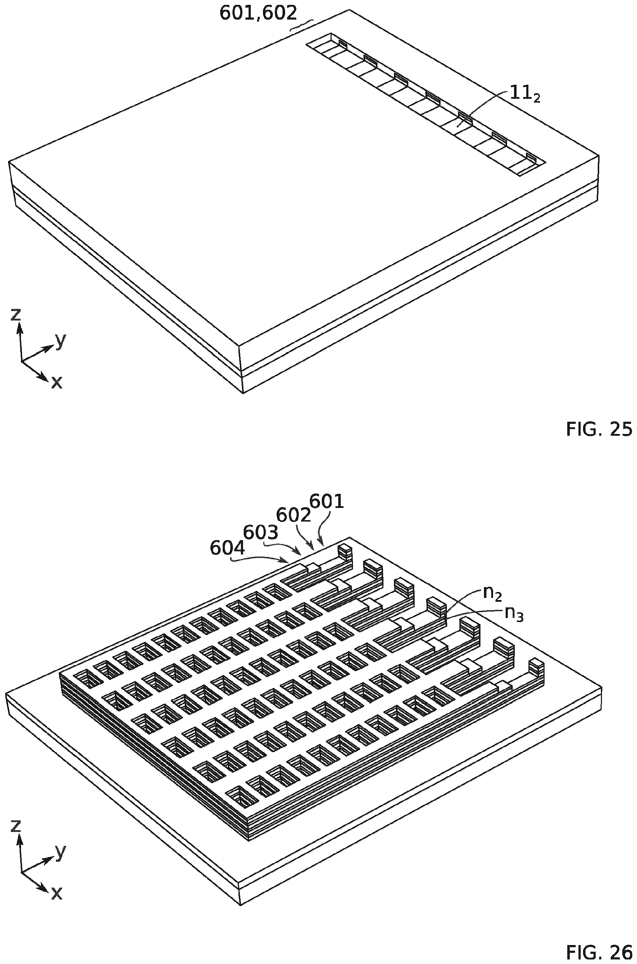

Une deuxième lithographie (figue 25) peut ensuite définir une deuxième ouverture permettant d'exposer la couche SiGe 11₂ relative au niveau n₂, au niveau des lignes 601, 602, de motifs de contacts. Une deuxième gravure similaire à la première gravure est effectuée. Cela permet d'atteindre et graver le deuxième niveau n₂ de Si au niveau des lignes 601, 602 (figure 26).

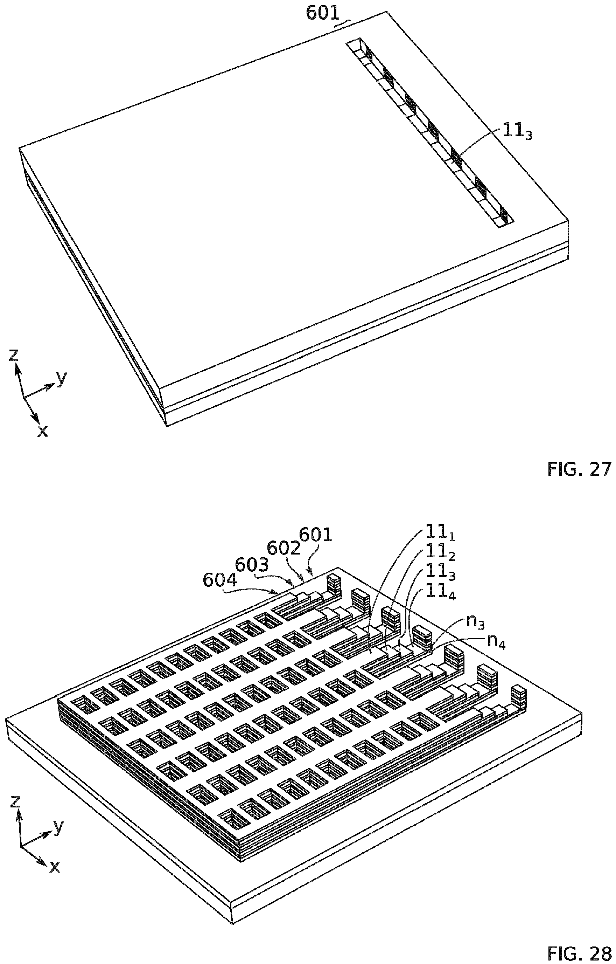

Une troisième lithographie (figue 27) peut ensuite définir une troisième ouverture permettant d'exposer la couche SiGe 11₃ relative au niveau n₃, au niveau de la ligne 601, de motifs de contacts. Une troisième gravure similaire aux première et deuxième gravures est effectuée. Cela permet d'atteindre et graver le troisième niveau n₃ de Si au niveau de la ligne 601 (figure 28).

Dans l'exemple illustré ici comprenant 4 niveaux de Si n₁, n₂, n₃, n₄, les couches SiGe 11₁, 11₂, 11₃, 11₄ sont exposées en escalier respectivement au niveau des lignes 604, 603, 602, 601 de la zone sourcelines 3 (figure 28). Une étape de lithographie/gravure est avantageusement supprimée dans ce deuxième exemple de réalisation, par rapport au premier exemple de réalisation.

La résine 61 n'est pas nécessairement entièrement retirée et/ou redéposée entre chaque lithographie/gravure.

### Formation des grilles sacrificielles

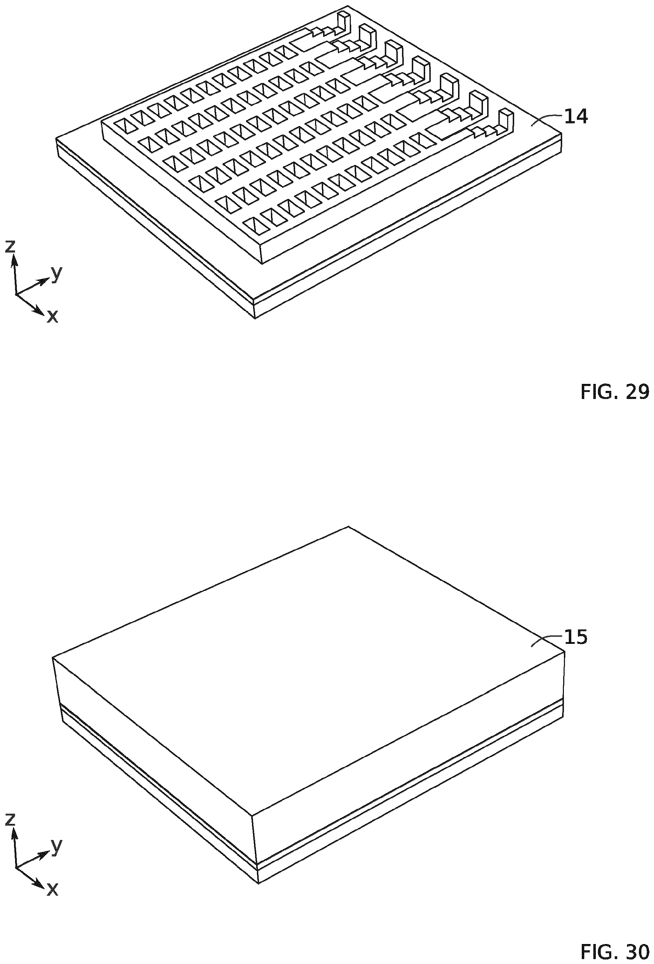

Les figures 29 à 33 illustrent des étapes de formation des grilles sacrificielles.

Les figures 29 et 30 illustrent respectivement des étapes de dépôt d'une couche 14 d'oxyde de silicium SiO₂ et d'une couche 15 de silicium polycristallin (polySi). L'épaisseur de SiO₂ déposé peut typiquement être de quelques nanomètres, par exemple 7 nm. Le polySi est déposé de façon à remplir les ouvertures 201, 202. L'épaisseur de polySi déposé peut typiquement être de quelques centaines de nanomètres, par exemple 380 nm. Ces dépôts successifs forment un empilement SiO₂/polySi s'apparentant à un empilement de grille classique. La structuration de cet empilement permet de former les grilles sacrificielles.

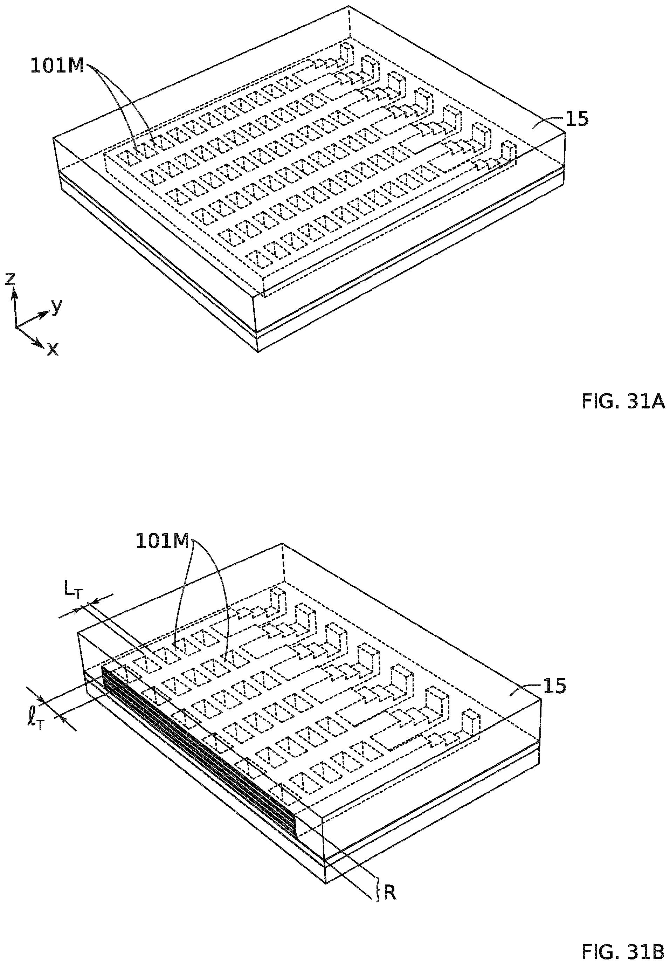

La figure 31A illustre une étape de planarisation du polySi 15, typiquement par polissage mécano-chimique CMP. Cette CMP peut être arrêtée au temps, par exemple au bout de quelques dizaines de secondes. Les motifs 101M, 301S des zones wordlines et bitlines, ainsi que les contacts structurés en escalier de la zone sourcelines sont visibles par transparence au travers de la couche polySi planarisée 15.

La figure 31B est une vue en coupe transverse selon XZ au travers des motifs 101M, de la structure obtenue à l'issue de l'étape illustrée à la figure 31A. Les motifs 101M de longueur ℓ_{T} et de largeur LT, formés dans le super-réseau R, sont visibles sur cette figure 31B.

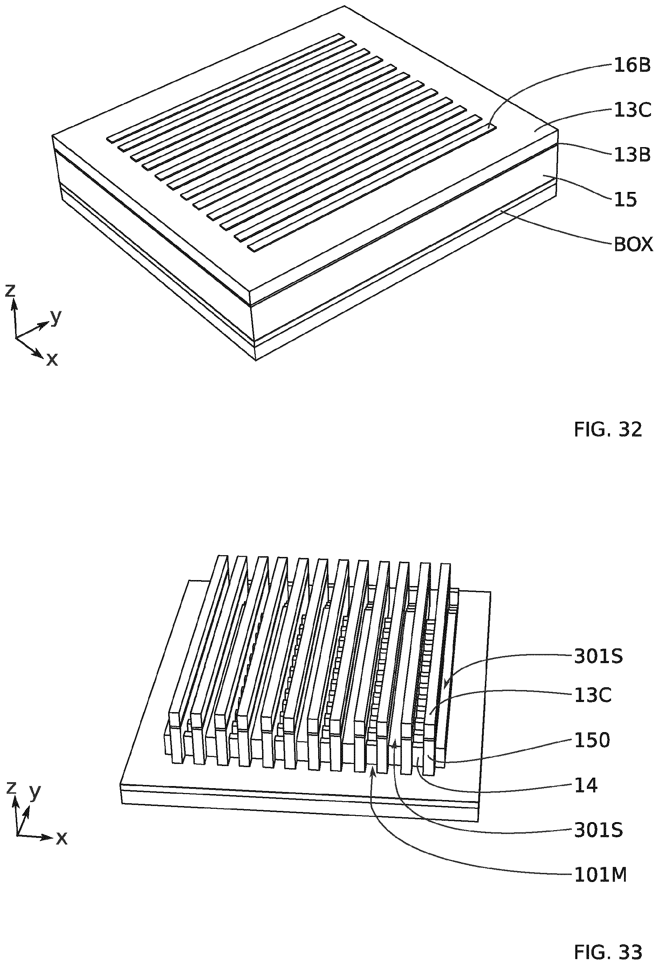

La figure 32 illustre une étape de lithographie visant à définir les grilles sacrificielles via un deuxième masque 16B.

Préalablement, une couche de nitrure 13B et une couche d'oxyde SiO₂ 13C sont successivement déposées sur la couche polySi 15 planarisée.

La figure 33 illustre la gravure anisotrope selon Z de l'oxyde 13C, du nitrure 13B et du polySi 15. La couche 14 de TEOS et l'oxyde enterré (BOX) servent avantageusement de couche d'arrêt lors de la gravure du Poly-Si. Les grilles sacrificielles 150 sont ainsi formées à cheval sur les portions périphériques des motifs de transistors 101M. Elles s'étendent principalement selon Y et bordent selon X les motifs de sources 301S, comme précédemment.

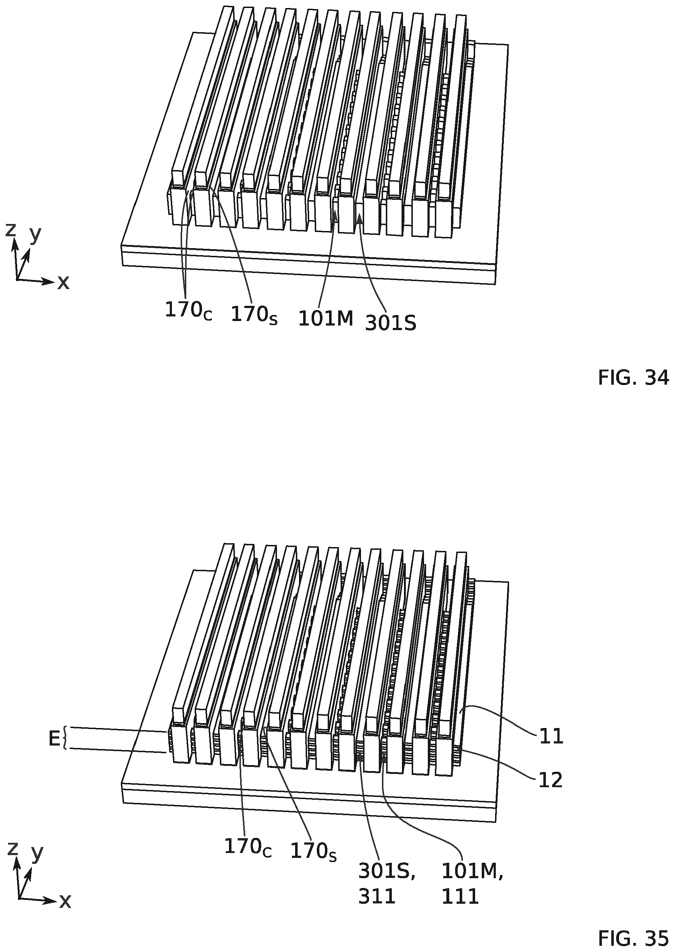

La figure 34 illustre la formation d'espaceurs 170_{c}, 170ₛ de part et d'autres des grilles sacrificielles 150. Ces espaceurs sont typiquement formés à partir d'un dépôt d'une couche de SiN conforme suivi d'une gravure anisotrope de cette couche de SiN, comme précédemment. Les motifs de sources 301S sont ainsi en partie couverts par les espaceurs 170ₛ. Les motifs de transistors 101M sont ainsi en partie couverts par les espaceurs 170_{c}.

La figure 35 illustre le retrait des parties exposées de la couche 14 d'oxyde TEOS, après formation des espaceurs 170_{c}, 170ₛ. Ce retrait permet d'exposer une portion centrale 111 des motifs de transistors 101M, entre les espaceurs 170_{c}, et une portion centrale 311 des motifs de sources 301S entre les espaceurs 170ₛ.

Les portions centrales 111 et 311 sont ensuite gravées de façon anisotrope selon Z, jusqu'au BOX, comme illustré à la figure 36. Cela permet de structurer l'empilement Si/SiGe sous forme de peigne.

Des portions périphériques 312 des motifs de sources 301S sont conservées à l'issue de cette gravure, sous les espaceurs 170ₛ. Ces portions périphériques 312 sont continues le long de l'axe Y. Elles forment le corps du peigne. Un premier côté de ces portions périphériques 312 débouche sur les ouvertures 401. Un deuxième côté de ces portions périphériques 312 est attaché aux grilles sacrificielles 150. Préférentiellement, les couches Si de ces portions périphériques 312 formeront ultérieurement les sources des transistors.

Des portions périphériques 112 des motifs de transistors 101M sont également conservées à l'issue de cette gravure, sous les grilles sacrificielles 150 et les espaceurs 170_{c}. Ces portions périphériques 112 s'étendent selon X et débouchent sur les ouvertures 301c. Les portions périphériques 112 forment les dents du peigne. Elles sont reliées entre elles par les portions périphériques 312. Préférentiellement, les couches Si de ces portions périphériques 112 formeront ultérieurement les canaux et les drains des transistors.

### Isolation des sources

Comme précédemment, afin de pouvoir adresser indépendamment chacun des transistors de la matrice 3D, il est nécessaire d'isoler entre elles les couches de Si des différents niveaux n₁, n₂, n₃, n₄. Les couches SiGe sont donc de préférence retirées et remplacées par des couches électriquement isolantes.

Comme illustré à la figure 37, les sources 1002 des transistors correspondent aux couches Si des portions périphériques 312 des motifs de sources 301S. Pour isoler ces sources 1002 entre elles, des portions des couches SiGe de l'empilement sont gravées à partir des ouvertures 401, 301c, comme précédemment.

La gravure est configurée de manière à ce que les couches SiGe des portions périphériques 312 soient gravées au travers des ouvertures 401. L'arrêt du front de gravure peut être contrôlé au temps, de préférence sensiblement à l'aplomb des grilles sacrificielles 150. Les sources 1002 sont dès lors suspendues.

La gravure des couches SiGe s'effectue de préférence également au travers des ouvertures 301c. La gravure sélective des couches SiGe se fait ainsi de part et d'autre de l'empilement, au niveau des motifs de transistors, tel qu'illustré à la figure 37. Des parties 1006 des couches Si des portions périphériques 112b des motifs de transistors 101M sont dès lors suspendues. Ces parties 1006 se présentent sous forme de fils et correspondent sensiblement aux drains des transistors.

La gravure est de préférence arrêtée avant que les couches SiGe soient totalement retirées. Des portions 1003 de SiGe sont ainsi conservées entre les couches Si des portions périphériques 112a des motifs de transistors 101M. Cela permet à la fois de définir les canaux 1001 et/ou les drains 1006 en Si, et d'éviter un risque d'effondrement des couches Si. Ces portions 1003 sont par la suite retirées de façon à former les grilles enrobantes des transistors GAA.

Les grilles sacrificielles en Poly-Si permettent notamment de maintenir les couches Si lors de la gravure SiGe. Elles forment une structure de piliers d'accroché pour les couches Si.

La figure 38 illustre la formation de bouchons 1004 diélectriques, par exemple en SiN, au niveau des cavités formées par le retrait du SiGe, comme précédemment. Les sources 1002 sont ainsi isolées électriquement entre elles. Les drains 1006 sont également isolés électriquement entre eux.

Une couche d'oxyde 180 est ensuite déposée de façon à remplir les ouvertures 401, 301c (figure 38). Cette couche d'oxyde 180 est ensuite planarisée par CMP avec arrêt sur les parties 13B de masque dur en SiN, comme illustré à la figure 39.

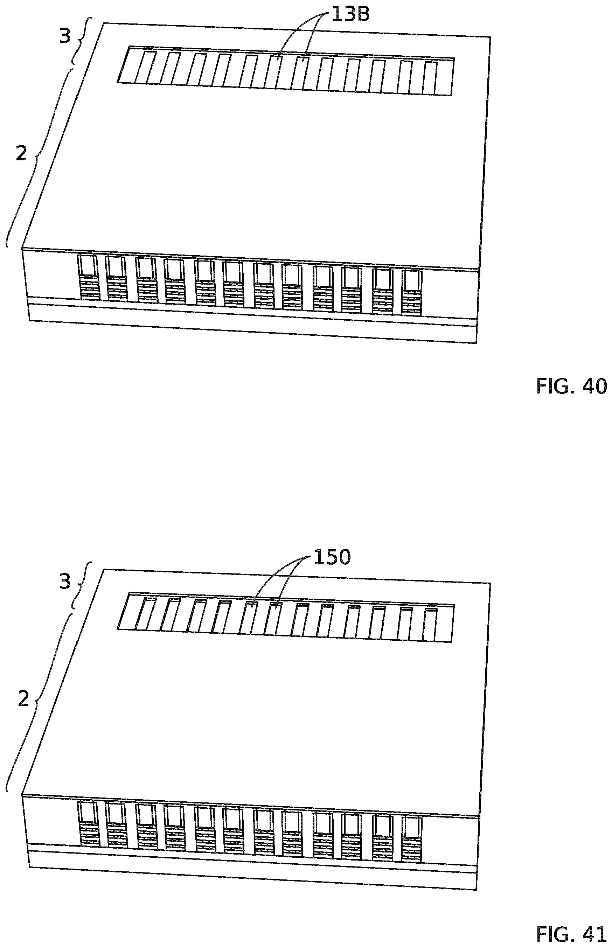

Une étape de lithographie est effectuée de façon à protéger la zone bitlines 2 et à exposer la zone sourcelines 3 (figure 40). Le masque dur 13B est retiré dans cette zone sourcelines 3, de façon à exposer les grilles sacrificielles 150 au niveau de la zone sourcelines 3 (figure 41).

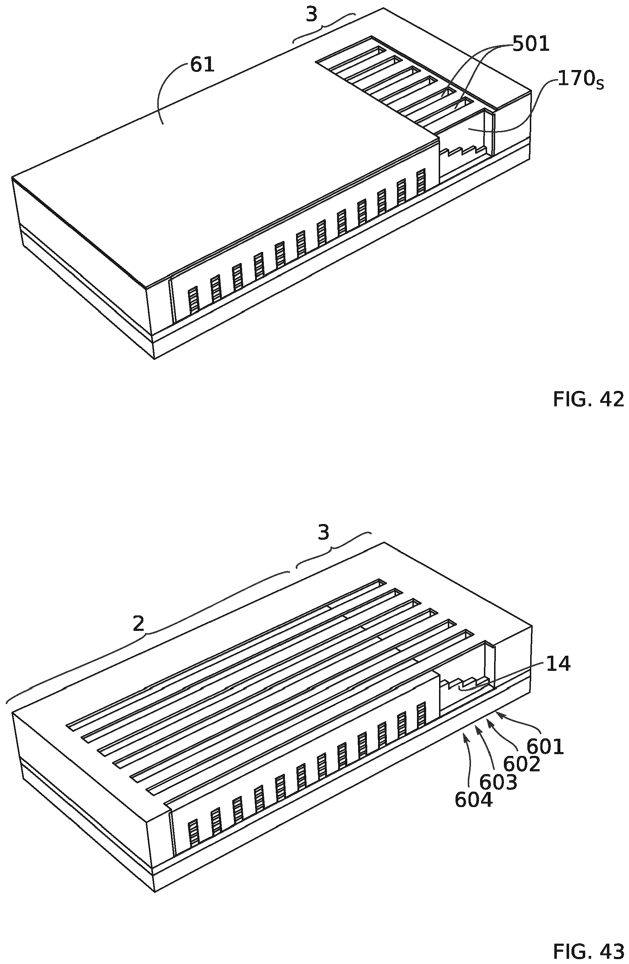

Les grilles sacrificielles 150 de la zone sourceline 3 sont ensuite retirées, tel qu'illustré à la figure 42. Le polySi des grilles sacrificielles peut être gravé à l'aide d'une solution TMAH ou TEAH, ou par gravure plasma anisotrope, par exemple à base de chimies CH₂F₂/SF₆/N₂/He et HBr/O₂/He, comme précédemment. Dans l'exemple illustré à la figure 42, le retrait des grilles sacrificielles 150 forme des ouvertures 501. Ces ouvertures 501 débouchent sur les contacts en escalier reliés aux sources 1002 (non visibles). Les ouvertures 501 sont bordées par les espaceurs 170_{c}, 170ₛ.

La résine 61 est ensuite retirée de façon à exposer la zone bitlines 2. Le nitrure du masque dur 13B dans la zone bitlines 2 et des espaceurs 170_{c}, 170ₛ dans la zone sourceline 3 est ensuite gravé, comme illustré à la figure 43. Cela permet de dégager les sources 1002 structurées en escalier et recouvertes de l'oxyde 14 dans la zone sourcelines 2. Les lignes 604, 603, 602, 601 de motifs de contacts, correspondant chacune à une marche des contacts en escalier, sont également représentées à la figure 43.

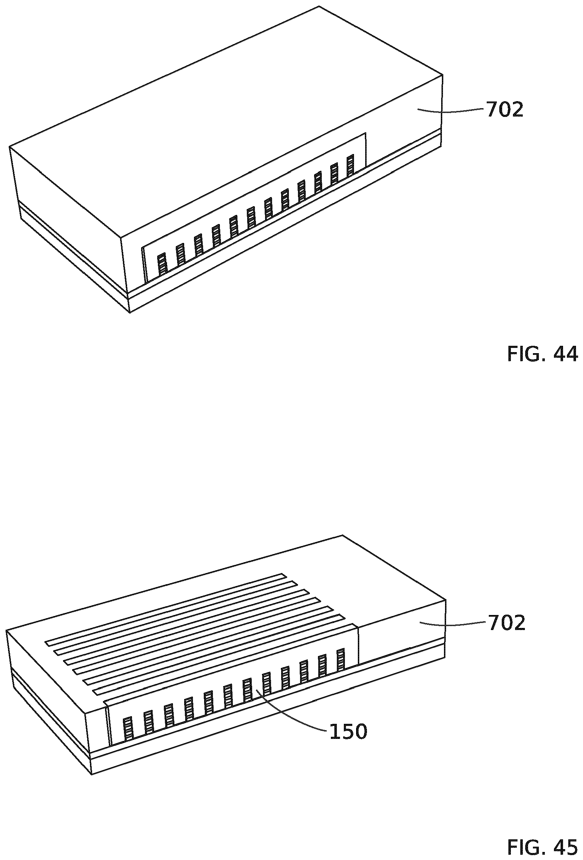

Une couche d'oxyde 702 SiO₂ épaisse est ensuite déposée sur l'ensemble de la structure (figure 44) et planarisée par CMP avec arrêt sur les sommets des grilles sacrificielles 150 (figure 45).

### Structuration de la zone wordlines

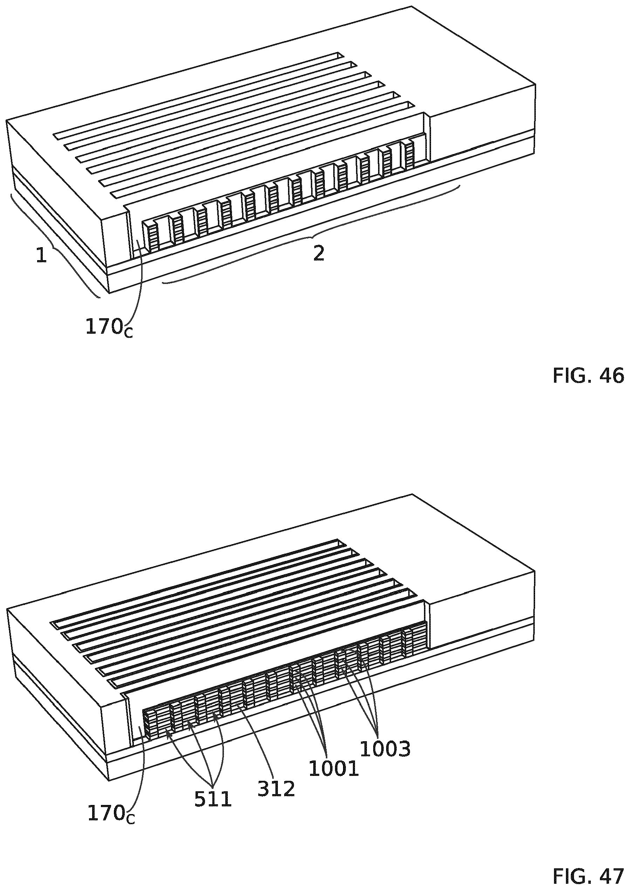

Les figures 46 et 47 illustrent le retrait des grilles sacrificielles 150 de la zone wordlines 1, comme précédemment. Le polySi (figure 46) puis le TEOS (figure 47) sont successivement retirés.

Dans l'exemple illustré à la figure 47, le retrait des grilles sacrificielles 150 forme des ouvertures 511. Ces ouvertures 511 sont bordées selon XZ par des empilements formés par les canaux Si 1001 et les portions SiGe 1003. Ces ouvertures 511 sont bordées selon YZ par les portions périphériques 312 comprenant l'empilement des sources 1002 isolées entre elles, et par les espaceurs 170_{c} (non visible) en regard desdites portions périphériques 312.

La figure 48 illustre la gravure sélective des portions 1003 de SiGe, comme précédemment. Cette gravure permet de graver le SiGe tout en préservant les canaux 1001 sous forme de nanofils Si et les parties des sources 1002 exposées au niveau des portions périphériques 312. A l'issue de la gravure, les canaux 1001 des transistors en Si sont suspendus entre les ouvertures 511 d'une même wordline WLₓ.

La figure 49 illustre la formation des grilles fonctionnelles à la place des grilles sacrificielles. Des dépôts successifs de matériaux utilisés pour la formation de grilles fonctionnelles permettent de former les grilles fonctionnelles 250 autour de chaque canal 1001, comme précédemment. Ces grilles fonctionnelles peuvent être formées à partir d'un dépôt de matériau à haute constante diélectrique dit high-k, par exemple HfO₂ sur une épaisseur de 2nm, suivi d'un dépôt de TiN sur une épaisseur de 3nm, suivi d'un dépôt de tungstène W visant à remplir les ouvertures 511 et les wordlines WLₓ délimitées par l'oxyde TEOS 180. Une planarisation par CMP avec arrêt sur l'oxyde TEOS 180 permet au besoin d'enlever les couches métalliques excédentaires. Les wordlines WLₓ sont ainsi définies. Les transistors de la matrice 3D sont des transistors MOS à grille enrobante (Gate-All-Around) à base de nanofils Si empilés.

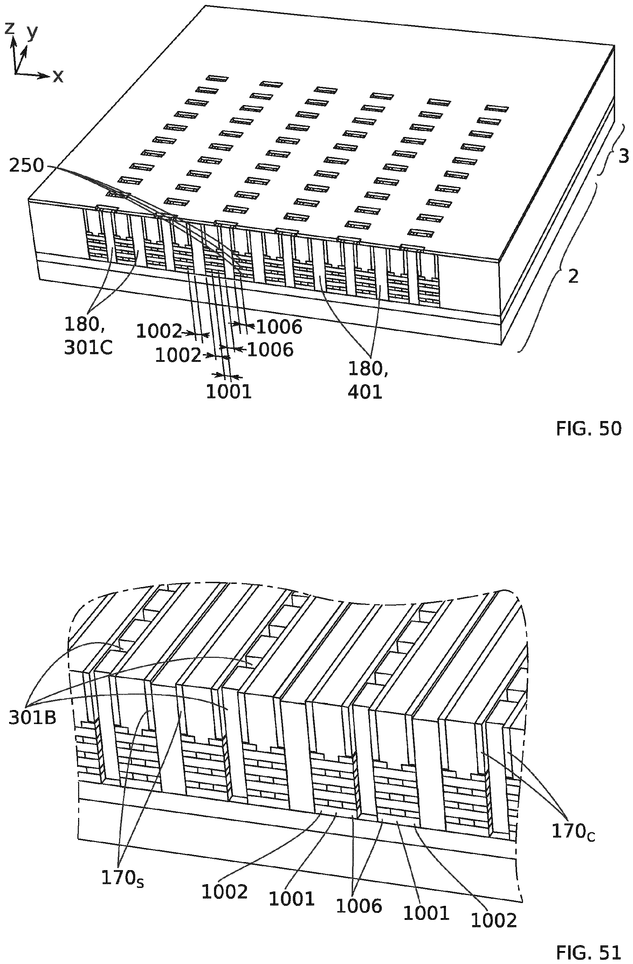

La figure 50 permet de distinguer en coupe selon XZ les sources 1002 des transistors, les canaux 1001 entourés par les grilles enrobantes 250, et des parties de nanofil formant les drains 1006 des transistors. Les sources 1002 s'étendent selon Y jusque dans la zone sourceline 3. Les drains 1006 s'étendent selon X jusqu'aux zones d'ouvertures 301c remplies d'oxyde 180.

### Structuration de la zone bitlines

L'étape suivante consiste à enlever en partie l'oxyde 180 des zones d'ouvertures 301c, de façon à accéder aux drains 1006 des transistors dans la zone bitlines 2.

La figure 50 illustre une étape de lithographie préalable à la gravure de l'oxyde 180 au niveau des zones d'ouvertures 301c. La gravure sélective de l'oxyde 180 permet de former des ouvertures 301B exposant une extrémité des drains 1006 en Si, tel qu'illustré à la figure 51.

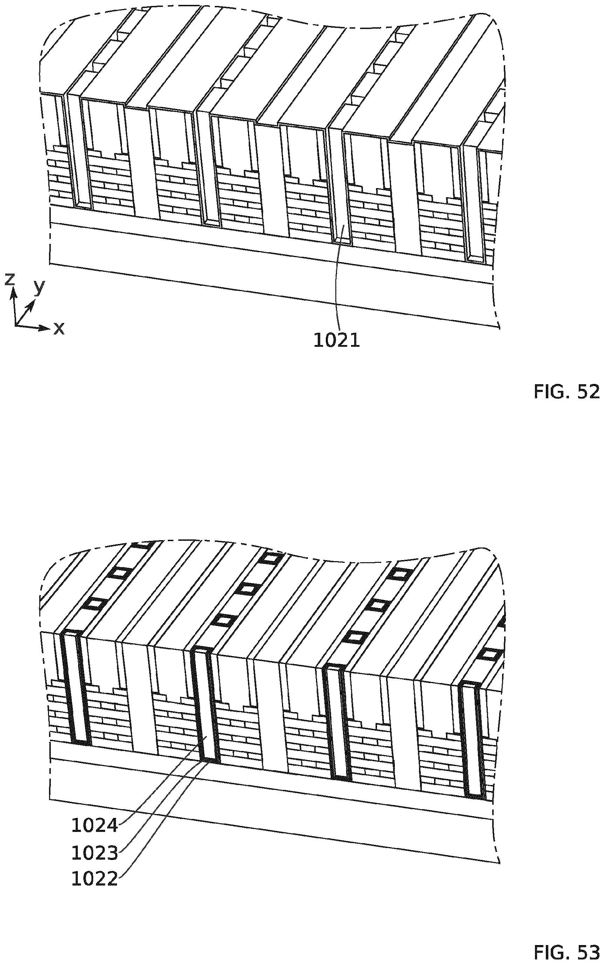

Ces ouvertures 301B sont remplies par dépôts successifs de façon à former les points mémoire, tel qu'illustré aux figures 52 et 53. Les points mémoire ainsi formés sont directement au contact des drains 1006 des transistors de sélection. Les drains 1006 peuvent être préalablement siliciurés. Dans le cas d'une mémoire résistive de type OxRAM, ces points mémoire peuvent être à base de HfO₂. Par exemple, ces points mémoire peuvent être réalisés par dépôt d'une couche HfO₂ 1021 d'épaisseur 5nm, suivi d'un dépôt d'une couche de Ti 1022 d'épaisseur 5nm, suivi d'un dépôt d'une couche de TiN 1023 d'épaisseur supérieure à 5nm suivi d'un dépôt d'une couche de W 1024 d'épaisseur 300nm. La couche de W 1024 peut typiquement s'étendre en dehors des ouvertures 301c. Elle est alors planarisée par CMP avec arrêt sur la couche d'oxyde 180.

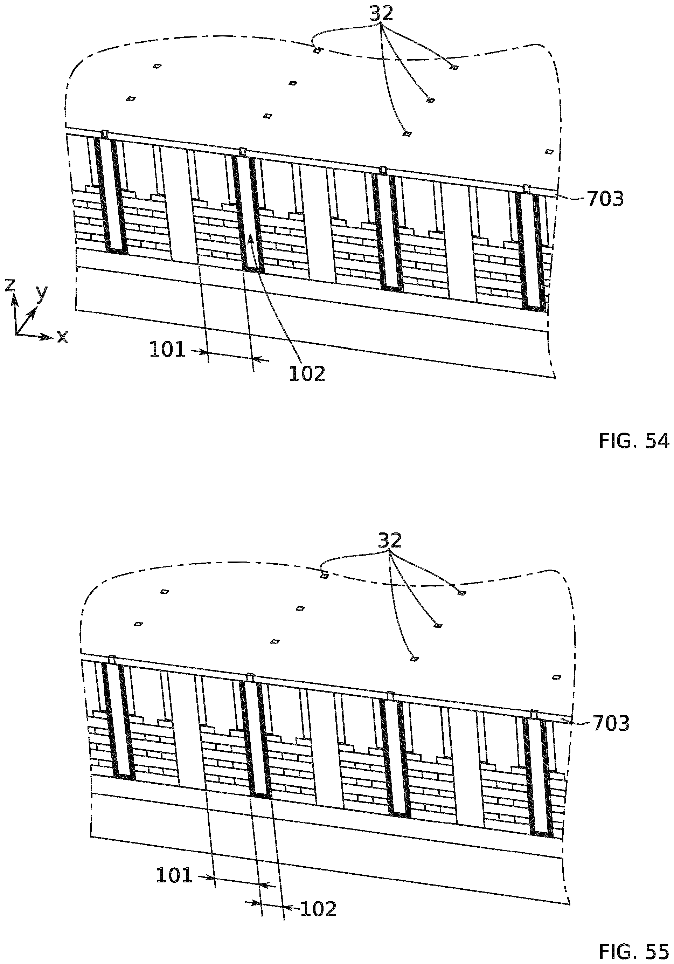

Une couche d'oxyde 703 est de préférence déposée sur la matrice 3D ainsi formée. Les trous de contacts 32 sont ensuite formés par lithographie/gravure au travers de la couche d'oxyde 703, tel qu'illustré aux figures 54 et 55. Les trous de contact 32 sont dédiés à la connexion des bitlines avec les points mémoire. Les trous de contact dédiés à la connexion des wordlines avec les grilles des transistors de sélection et les trous de contact 33 dédiés à la connexion des sourcelines avec les sources des transistors de sélection sont également formés par lithographie/gravure au travers des couche d'oxyde 703, 702.

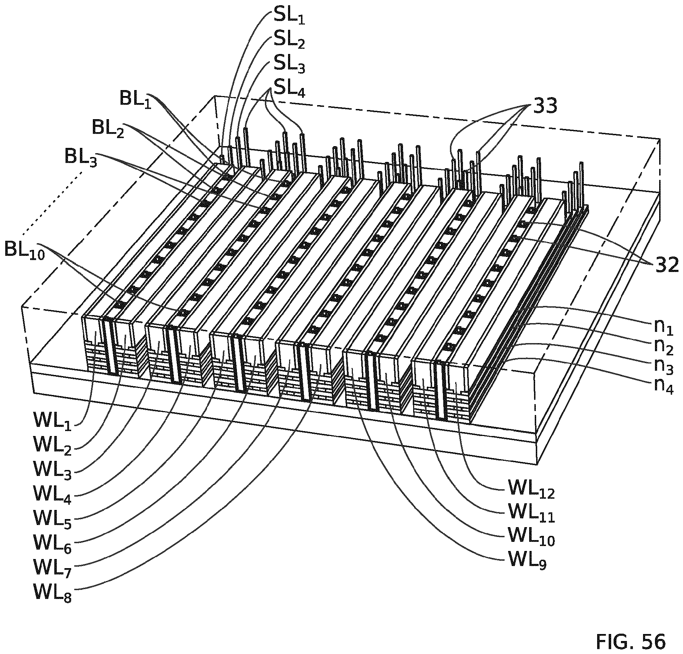

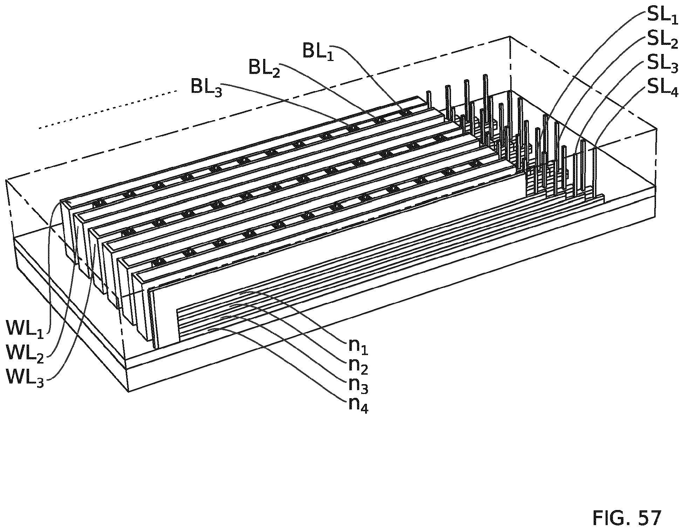

Les figures 56 et 57 présentent une mémoire résistive 3D obtenue par ce deuxième mode de réalisation, respectivement selon une coupe transverse selon XZ et selon une coupe longitudinale selon YZ.

Les lignes de contact sourceline SL1, SL2, SL3, SL4 connectant indépendamment chacun des niveaux n₁, n₂, n₃, n₄ de la matrice, les wordlines WL1, WL2, WL3, WL4, WL5, WL6, WL7, WL8, WL9, WL10, WL11, WL12 et les bitline BL1, BL2, BL3, BL4, BL5, BL6, BL7, BL8, BL9, BL10 sont visibles en transparence sur ces figures 56 et 57. Les contacts 32, 33 sont également illustrés sur ces figures 56 et 57.

La présente invention concerne également un dispositif microélectronique comprenant au moins deux transistors empilés selon z. Chacun de ces transistors comprend un canal sous forme de fil s'étendant principalement selon la première direction x, une grille entourant ledit canal, une source et un drain. Ainsi, la longueur de chaque canal s'étend selon la première direction x. Pour chaque transistor, le canal, la source et le drain s'étendent uniquement sur un niveau n_{z}, n_{z} = n₁...n₄, - d'altitude donnée selon la troisième direction z. Un niveau n_{z} d'altitude donnée correspond à une portion d'espace délimitée par deux plans P1n_{z}, P2n_{z} perpendiculaires à la troisième direction z et passant respectivement par une face supérieure 251n_{z} du canal du transistor associé au niveau n_{z}, et une face inférieure 252n_{z} du canal du transistor associé au niveau n_{z}. La source 1002, et le drain 1006 connectés audit canal sont entièrement contenus dans cette portion d'espace. Selon l'invention, deux niveaux n_{z} d'altitudes différents sont séparés l'un de l'autre par un espaceur dit horizontal, de préférence en un matériau diélectrique. On entend par deux niveaux n_{z} d'altitude donnée deux niveaux présentant deux altitudes différentes.

Un tel dispositif est avantageusement fabriqué par le procédé selon l'invention. L'utilisation de grilles sacrificielles et de couches sacrificielles permet notamment de former ces transistors sur différents niveaux n_{z}, n_{z} = n₁...n₄, et d'isoler ces différents niveaux n_{z} entre eux. En particulier, les bouchons formés dans le procédé de fabrication correspondent avantageusement aux espaceurs horizontaux du dispositif.

Des exemples de dispositifs sont décrits et illustrés dans la suite. Ces dispositifs comprennent de préférence au moins un espaceur horizontal 1004 séparant la source 1002 d'un niveau n_{z}, de la source 1002 d'un niveau n_{z-1} ou n_{z+1} adjacent à ce niveau n_{z}.

De même, ces dispositifs comprennent de préférence au moins un espaceur horizontal 1004 séparant le drain 1006 d'un niveau n_{z}, du drain 1006 d'un niveau n_{z-1} ou n_{z+1} adjacent à ce niveau n_{z}. Ainsi, la source 1002 et le drain 1006 d'un transistor occupant un niveau n_{z} sont localisés uniquement sur ce niveau n_{z}, entre des espaceurs horizontaux 1004. Typiquement, un premier espaceur horizontal sépare les niveaux n_{z} et n_{z-1} et un deuxième espaceur horizontal sépare les niveaux n_{z} et n_{z+1}. Ces premier et deuxième espaceurs horizontaux peuvent être distincts l'un de l'autre, au moins selon une section du dispositif prise selon le plan zx. Différents empilements de sources S et drains D peuvent être envisagés. Selon un exemple les sources S sont empilées selon z les unes au-dessus des autres et forment un empilement S/S/S/S/S/S. De même, les drains D peuvent être empilés selon z les uns au-dessus des autres de façon à former un empilement D/D/D/D/D/D. D'autres empilements alternant les sources et les drains peuvent également être envisagés, par exemple S/D/S/D/S/D ou S/D/D/S/S/D. Les sources et/ou les drains de différents niveaux n_{z} sont séparés les uns des autres par des espaceurs horizontaux.

Selon l'invention, une zone formant une source 1002 ou un drain 1006 ne s'étend pas sur plusieurs niveaux de transistors.

Ainsi, la source 1002 et/ou le drain 1006 associés au canal 1001 d'un niveau n_{z} d'altitude donnée sont disposés à distance d'une source et/ou d'un drain associés à un canal d'un niveau n_{z-1} ou n_{z+1} adjacent au niveau n_{z}.

Les figures 59A à 59C montrent un premier exemple de dispositif comprenant deux niveaux n₁, n₂ et quatre transistors répartis sur ces deux niveaux, par souci de clarté. Le nombre de niveaux illustrés n'est pas limitatif de l'invention. Trois, quatre niveaux ou plus, par exemple dix, sont parfaitement envisageables dans le cadre de l'invention.

Dans cet exemple, chaque niveau n₁, n₂ comprend une source 1002 s'étendant principalement selon y et un drain 1006 s'étendant principalement selon y (figure 59A). Les source et drain 1002, 1006 du niveau n₁ sont reliés entre eux par deux canaux 1001 sous forme de fils s'étendant selon x. Les source et drain 1002, 1006 du niveau n₂ sont également reliés entre eux par deux canaux 1001 sous forme de fils s'étendant selon x (figure 59B).

Les source et drain 1002, 1006 du niveau n₁ sont séparés des source et drain 1002, 1006 du niveau n₂ par des bouchons 1004, également dénommés espaceurs horizontaux. Ces espaceurs horizontaux sont par exemple en nitrure de silicium ou en dioxyde de silicium. Ils permettent d'isoler les source et drain 1002, 1006 d'un niveau n_{z} donné, par exemple n₁, par rapport aux niveaux inférieurs n_{z+1}, par exemple n₂, et/ou par rapport aux niveaux supérieurs n_{z-1}.

La grille enrobante 250 enrobe totalement les canaux 1001 et présente ici un premier côté 2501 en affleurement des sources 1002 et des espaceurs horizontaux 1004, et un deuxième côté 2502 en affleurement des drains 1006 et des espaceurs horizontaux 1004 (figure 59C). Selon une possibilité, un premier oxyde de grille fin peut s'intercaler entre les espaceurs horizontaux 1004 et le premier côté 2501 et/ou le deuxième côté 2502 (non illustré). Le premier côté 2501 de la grille enrobante 250 est de préférence directement au contact des sources 1002. Le deuxième côté 2502 de la grille enrobante 250 est de préférence directement au contact des drains 1006.

Selon un exemple illustré à la figure 60, la ou les source 1002 d'un niveau n_{z}, par exemple n₁, peuvent chacune présenter une longueur selon y, par exemple L1, différente des longueurs selon y, par exemple L2, de la ou des sources 1002 d'un autre niveau n_{z}, par exemple n₂. De façon similaire, le ou les drains 1006 d'un niveau n_{z}, par exemple n₁, peuvent chacun présenter une longueur selon y, par exemple L1, différente des longueurs selon y, par exemple L2, du ou des drains 1006 d'un autre niveau n_{z}, par exemple n₂. Cela permet de faciliter la reprise de contacts électriques sur différentes sources et/ou différents drains de différents niveaux. Cela permet par exemple de former des contacts en escaliers sur les différentes sources et/ou drains.

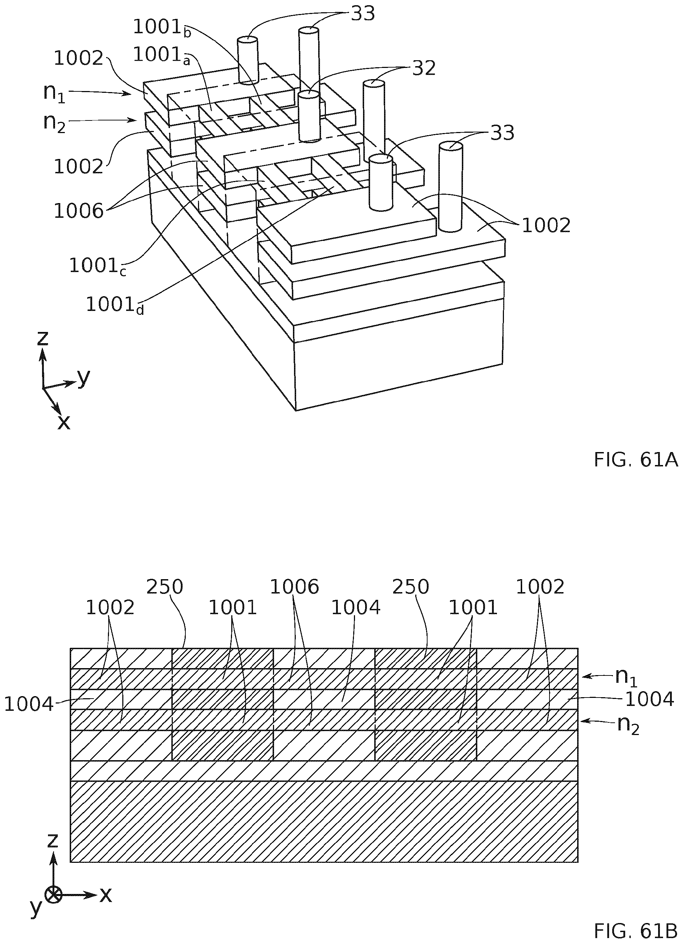

Selon un exemple illustré aux figures 61A, 61B, des contacts en escalier 33 sont formés au niveau d'une extrémité des sources 1002. Les sources 1002 peuvent être communes à plusieurs transistors d'un même niveau n_{z}.

Selon cet exemple, des contacts en escalier 32 sont formés au niveau d'une extrémité des drains 1006. Les drains 1006 peuvent être communs à plusieurs transistors d'un même niveau n_{z}. Dans cet exemple, le drain 1006 du niveau n₁ est relié à quatre canaux 1001a, 1001b, 1001c, 1001d appartenant respectivement à quatre transistors distincts du niveau n₁.

Cela permet de densifier le nombre de transistors sur un même niveau n_{z}.

Une matrice compacte de transistors GAA est ainsi avantageusement formée. La figure 61B illustre en coupe le système de la figure 61A. Les sources 1002 et drain 1006 du niveau n₁, sont isolés des sources 1002 et du drain 1006 du niveau n₂ par les espaceurs horizontaux 1004.

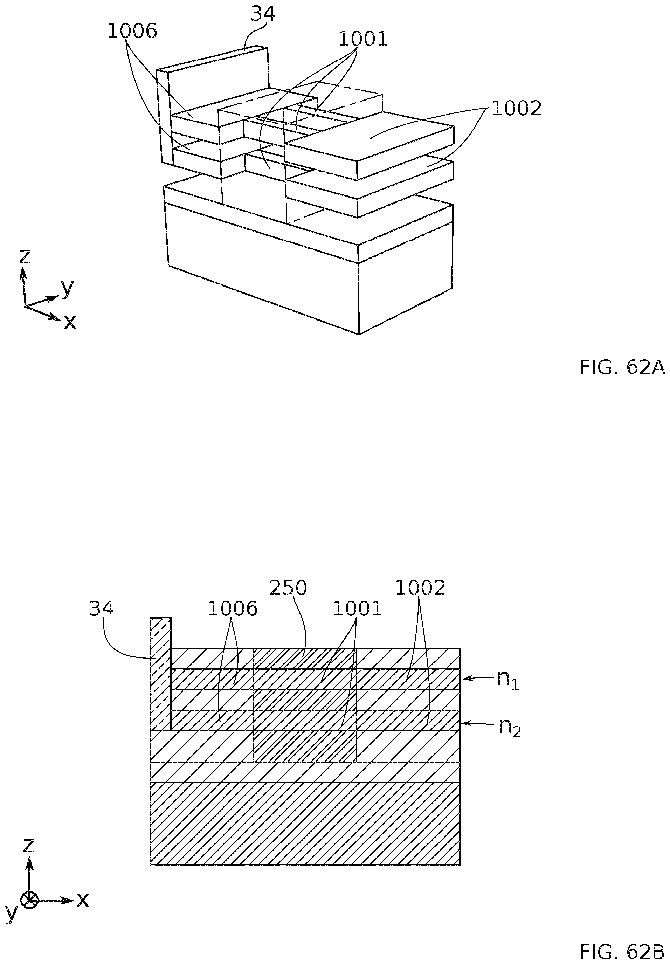

Selon un autre exemple illustré aux figures 62A et 62B, un contact 34 peut s'étendre sur un flanc des drains 1006 et/ou des sources 1002 (non illustré) de différents niveaux n_{z}, de façon à connecter électriquement en commun lesdits drains 1006 et/ou sources 1002.

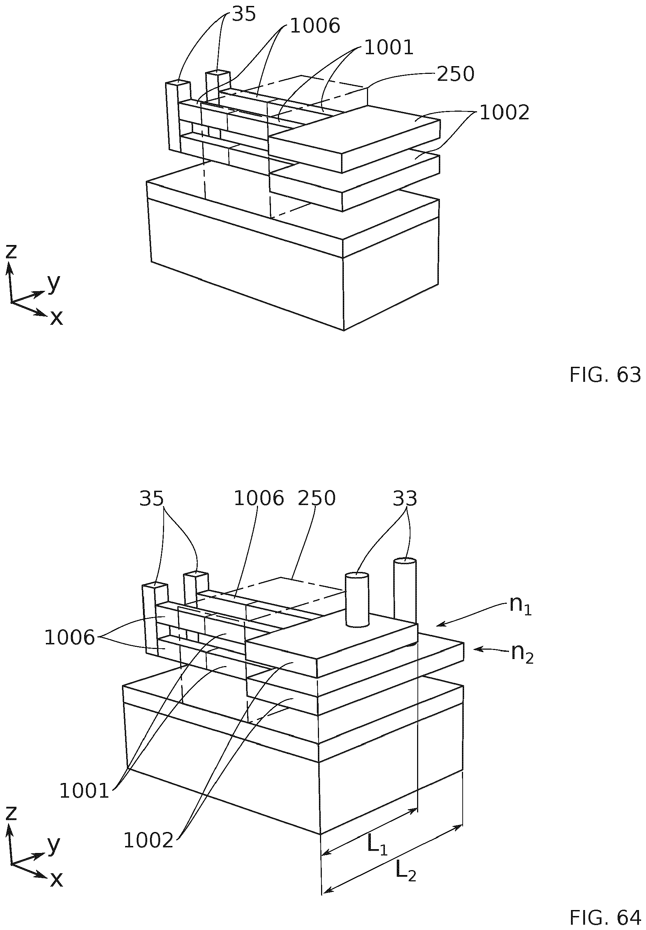

Selon un autre exemple illustré à la figure 63, les drains 1006 s'étendent sous forme de fils selon x, en prolongement des canaux 1001. Dans ce cas, des contacts verticaux sous forme de vias traversants 35 peuvent s'étendre sur un flanc desdits drains 1006 sous forme de fils, le long de différents niveaux n_{z}.

Cela permet de contacter séparément au moins une partie des drains 1006 sous forme de fils.

Selon un autre exemple illustré à la figure 64, les drains 1006 s'étendent sous forme de fils selon x, en prolongement des canaux 1001 et, comme précédemment, des contacts verticaux sous forme de vias traversants 35 s'étendent sur un flanc desdits drains 1006 sous forme de fils, le long des différents niveaux n_{z}.

Dans cet exemple, les sources 1002 s'étendent principalement selon y et présentent différentes longueurs pour différents niveaux n_{z}. Par exemple, la source 1002 du niveau n₁ présente une longueur L1 inférieure à la longueur L2 de la source 1002 du niveau n₂. Cela permet de contacter les sources 1002 par des contacts en escalier 33. Les différents transistors des différents niveaux n_{z} peuvent ainsi être contrôlés indépendamment les uns des autres.

Les caractéristiques des différents modes de réalisation du dispositif microélectronique et/ou du système décrites et illustrées au travers des figures 59A à 64 peuvent être combinées de façon à d'autres modes de réalisation du dispositif microélectronique et/ou du système selon l'invention.

De façon générale, l'invention n'est pas limitée aux modes de réalisation décrits mais s'étend à tout mode de réalisation entrant dans la portée des revendications indépendantes 1 et 11. En particulier, la présente invention couvre des procédés de réalisation de dispositifs microélectroniques ne comportant pas de cellules mémoire. Les drains et les sources des transistors peuvent être intervertis, indépendamment les uns des autres.

## Revendications

1. Procédé de fabrication d'un dispositif microélectronique comprenant au moins deux transistors (101) comprenant chacun un canal (1001) sous forme de fil s'étendant principalement selon une première direction x, une grille (250) entourant ledit canal (1001), une source (1002) et un drain (1006) associés au canal (1001), lesdits transistors (101) étant empilés selon une troisième direction z et occupant chacun un niveau n_{z}, n_{z} = n₁...n₄, d'altitude donnée selon la troisième direction z, ledit procédé comprenant les étapes suivantes :
- Former sur un substrat un empilement (E) selon la troisième direction z comprenant au moins deux couches (12) en un premier matériau semiconducteur séparées par au moins une couche sacrificielle (11) en un deuxième matériau semi-conducteur,
- Former à partir de cet empilement (E) des ouvertures (201, 202, 301, 301_{c}, 401) définissant des motifs de transistors (101M), les motifs de transistors (101M) comprenant chacun une partie centrale (112a) s'étendant notamment et de préférence principalement selon la première direction x et des première et deuxième parties périphériques (312, 112b) s'étendant de part et d'autre de la partie centrale (112a), ladite partie centrale (112a) étant destinée à former les canaux (1001) des transistors et lesdites première et deuxième parties périphériques (312, 112b) étant destinées à former respectivement les sources (1002) et les drains (1006) des transistors,
- Former des grilles sacrificielles (150) en partie dans les ouvertures (201, 202), à cheval sur les parties centrales (112a) des motifs de transistors (101M) et s'étendant principalement selon une deuxième direction y normale à la première direction x,
- Retirer, à partir des ouvertures (201, 202), le deuxième matériau semiconducteur de l'au moins une couche sacrificielle (11) des motifs de transistors (101M),
- Remplir par un deuxième matériau diélectrique un premier espace laissé par le retrait, au niveau des première et deuxième parties périphériques (312, 112b) des motifs de transistors (101M), de l'au moins une couche sacrificielle (11),
- Retirer les grilles sacrificielles (150),
- Remplir par un matériau de grille un deuxième espace laissé par le retrait, au niveau des parties centrales (112a) des motifs de transistors (101M), de l'au moins une couche sacrificielle (11), de façon à former des grilles (250) dites enrobantes entourant totalement les canaux (1001) des transistors (101) d'au moins un niveau n_{z} parmi les niveaux d'altitudes données.

2. Procédé selon la revendication précédente dans lequel le retrait de l'au moins une couche sacrificielle (11) comprend :
- un premier retrait configuré pour former le premier espace au niveau des première et deuxième parties périphériques (312, 112b) avant le retrait des grilles sacrificielles (150), et
- un deuxième retrait configuré pour former le deuxième espace au niveau des parties centrales (112a) après le retrait des grilles sacrificielles (150).

3. Procédé selon l'une quelconque des revendications précédentes dans lequel, pour chacun des transistors (101), au moins l'un parmi la source (1002) et le drain (1006) s'étend principalement selon la deuxième direction y.

4. Procédé selon l'une quelconque des revendications précédentes dans lequel les grilles sacrificielles (150) sont formées directement en bordure de l'une au moins parmi les premières et deuxièmes parties périphériques (312, 112b).

5. Procédé selon l'une quelconque des revendications précédentes comprenant en outre des gravures en escalier dans une zone de lignes de source (3), de façon à atteindre les sources (1002) des différents niveaux n_{z}, et la formation de contacts (33) en escalier sur les sources (1002) des différents niveaux n_{z}.

6. Procédé selon l'une quelconque des revendications précédentes dans lequel le premier matériau semi-conducteur est du silicium et le deuxième matériau semi-conducteur est un alliage de silicium-germanium.

7. Procédé selon l'une quelconque des revendications précédentes dans lequel le substrat est un substrat de type semiconducteur sur isolant comprenant une couche mince de semiconducteur (topSi) et dans lequel ladite couche mince de semiconducteur (topSi) est l'une parmi la couche sacrificielle (11) et les au moins deux couches (12) en un premier matériau semi-conducteur de l'empilement (E, R).

8. Procédé selon l'une quelconque des revendications précédentes dans lequel chaque couche (topSi, 11, 12) de l'empilement (E, R) présente une épaisseur comprise entre 5 nm et 50 nm, par exemple de l'ordre de 15 nm.

9. Procédé selon l'une quelconque des revendications précédentes dans lequel le retrait de l'au moins une couche sacrificielle (11) se fait par gravure sélective du deuxième matériau semiconducteur vis-à-vis du premier matériau semiconducteur avec une sélectivité de gravure entre le deuxième matériau semiconducteur et le premier matériau semiconducteur supérieure ou égale à 5:1.

10. Procédé selon l'une quelconque des revendications précédentes dans lequel chaque partie centrale (112a) de chaque motif de transistors (101M) comprend un empilement d'au moins X canaux (1001), chaque première partie périphérique (312) de chaque motif de transistors (101M) comprend un empilement d'au moins X sources (1002), et chaque deuxième partie périphérique (112b) de chaque motif de transistors (101M) comprend un empilement d'au moins X drains (1006), avec X ≥ 3 et de préférence X ≥ 4 et de préférence X ≥ 10.

11. Dispositif microélectronique comprenant au moins deux transistors (101) comprenant chacun un canal (1001) sous forme de fil s'étendant principalement selon une première direction x, une grille (250) entourant ledit canal (1001), une source (1002) et un drain (1006) associés au canal (1001), lesdits transistors (101) étant empilés selon une troisième direction z de sorte que le canal (1001) de chacun desdits transistors (101) occupe un niveau n_{z}, n_{z} = n₁...n₄, d'altitude donnée selon la troisième direction z, et la source (1002) et le drain (1006) associés audit canal (1001) sont localisés uniquement audit niveau n_{z}, ledit dispositif microélectronique étant **caractérisé en ce que** la grille (250) est bordée par des espaceurs (170_{C}, 170_{S}) longitudinaux, lesdits espaceurs (170_{C}, 170_{S}) longitudinaux s'étendant de part et d'autre de la grille (250) principalement selon une deuxième direction y normale aux première et troisième directions x, z, lesdits espaceurs (170_{C}, 170_{S}) longitudinaux couvrant la source (1002) et le drain (1006) de chaque transistor (101).

12. Dispositif microélectronique selon la revendication précédente dans lequel les sources (1002) des transistors sont séparées entre elles selon la troisième direction z par au moins un espaceur (1004) et/ou les drains (1006) des transistors sont séparés entre eux selon la troisième direction z par au moins un autre espaceur (1004).

13. Dispositif microélectronique selon l'une quelconque des deux revendications précédentes dans lequel les sources (1002) ou les drains (1006) de différents niveaux n_{z} sont contactés électriquement entre eux par au moins un contact commun (34, 35) s'étendant selon la troisième direction z, en bordure desdits sources ou drains.

14. Dispositif microélectronique selon l'une quelconque des trois revendications précédentes dans lequel les sources (1002) et/ou les drains (1006) de différents niveaux n_{z} sont contactés électriquement indépendamment les uns des autres par des contacts en escalier (33, 32).

15. Système microélectronique comprenant une pluralité de dispositifs microélectroniques selon l'une quelconque des quatre revendications précédentes, lesdits dispositifs étant adjacents selon un plan normal comprenant la troisième direction z, dans lequel les sources (1002) et/ou les drains (1006) d'un niveau n_{z} d'altitude donnée de deux dispositifs adjacents sont communs audits deux dispositifs adjacents.

## Patentansprüche

1. Verfahren zur Herstellung einer Mikroelektronikvorrichtung, umfassend mindestens zwei Transistoren (101), jeweils umfassend einen Kanal (1001) in Drahtform, der sich hauptsächlich entlang einer ersten Richtung x erstreckt, ein Gitter (250), das den Kanal (1001) umgibt, eine Source (1002) und einen Drain (1006), assoziiert mit dem Kanal (1001), wobei die Transistoren (101) entlang einer dritten Richtung z gestapelt sind und entlang der dritten Richtung z jeweils ein gegebenes Höhenniveau n_{z}, n_{z} = n₁...n₄ einnehmen,
wobei das Verfahren die folgenden Schritte umfasst:
- Bilden, auf einem Substrat, einer Stapelung (E) entlang der dritten Richtung z, umfassend mindestens zwei Schichten (12) aus einem ersten Halbleitermaterial, getrennt durch mindestens eine Opferschicht (11), und ein zweites Halbleitermaterial,
- Bilden von Öffnungen (201, 202, 301, 301c, 401) ausgehend von dieser Stapelung (E), die Transistormuster (101M) definieren, wobei die Transistoren (101M) jeweils einen Mittelteil (112a), der sich insbesondere und vorzugsweise hauptsächlich entlang der ersten Richtung x erstreckt, und erste und zweite periphere Teile (312, 112b), die sich beiderseits des Mittelteils (112a) erstrecken, umfasst, wobei der Mittelteil (112a) dazu bestimmt ist, die Kanäle (1001) der Transistoren zu bilden und die ersten und zweiten peripheren Teile (312, 112b) dazu bestimmt sind, jeweils die Sourcen (1002) und die Drains (1006) der Transistoren zu bilden,
- Bilden von Opfergittern (150), zum Teil in den Öffnungen (201, 202), gebietsübergreifend auf den Mittelteilen (112a) der Transistormuster (101M) und sich hauptsächlich entlang einer zweiten Richtung y senkrecht zu der ersten Richtung x erstreckend,
- Entfernen, ausgehend von den Öffnungen (201, 202), des zweiten Halbleitermaterials der mindestens einen Opferschicht (11) von den Transistormustern (101M),
- Füllen, durch ein zweites dielektrisches Material, eines durch die Entfernung zurückgelassenen ersten Raums auf dem Niveau der ersten und zweiten peripheren Teile (312, 112b) der Transistormuster (101M) der mindestens einen Opferschicht (11),
- Entfernen der Opfergitter (150),
- Füllen, durch ein Gittermaterial, eines durch die Entfernung zurückgelassenen zweiten Raums auf dem Niveau der Mittelteile (112a) der Transistormuster (101M) der mindestens einen Opferschicht (11) derart, dass die einkapselnden Gitter (250), die die Kanäle (1001) der Transistoren (101) von mindestens einem Niveau nz unter den gegebenen Höhenniveaus komplett umgeben, gebildet werden.

2. Verfahren nach dem vorstehenden Anspruch, wobei die Entfernung der mindestens einen Opferschicht (11) umfasst:
- Eine erste Entfernung, konfiguriert, um vor der Entfernung der Opfergitter (150) den ersten Raum auf dem Niveau der ersten und zweiten peripheren Teile (312, 112b) zu bilden, und
- Eine zweite Entfernung, konfiguriert, um nach der Entfernung der Opfergitter (150) den zweiten Raum auf dem Niveau der Mittelteile (112a) zu bilden.

3. Verfahren nach einem der vorstehenden Ansprüche, wobei für jeden der Transistoren (101) sich mindestens eines unter der Source (1002) und dem Drain (1006) hauptsächlich entlang der zweiten Richtung y erstreckt.

4. Verfahren nach einem der vorstehenden Ansprüche, wobei die Opfergitter (150) direkt an den Rändern des mindestens einen unter den ersten und zweiten peripheren Teilen (312, 112b) gebildet werden.

5. Verfahren nach einem der vorstehenden Ansprüche, umfassend des Weiteren stufenförmige Ätzungen in einer Sourceleitungszone (3) derart, dass die Sourcen (1002) der unterschiedlichen Niveaus n_{z}, und die Bildung von stufenförmigen Kontakten (33) auf den Sourcen (1002) der unterschiedlichen Niveaus n_{z} erzielt werden.

6. Verfahren nach einem der vorstehenden Ansprüche, wobei das erste Halbleitermaterial Silicium ist und das zweite Halbleitermaterial eine Silicium-Germanium-Legierung ist.

7. Verfahren nach einem der vorstehenden Ansprüche, wobei das Substrat ein Substrat vom Typ Halbleiter auf Isolator ist, umfassend eine Halbleiterdünnschicht (topSi) und wobei die Halbleiterdünnschicht (topSi) eine unter der Opferschicht (11) und den mindestens zwei Schichten (12) aus einem ersten Halbleitermaterial der Stapelung (E, R) ist.

8. Verfahren nach einem der vorstehenden Ansprüche, wobei jede Schicht (topSi, 11, 12) der Stapelung (E, R) eine Dicke zwischen 5 nm und 50 nm aufweist, zum Beispiel in der Größenordnung von 15 nm.

9. Verfahren nach einem der vorstehenden Ansprüche, wobei die Entfernung der mindestens einen Opferschicht (11) durch selektive Ätzung des zweiten Halbleitermaterials bezüglich des ersten Halbleitermaterials mit einer Ätzselektivität zwischen dem zweiten Halbleitermaterial und dem ersten Halbleitermaterial von größer als oder gleich 5 : 1 erfolgt.

10. Verfahren nach einem der vorstehenden Ansprüche, wobei jeder Mittelteil (112a) von jedem Transistormuster (101M) eine Stapelung von mindestens X Kanälen (1001) umfasst, wobei jeder periphere Teil (312) von jedem Transistormuster (101M) eine Stapelung von mindestens X Sourcen (1002) umfasst und jeder zweite periphere Teil (112b) von jedem Transistormuster (101M) eine Stapelung von mindestens X Drains (1006) umfasst, mit X ≥ 3 und vorzugsweise X ≥ 4 und vorzugsweise X ≥ 10.

11. Mikroelektronikvorrichtung, umfassend mindestens zwei Transistoren (101), die jeweils einen Kanal (1001) in Drahtform, der sich hauptsächlich entlang einer ersten Richtung x erstreckt, ein Gitter (250), das den Kanal (1001) umgibt, eine Source (1002) und einen Drain (1006), assoziiert mit dem Kanal (1001), umfassen, wobei die Transistoren (101) entlang einer dritten Richtung z so gestapelt sind, dass der Kanal (1001) von jedem der Transistoren (101) ein gegebenes Höhenniveau n_{z}, n_{z} = n₁... n₄ entlang der dritten Richtung z einnimmt, und die Source (1002) und der Drain (1006), assoziiert mit dem Kanal (1001), sich einzig auf dem Niveau n_{z} befinden, wobei die Mikroelektronikvorrichtung **dadurch gekennzeichnet ist, dass** das Gitter (250) von längsgerichteten Abstandshaltern (170c, 170s) umrandet ist, wobei sich die längsgerichteten Abstandshalter (170c, 170s) beiderseits des Gitters (250) hauptsächlich entlang einer zweiten Richtung y erstrecken, senkrecht zu der ersten und dritten Richtung x, z, wobei die längsgerichteten Abstandshalter (170c, 170s) die Source (1002) und den Drain (1006) von jedem Transistor (101) bedecken.

12. Mikroelektronikvorrichtung nach dem vorstehenden Anspruch, wobei die Sourcen (1002) der Transistoren untereinander entlang der dritten Richtung z durch mindestens einen Abstandshalter (1004) getrennt sind und/oder die Drains (1006) der Transistoren untereinander entlang der dritten Richtung z durch mindestens einen anderen Abstandshalter (1004) getrennt sind.

13. Mikroelektronikvorrichtung nach einem der zwei vorstehenden Ansprüche, wobei die Sourcen (1002) oder die Drains (1006) von unterschiedlichen Niveaus n_{z} untereinander durch mindestens einen gemeinsamen Kontakt (34, 35), der sich entlang der dritten Richtung z erstreckt, am Rand der Sourcen und Drains elektrisch in Kontakt gebracht sind.

14. Mikroelektronikvorrichtung nach einem der drei vorstehenden Ansprüche, wobei die Sourcen (1002) und/oder die Drains (1006) von unterschiedlichen Niveaus n_{z} unabhängig voneinander durch stufenförmige Kontakte (33, 32) in Kontakt gebracht sind.

15. Mikroelektroniksystem, umfassend eine Vielzahl von Mikroelektronikvorrichtungen nach einem der vier vorstehenden Ansprüche, wobei die Vorrichtungen entlang einer senkrechten Ebene benachbart sind, umfassend die dritte Richtung z, wobei die Sourcen (1002) und/oder die Drains (1006) eines Höhenniveaus n_{z} von zwei benachbarten Vorrichtungen den zwei benachbarten Vorrichtungen gemeinsam sind.

## Claims

1. A method for manufacturing a microelectronic device comprising at least two transistors (101) each comprising a channel (1001) in the form of a wire extending mainly in a first direction x, a gate (250) surrounding said channel (1001), a source (1002) and a drain (1006) linked to the channel (1001), said transistors (101) being stacked in a third direction z and each occupying a level n_{z}, n_{z} = n₁...n₄, of a given altitude in the third direction z,
said method comprising the following steps:
- Forming on a substrate a stack (E) in the third direction z comprising at least two layers (12) made of a first semiconductor material separated by at least one sacrificial layer (11) made of a second semiconductor material,
- Forming from this stack (E) openings (201, 202, 301, 301_{c}, 401) defining transistor patterns (101M), the transistor patterns (101M) each comprising a central portion (112a) extending particularly and preferably mainly in the first direction x and first and second peripheral portions (312, 112b) extending on either side of the central portion (112a), said central portion (112a) being intended to form the channels (1001) of the transistors and said first and second peripheral portions (312, 112b) being intended to form the sources (1002) and drains (1006) of the transistors respectively,
- Forming sacrificial gates (150) partly in the openings (201, 202), spanning the central portions (112a) of the transistor patterns (101M) and extending mainly in a second direction y normal to the first direction x,
- Removing, from the openings (201, 202), the second semiconductor material from the at least one sacrificial layer (11) of the transistor patterns (101M),
- Filling with a second dielectric material a first space left by the removal, at the first and second peripheral portions (312, 112b) of the transistor patterns (101M), of the at least one sacrificial layer (11),
- Removing the sacrificial gates (150),
- Filling with a gate material a second space left by the removal, at the central portions (112a) of the transistor patterns (101M), of the at least one sacrificial layer (11), so as to form so-called gate-all-around (250) totally surrounding the channels (1001) of the transistors (101) by at least one level n_{z} of the given levels of altitude.

2. The method according to the preceding claim wherein the removal of the at least one sacrificial layer (11) comprises:
- A first recess configured to form the first space at the first and second peripheral portions (312, 112b) before removing the sacrificial gates (150), and
- A second recess configured to form the second space at the central portions (112a) after removing the sacrificial gates (150).

3. The method according to any of the preceding claims, wherein for each of the transistors (101), at least one of the source (1002) and the drain (1006) extends mainly in the second direction y.

4. The method according to any of the preceding claims wherein the sacrificial gates (150) are formed directly on the edges of at least one of the first and second peripheral portions (312, 112b).

5. The method according to any of the preceding claims comprising stepped etchings in a source line area (3), so as to reach the sources (1002) of the different levels n_{z}, and forming stepped contacts (33) on the sources (1002) of the different levels n_{z}.

6. The method according to any of the preceding claims wherein the first semiconductor material is silicon and the second semiconductor material is a silicongermanium alloy.

7. The method according to any of the preceding claims wherein the substrate is a semiconductor-on-insulator type substrate comprising a thin semiconductor layer (topSi) and wherein said thin semiconductor layer (topSi) is one of the sacrificial layer (11) and the at least two layers (12) made of a first semiconductor material of the stack (E, R).

8. The method according to any of the preceding claims wherein each layer (topSi, 11, 12) of the stack (E, R) has a thickness of between 5 nm and 50 nm, for instance in the order of 15 nm.

9. The method according to any of the preceding claims wherein the removal of the at least one sacrificial layer (11) is performed by a selective etching of the second semiconductor material with respect to the first semiconductor material, with an etching selectivity between the second semiconductor material and the first semiconductor material that is greater than or equal to 5:1.

10. The method according to any of the preceding claims wherein each central portion (112a) of each transistor pattern (101M) comprises a stack of at least X channels (1001), each first peripheral portion (312) of each transistor pattern (101M) comprises a stack of at least X sources (1002), and each second peripheral portion (112b) of each transistor pattern (101M) comprises a stack of at least X drains (1006), with X ≥ 3 and preferably X ≥ 4 and preferably X ≥ 10.

11. The microelectronic device comprising at least two transistors (101) each comprising a channel (1001) in the form of a wire extending mainly in a first direction x, a gate (250) surrounding said channel (1001), a source (1002) and a drain (1006) linked to the channel (1001), said transistors (101) being stacked in a third direction z such that the channel (1001) of each of said transistors (101) occupies a level n_{z}, n_{z} = n₁...n₄ of a given altitude in the third direction z, and the source (1002) and the drain (1006) linked to said channel (1001) are located solely at said level n_{z}, said microelectronic device being **characterised in that** the gate (250) is bordered by longitudinal spacers (170_{c}, 170ₛ) extending on either side of the gate (250), mainly in a second direction y normal to the first and third directions x, z, said longitudinal spacers (170_{c}, 170ₛ) covering the source (1002) and the drain (1006) of each transistor (101).

12. The microelectronic device according to the preceding claim wherein the sources (1002) of the transistors are separated from each other in the third direction z by at least one spacer (1004) and/or the drains (1006) of the transistors are separated from each other in the third direction z by at least one other spacer (1004).

13. The microelectronic device according to any of the two preceding claims wherein the sources (1002) or the drains (1006) of different levels n_{z} are contacted electrically with each other by at least one common contact (34, 35) extending in the third direction z, on the edges of said sources or drains.

14. The microelectronic device according to any of the three preceding claims wherein the sources (1002) and/or the drains (1006) of different levels n_{z} are contacted electrically separately from each other by stepped contacts (33, 32).

15. A microelectronic system comprising a plurality of microelectronic devices according to any of the four preceding claims, said devices being adjacent in a normal plane comprising the third direction z, wherein the sources (1002) and/or the drains (1006) of a level n_{z} of a given altitude of two adjacent devices are common to said two adjacent devices.
